# EUROPEAN PATENT APPLICATION

(11) **EP 4 844 734 A1**
(43) Date of publication of application: **25.11.2026**
(21) Application number: 25829677.1
(22) Date of filing: 09.06.2025
(51) Int. Cl.: G09F 9/30, F16C 11/04, H05K 5/02

(54) **FOLDING MECHANISM AND ELECTRONIC DEVICE**

(30) Priority: 19.06.2024 CN 202410798988
(71) Applicant: Huawei Technologies Co., Ltd., Shenzhen, Guangdong 518129 (CN)
(72) Inventor: LIN, Yangming, Shenzhen, Guangdong 518129 (CN); XIE, Kangzhou, Shenzhen, Guangdong 518129 (CN); HUA, Leilei, Shenzhen, Guangdong 518129 (CN)
(74) Representative: Pfenning, Meinig & Partner mbB
(86) International application number: PCT/CN2025/099838
(87) International publication number: WO 2025/261196

(57) **Abstract**

This application provides a foldable mechanism and an electronic device. A main shaft is located between a first mounting bracket and a second mounting bracket. A first support plate is rotatably connected to the main shaft, and a third support plate is rotatably connected to the first support plate and the first mounting bracket. A rotating end of a first connecting piece is rotatably connected to the main shaft, a sliding end of the first connecting piece is slidably connected to the first mounting bracket, and a connecting section of the first connecting piece is connected to the first support plate through a first revolute pair. A second support plate is rotatably connected to the main shaft, and a fourth support plate is rotatably connected to the second support plate and the second mounting bracket. A rotating end of a second connecting piece is rotatably connected to the main shaft, a sliding end of the second connecting piece is slidably connected to the second mounting bracket, and a connecting section of the second connecting piece is connected to the second support plate through a second revolute pair. A folding action performed by the foldable mechanism on a flexible screen is stable, and a compressive force applied to the flexible screen is relatively small. This helps reduce a risk that the flexible screen is damaged due to excessive compression of the foldable mechanism, thereby improving reliability of the flexible screen.

## Description

This application claims priority to Chinese Patent Application No. 202410798988.4, filed with the China National Intellectual Property Administration on June 19, 2024, and entitled "FOLDABLE MECHANISM AND ELECTRONIC DEVICE", which is incorporated herein by reference in its entirety.

### TECHNICAL FIELD

This application relates to the field of foldable electronic product technologies, and in particular, to a foldable mechanism and an electronic device.

### BACKGROUND

In recent years, flexible screens are widely used in various foldable electronic devices because they are lightweight, thin, and resistant to breakage. A foldable electronic device further includes a housing apparatus configured to carry the flexible screen. The housing apparatus generally includes two housings and a foldable mechanism connected between the two housings. The two housings are folded or unfolded relative to each other through deformation of the foldable mechanism, and drive the flexible screen to be folded or unfolded. In a conventional electronic device with an inward-folding screen, when the electronic device is folded, the flexible screen is folded on an inner side of the housing apparatus, and a bent portion of the flexible screen is prone to damage due to excessive compression by a foldable mechanism, resulting in reduced reliability and a shortened service life of the flexible screen.

### SUMMARY

This application provides a foldable mechanism and an electronic device. The foldable mechanism is used in a housing apparatus of the electronic device, and is configured to connect two housings of the housing apparatus. The housing apparatus is configured to carry a flexible screen. In a folding process of the housing apparatus, the foldable mechanism of the housing apparatus can form an accommodating space through automatic avoidance. A folding action performed by the housing apparatus on the flexible screen is stable, and a compressive force applied to the flexible screen is relatively small. This helps reduce a risk that the flexible screen is damaged due to excessive compression of the foldable mechanism, thereby improving the flexible screen highly reliable.

According to a first aspect, this application provides a foldable mechanism. The foldable mechanism includes a main shaft, a first mounting bracket, a second mounting bracket, a first support plate, a second support plate, a third support plate, a fourth support plate, a first connecting piece, a second connecting piece, a first revolute pair, and a second revolute pair, and the main shaft is located between the first mounting bracket and the second mounting bracket.

The first support plate is rotatably connected to the main shaft, and the third support plate is rotatably connected to the first support plate and the first mounting bracket.

The first connecting piece includes a rotating end, a connecting section, and a sliding end that are sequentially connected, the rotating end of the first connecting piece is rotatably connected to the main shaft, the sliding end of the first connecting piece is slidably connected to the first mounting bracket, and the connecting section of the first connecting piece is connected to the first support plate through the first revolute pair.

The second support plate is rotatably connected to the main shaft, and the fourth support plate is rotatably connected to the second support plate and the second mounting bracket.

The second connecting piece includes a rotating end, a connecting section, and a sliding end that are sequentially connected, the rotating end of the second connecting piece is rotatably connected to the main shaft, the sliding end of the second connecting piece is slidably connected to the second mounting bracket, and the connecting section of the second connecting piece is connected to the second support plate through the second revolute pair.

It may be understood that the foldable mechanism may be a crank-slider connecting rod motion mechanism. A main mechanism motion of the foldable mechanism may include a primary motion and a secondary motion. The primary motion may be a motion manner of a four-connecting rod motion mechanism formed by the main shaft, the first support plate, the first connecting piece, and the first revolute pair. In addition, the secondary motion may be a motion manner of a slider connecting rod motion mechanism formed by the first mounting bracket, the third support plate, the first support plate, and the first revolute pair. The foldable mechanism, through the primary motion and the secondary motion, may enable a degree of freedom for the first mounting bracket to move relative to the main shaft to be 1 in a process of unfolding or folding the foldable mechanism, so that a motion track of the first mounting bracket relative to the main shaft can be determined. Specifically, in the process of unfolding or folding the foldable mechanism, a motion manner of the first support plate, the third support plate, the first connecting piece, and the first revolute pair may constrain a motion track of the first mounting bracket, so that the motion track of the first mounting bracket relative to the main shaft can be determined. In this way, in a process of changing an unfolded state of the foldable mechanism to a folded state, the first support plate, the third support plate, the first connecting piece, and the first revolute pair can pull the first mounting bracket back to be close to the main shaft. In a process of changing the folded state of the foldable mechanism to the unfolded state, the first support plate, the third support plate, the first connecting piece, and the first revolute pair can push the first mounting bracket away from the main shaft.

Similarly, the second support plate is disposed to be rotatably connected to the main shaft, the fourth support plate is disposed to be rotatably connected to the second support plate, the fourth support plate is disposed to be rotatably connected to the second mounting bracket, the rotating end of the second connecting piece is disposed to be rotatably connected to the main shaft, and the sliding end of the second connecting piece is disposed to be slidably connected to the second mounting bracket, so that the second support plate is further rotatably connected to the second connecting piece through the second revolute pair. In this case, a motion manner of a four-connecting rod motion mechanism formed by the main shaft, the second support plate, the second connecting piece, and the second revolute pair may also form the primary motion of the foldable mechanism. A motion manner of a slider connecting rod motion mechanism formed by the second support plate, the fourth support plate, the second mounting bracket, and the second revolute pair may also form the secondary motion of the foldable mechanism. In this case, the foldable mechanism, through the primary motion and the secondary motion, may enable a degree of freedom for the second mounting bracket to move relative to the main shaft to be 1 in a process of unfolding or folding the foldable mechanism, so that a motion track of the second mounting bracket relative to the main shaft can be determined. In this way, in a process of changing the unfolded state of the foldable mechanism to the folded state, the second support plate, the fourth support plate, the second connecting piece, and the second revolute pair can pull the second mounting bracket back to be close to the main shaft. In a process of changing the folded state of the foldable mechanism to the unfolded state, the second support plate, the fourth support plate, the second connecting piece, and the second revolute pair can push the second mounting bracket away from the main shaft.

In a possible implementation, when the foldable mechanism is in the unfolded state, the third support plate, the first support plate, the second support plate, and the fourth support plate are sequentially joined and together form a support surface; or
when the foldable mechanism is in the folded state, the first support plate and the second support plate are disposed opposite to each other, the third support plate and the fourth support plate are disposed opposite to each other, and the main shaft, the first support plate, the second support plate, the third support plate, and the fourth support plate enclose an accommodating space.

It may be understood that when the foldable mechanism is in the unfolded state, the first support plate, the second support plate, the third support plate, and the fourth support plate may together form the support surface, so that when the foldable mechanism is used in an electronic device, the support surface can support a second display area of a flexible screen. In this case, the flexible screen is not easily dented under pressing of a user. This not only helps improve a service life and reliability of the flexible screen, but also achieves good light and shadow performance of the flexible screen. Therefore, the foldable mechanism in this implementation offers strong product competitiveness.

It may be understood that in an implementation, when the foldable mechanism is in the unfolded state, the first support plate, the second support plate, and the main shaft together form the support surface, to support the second display area of the flexible screen. In this solution, because the main shaft needs to be connected to the first support plate and the second support plate through a plurality of connecting pieces, the main shaft needs to be provided with a plurality of clearance spaces, to avoid the connecting pieces or other components. The clearance space may be a groove or a through hole. As a result, a dent easily appears on a surface, of the main shaft, used to form the support surface, that is, flatness of the support surface is poor. In this case, the flexible screen is easily dented under pressing of the user, causing a problem such as a failure of the flexible screen. This is not conducive to improving the service life and the reliability of the flexible screen. In this implementation, when the foldable mechanism is in the unfolded state, the first support plate, the second support plate, the third support plate, and the fourth support plate of the foldable mechanism may be together joined into the support surface, to support the second display area of the flexible screen. In this case, in this implementation, the main shaft may no longer be used to support the second display area of the flexible screen, thereby avoiding a problem such as a failure of the flexible screen caused by poor flatness of the main shaft. In other words, when the electronic device in this implementation is in an unfolded state, the flexible screen has a long service life and high reliability.

In this implementation, because the first support plate, the second support plate, the third support plate, and the fourth support plate have a small quantity of connection positions with other structures, and a mating relationship between parts is simple, the first support plate, the second support plate, the third support plate, and the fourth support plate have a small quantity of holes, and are structurally simple. In this way, the support surface together formed by the first support plate, the second support plate, the third support plate, and the fourth support plate has a small quantity of holes, and a gap between two adjacent support plates is small, thereby facilitating flatness of the support surface, and helping improve the service life and the reliability of the flexible screen.

It may be understood that when the foldable mechanism is in the folded state, the first support plate, the second support plate, the third support plate, and the fourth support plate may together form the accommodating space with the main shaft, to accommodate the second display area of the flexible screen when the foldable mechanism is used in the electronic device. It may be understood that in a process of folding the foldable mechanism, the first support plate, the second support plate, the third support plate, and the fourth support plate may be automatically avoided, to form the accommodating space. Folding actions performed by the first support plate, the second support plate, the third support plate, and the fourth support plate on the flexible screen may be stable, and a compressive force applied to the flexible screen is relatively small. This helps reduce a risk that the flexible screen is damaged due to excessive compression of the foldable mechanism, and makes the flexible screen highly reliable.

For example, when the foldable mechanism is in the folded state, the first support plate, the second support plate, the third support plate, and the fourth support plate may stably support the second display area of the flexible screen, thereby reducing a risk of damage caused by freedom of the flexible screen, and improving the service life and the reliability of the flexible screen. Therefore, the foldable mechanism in this implementation offers strong product competitiveness.

In a possible implementation, when the foldable mechanism is in the folded state, the first support plate and the second support plate are both disposed obliquely relative to the main shaft, the first support plate and the second support plate are close to each other in a direction close to the main shaft, the third support plate and the fourth support plate are also disposed obliquely relative to the main shaft, and the third support plate and the fourth support plate are close to each other in a direction away from the main shaft. In this way, in a process of folding the foldable mechanism, a volume of the accommodating space is large, and folding actions performed by the first support plate, the second support plate, the third support plate, and the fourth support plate on the flexible screen may be stable, and a compressive force applied to the flexible screen is relatively smaller. This helps reduce a risk that the flexible screen is damaged due to excessive compression of the foldable mechanism, thereby improving reliability of the flexible screen.

In a possible implementation, when the foldable mechanism is in the unfolded state, the first support plate and the second support plate together cover all of the main shaft; or
when the foldable mechanism is in the folded state, the first support plate and the second support plate respectively cover two side parts of the main shaft.

It may be understood that when the foldable mechanism is in the unfolded state, the first support plate and the second support plate together cover all of the main shaft. In this way, the first support plate and the second support plate are arranged more compactly, thereby facilitating miniaturization of the foldable mechanism.

It may be understood that when the foldable mechanism is in the folded state, the first support plate and the second support plate respectively cover the two side parts of the main shaft. In this way, in comparison with a solution in which the first support plate and the second support plate do not cover the two side parts of the main shaft when the foldable mechanism is in the folded state, the first support plate and the second support plate in this implementation are arranged more compactly, thereby facilitating miniaturization of the foldable mechanism.

In a possible implementation, a rotating axis of the first support plate rotatably connected to the first revolute pair and a rotating axis of the third support plate rotatably connected to the first support plate are aligned on a same straight line. In this way, the third support plate may be connected to the first revolute pair through the first support plate. It may be understood that in comparison with a solution in which the third support plate is connected to the first revolute pair through the first support plate by disposing another connection structure, in this implementation, the rotating axis of the first support plate rotatably connected to the first revolute pair and the rotating axis of the third support plate rotatably connected to the first support plate are aligned on a same straight line. An assembly manner is simple, and parts can be saved, to simplify the structure.

In a possible implementation, the main shaft is bent to form an inner-side space, the main shaft is further provided with a first arc-shaped groove, and the first arc-shaped groove of the main shaft communicates with the inner-side space.

The first support plate includes a first support plate body and an arc-shaped block.

The arc-shaped block of the first support plate is disposed in the first arc-shaped groove of the main shaft, and is capable of rotating in the first arc-shaped groove of the main shaft. At least a part of the first support plate body is disposed in the inner-side space, and is capable of rotating in the inner-side space.

It may be understood that the arc-shaped block of the first support plate is disposed in the first arc-shaped groove of the main shaft. Through relative motion between the arc-shaped block and the first arc-shaped groove, the first support plate and the main shaft form a rotating connection structure through mating of the arc-shaped block and the arc-shaped groove, that is, the first support plate may be rotatably connected to the main shaft through a virtual axis. A structure of the rotating connection through the virtual axis is simple and occupies little space, which helps reduce a thickness of the foldable mechanism, so that it is easier to make the foldable mechanism and the electronic device thinner and lighter.

It may be understood that at least the part of the first support plate body is disposed in the inner-side space, which helps reduce the thickness of the foldable mechanism, so that it is easier to make the foldable mechanism and the electronic device thinner and lighter.

In a possible implementation, the first support plate body includes a bottom surface and a first end surface, the first end surface of the first support plate body is connected to the bottom surface of the first support plate body, and the bottom surface of the first support plate body faces the main shaft when the foldable mechanism is in the unfolded state.

The first support plate body is provided with a clearance space, the clearance space forms an opening on the bottom surface of the first support plate body, the clearance space includes a first wall surface, and the first wall surface of the clearance space and the first end surface of the first support plate body are disposed facing away from each other.

The first support plate has at least two arc-shaped blocks, one arc-shaped block of the first support plate protrudes from the first end surface of the first support plate body, and one arc-shaped block of the first support plate protrudes from the first wall surface of the clearance space.

It may be understood that arrangement between the two arc-shaped blocks of the first support plate is compact, thereby facilitating miniaturization of the foldable mechanism.

In a possible implementation, the first support plate is provided with a first rotating space, the first rotating space of the first support plate is located on one side, of the arc-shaped block of the first support plate, away from the main shaft, the first rotating space of the first support plate includes a first side wall and a second side wall that are disposed opposite to each other, and the first side wall and the second side wall of the first rotating space of the first support plate each are provided with a rotating shaft hole.

The third support plate includes a rotating shaft block, and the rotating shaft block of the third support plate is provided with a rotating shaft hole.

The foldable mechanism further includes a first rotating shaft, and the first rotating shaft sequentially passes through the rotating shaft hole of the first side wall of the first rotating space of the first support plate, the rotating shaft hole of the rotating shaft block of the third support plate, and the rotating shaft hole of the second side wall of the first rotating space of the first support plate.

It may be understood that the first support plate may alternatively be rotatably connected to the third support plate through a physical axis. In this case, a connection relationship between the first support plate and the third support plate is reliable, a rotary backlash is small, and a rotation action is accurate and stable.

In a possible implementation, the first revolute pair includes a bracket, a first pin shaft, and a second pin shaft, and the bracket is provided with a first pin shaft hole and a second pin shaft hole that are spaced apart.

The connecting section of the first connecting piece is provided with a rotating space, the rotating space of the first connecting piece includes a first side wall and a second side wall that are disposed opposite to each other, and the first side wall and the second side wall of the rotating space of the first connecting piece each are provided with a rotating shaft hole.

A part of the bracket is located in the rotating space of the connecting section of the first connecting piece, and the first pin shaft sequentially passes through the rotating shaft hole of the first side wall of the rotating space of the first connecting piece, the first pin shaft hole of the bracket, and the rotating shaft hole of the second side wall of the rotating space of the first connecting piece.

The first support plate is further provided with a second rotating space, the second rotating space of the first support plate includes a first side wall and a second side wall that are disposed opposite to each other, and the first side wall and the second side wall of the second rotating space of the first support plate each are provided with a rotating shaft hole.

A part of the bracket is located in the second rotating space of the first support plate, and the second pin shaft sequentially passes through the rotating shaft hole of the first side wall of the second rotating space of the first support plate, the second pin shaft hole of the bracket, and the rotating shaft hole of the second side wall of the second rotating space of the first support plate.

It may be understood that a structure of the first revolute pair in this implementation is simple.

In a possible implementation, the connecting section of the first connecting piece includes a first part and a second part, the first part is connected to the rotating end of the first connecting piece and the sliding end of the first connecting piece, and the second part protrudes from one side of the rotating end of the first connecting piece; and the rotating space of the first connecting piece is provided in the second part.

It may be understood that a structure of the first connecting piece in this implementation is simple.

In a possible implementation, the third support plate includes an arc-shaped block, and the first mounting bracket is provided with an arc-shaped groove; and the arc-shaped block of the third support plate is disposed in the arc-shaped groove of the first mounting bracket, and is capable of rotating in the arc-shaped groove of the first mounting bracket.

It may be understood that the third support plate may be rotatably connected to the first mounting bracket through a virtual axis. A structure of the rotating connection through the virtual axis is simple and occupies little space, which helps reduce a thickness of the foldable mechanism, so that it is easier to make the foldable mechanism and the electronic device thinner and lighter.

In a possible implementation, the first support plate is further slidably connected to the first mounting bracket, and/or the second support plate is further slidably connected to the second mounting bracket.

It may be understood that the first support plate is further disposed to be slidably connected to the first mounting bracket, so that in a process of unfolding or folding the foldable mechanism, a motion manner of the first support plate, the third support plate, the first connecting piece, and the first revolute pair can better constrain a motion track of the first mounting bracket, and the motion track of the first mounting bracket relative to the main shaft is more accurate. In this way, when the foldable mechanism is used in the electronic device, folding actions performed by the first support plate, the second support plate, the third support plate, and the fourth support plate on the flexible screen may be stable, and a compressive force applied to the flexible screen is relatively small. This helps reduce a risk that the flexible screen is damaged due to excessive compression of the foldable mechanism, thereby improving reliability of the flexible screen.

It may be understood that the second support plate is further disposed to be slidably connected to the second mounting bracket, so that in a process of unfolding or folding the foldable mechanism, a motion manner of the second support plate, the fourth support plate, the second connecting piece, and the second revolute pair can better constrain a motion track of the second mounting bracket, and the motion track of the second mounting bracket relative to the main shaft is more accurate. In this way, when the foldable mechanism is used in the electronic device, folding actions performed by the first support plate, the second support plate, the third support plate, and the fourth support plate on the flexible screen may be stable, and a compressive force applied to the flexible screen is relatively small. This helps reduce a risk that the flexible screen is damaged due to excessive compression of the foldable mechanism, thereby improving reliability of the flexible screen.

In a possible implementation, the first support plate includes a sliding block, and the first mounting bracket is provided with a second sliding slot; and the sliding block of the first support plate is disposed in the second sliding slot of the first mounting bracket, and is capable of sliding in the second sliding slot of the first mounting bracket.

It may be understood that the sliding block of the first support plate is disposed in the second sliding slot of the first mounting bracket. Through relative motion between the sliding block and the second sliding slot, the first support plate and the first mounting bracket form a sliding connection structure through mating of the sliding block and the sliding slot. The sliding connection structure in this implementation is simple.

In a possible implementation, the first mounting bracket includes a first side surface facing the main shaft, and the second sliding slot of the first mounting bracket is disposed obliquely relative to the first side surface of the first mounting bracket.

It may be understood that the second sliding slot of the first mounting bracket is disposed obliquely relative to the first side surface of the first mounting bracket, so that when the first mounting bracket and the first support plate are mated with each other, the first mounting bracket and the first support plate may form an oblique sliding slot mating structure; and when the electronic device is dropped or impacted, the first housing exerts pressure on the first mounting bracket. In this case, the first mounting bracket may share energy of the drop impact to the first support plate and the main shaft. In this way, the foldable mechanism has good drop impact performance, thereby helping improve the service life and the reliability of the electronic device.

In a possible implementation, the first support plate is further rotatably connected to the first mounting bracket, and/or the second support plate is further rotatably connected to the second mounting bracket.

It may be understood that the first support plate is further disposed to be rotatably connected to the first mounting bracket, so that in a process of unfolding or folding the foldable mechanism, a motion manner of the first support plate, the third support plate, the first connecting piece, and the first revolute pair can better constrain a motion track of the first mounting bracket, and the motion track of the first mounting bracket relative to the main shaft is more accurate. In this way, when the foldable mechanism is used in the electronic device, folding actions performed by the first support plate, the second support plate, the third support plate, and the fourth support plate on the flexible screen may be stable, and a compressive force applied to the flexible screen is relatively small. This helps reduce a risk that the flexible screen is damaged due to excessive compression of the foldable mechanism, thereby improving reliability of the flexible screen.

It may be understood that the second support plate is further disposed to be rotatably connected to the second mounting bracket, so that in a process of unfolding or folding the foldable mechanism, a motion manner of the second support plate, the fourth support plate, the second connecting piece, and the second revolute pair can better constrain a motion track of the second mounting bracket, and the motion track of the second mounting bracket relative to the main shaft is more accurate. In this way, when the foldable mechanism is used in the electronic device, folding actions performed by the first support plate, the second support plate, the third support plate, and the fourth support plate on the flexible screen may be stable, and a compressive force applied to the flexible screen is relatively small. This helps reduce a risk that the flexible screen is damaged due to excessive compression of the foldable mechanism, thereby improving reliability of the flexible screen.

According to a second aspect, this application provides a foldable mechanism. The foldable mechanism includes a main shaft, a first mounting bracket, a second mounting bracket, a first support plate, a second support plate, a third support plate, a fourth support plate, a first connecting piece, and a second connecting piece, and the main shaft is located between the first mounting bracket and the second mounting bracket. The first support plate is rotatably connected to the main shaft, and is slidably connected to or rotatably connected to the first mounting bracket, and the third support plate is rotatably connected to the first support plate and the first mounting bracket. The first connecting piece includes a rotating end and a sliding end, the rotating end of the first connecting piece is rotatably connected to the main shaft, and the sliding end of the first connecting piece is slidably connected to the first mounting bracket. The second support plate is rotatably connected to the main shaft, and is slidably connected to or rotatably connected to the second mounting bracket, and the fourth support plate is rotatably connected to the second support plate and the second mounting bracket. The second connecting piece includes a rotating end and a sliding end, the rotating end of the second connecting piece is rotatably connected to the main shaft, and the sliding end of the second connecting piece is slidably connected to the second mounting bracket.

It may be understood that the foldable mechanism may be a slider connecting rod motion mechanism. A main mechanism motion of the foldable mechanism may include a primary motion and a secondary motion. The primary motion may be a motion manner of a slider connecting rod motion mechanism formed by the main shaft, the first support plate, the first connecting piece, and the first mounting bracket. In addition, the secondary motion may be a motion manner of a connecting rod motion mechanism formed by the first support plate, the third support plate, and the first mounting bracket. The foldable mechanism, through the primary motion and the secondary motion, may enable a degree of freedom for the first mounting bracket to move relative to the main shaft to be 1 in a process of unfolding or folding the foldable mechanism, so that a motion track of the first mounting bracket relative to the main shaft can be determined. Specifically, in the process of unfolding or folding the foldable mechanism, a motion manner of the first support plate, the third support plate, and the first connecting piece may constrain a motion track of the first mounting bracket, so that the motion track of the first mounting bracket relative to the main shaft can be determined. In this way, in a process of changing an unfolded state of the foldable mechanism to a folded state, the first support plate, the third support plate, and the first connecting piece can pull the first mounting bracket back to be close to the main shaft. In a process of changing the folded state of the foldable mechanism to the unfolded state, the first support plate, the third support plate, and the first connecting piece can push the first mounting bracket away from the main shaft.

It may be understood that in the process of unfolding or folding the foldable mechanism, a motion manner of the second support plate, the fourth support plate, and the second connecting piece may constrain a motion track of the second mounting bracket, so that the motion track of the second mounting bracket relative to the main shaft can be determined. In this way, in a process of changing the unfolded state of the foldable mechanism to the folded state, the second support plate, the fourth support plate, and the second connecting piece can pull the second mounting bracket back to be close to the main shaft. In a process of changing the folded state of the foldable mechanism to the unfolded state, the second support plate, the fourth support plate, and the second connecting piece can push the second mounting bracket away from the main shaft.

It may be understood that the foldable mechanism in this implementation implements a connection between the first mounting bracket and the main shaft and a connection between the second mounting bracket and the main shaft by using the connecting rod slider structure and the connecting rod structure. The foldable mechanism has a small quantity of components, a simple mating relationship, and a simple mating position, and components are easy to manufacture and assemble, thereby facilitating mass production.

In a possible implementation, when the foldable mechanism is in the unfolded state, the third support plate, the first support plate, the second support plate, and the fourth support plate are sequentially joined and together form a support surface; or
when the foldable mechanism is in the folded state, the first support plate and the second support plate are disposed opposite to each other, the third support plate and the fourth support plate are disposed opposite to each other, and the main shaft, the first support plate, the second support plate, the third support plate, and the fourth support plate enclose an accommodating space.

It may be understood that when the foldable mechanism is in the unfolded state, the first support plate, the second support plate, the third support plate, and the fourth support plate may together form the support surface, so that when the foldable mechanism is used in an electronic device, the support surface can support a second display area of a flexible screen. In this case, the flexible screen is not easily dented under pressing of a user. This not only helps improve a service life and reliability of the flexible screen, but also achieves good light and shadow performance of the flexible screen. Therefore, the foldable mechanism in this implementation offers strong product competitiveness.

It may be understood that in an implementation, when the foldable mechanism is in the unfolded state, the first support plate, the second support plate, and the main shaft together form the support surface, to support the second display area of the flexible screen. In this solution, because the main shaft needs to be connected to the first support plate and the second support plate through a plurality of connecting pieces, the main shaft needs to be provided with a plurality of clearance spaces, to avoid the connecting pieces or other components. The clearance space may be a groove or a through hole. As a result, a dent easily appears on a surface, of the main shaft, used to form the support surface, that is, flatness of the support surface is poor. In this case, the flexible screen is easily dented under pressing of the user, causing a problem such as a failure of the flexible screen. This is not conducive to improving the service life and the reliability of the flexible screen. In this implementation, when the foldable mechanism is in the unfolded state, the first support plate, the second support plate, the third support plate, and the fourth support plate of the foldable mechanism may be together joined into the support surface, to support the second display area of the flexible screen. In this case, in this implementation, the main shaft may no longer be used to support the second display area of the flexible screen, thereby avoiding a problem such as a failure of the flexible screen caused by poor flatness of the main shaft. In other words, when the electronic device in this implementation is in an unfolded state, the flexible screen has a long service life and high reliability.

In this implementation, because the first support plate, the second support plate, the third support plate, and the fourth support plate have a small quantity of connection positions with other structures, and a mating relationship between parts is simple, the first support plate, the second support plate, the third support plate, and the fourth support plate have a small quantity of holes, and are structurally simple. In this way, the support surface together formed by the first support plate, the second support plate, the third support plate, and the fourth support plate has a small quantity of holes, and a gap between two adjacent support plates is small, thereby facilitating flatness of the support surface, and helping improve the service life and the reliability of the flexible screen.

In this implementation, when the foldable mechanism is in the folded state, the first support plate, the second support plate, the third support plate, and the fourth support plate may together form the accommodating space with the main shaft, to accommodate the second display area of the flexible screen when the foldable mechanism is used in the electronic device. It may be understood that in a process of folding the foldable mechanism, the first support plate, the second support plate, the third support plate, and the fourth support plate may be automatically avoided, to form the accommodating space. Folding actions performed by the first support plate, the second support plate, the third support plate, and the fourth support plate on the flexible screen may be stable, and a compressive force applied to the flexible screen is relatively small. This helps reduce a risk that the flexible screen is damaged due to excessive compression of the foldable mechanism, thereby improving reliability of the flexible screen.

For example, when the foldable mechanism is in the folded state, the first support plate, the second support plate, the third support plate, and the fourth support plate may stably support the second display area of the flexible screen, thereby reducing a risk of damage caused by freedom of the flexible screen, and improving the service life and the reliability of the flexible screen. Therefore, the foldable mechanism in this implementation offers strong product competitiveness.

In a possible implementation, when the foldable mechanism is in the folded state, the first support plate and the second support plate are both disposed obliquely relative to the main shaft, the first support plate and the second support plate are close to each other in a direction close to the main shaft, the third support plate and the fourth support plate are also disposed obliquely relative to the main shaft, and the third support plate and the fourth support plate are close to each other in a direction away from the main shaft. In this way, in a process of folding the foldable mechanism, a volume of the accommodating space is large, and folding actions performed by the first support plate, the second support plate, the third support plate, and the fourth support plate on the flexible screen may be stable, and a compressive force applied to the flexible screen is relatively smaller. This helps reduce a risk that the flexible screen is damaged due to excessive compression of the foldable mechanism, thereby improving reliability of the flexible screen.

In a possible implementation, when the foldable mechanism is in the unfolded state, the first support plate and the second support plate together cover all of the main shaft; or
when the foldable mechanism is in the folded state, the first support plate and the second support plate respectively cover two side parts of the main shaft.

It may be understood that when the foldable mechanism is in the unfolded state, the first support plate and the second support plate together cover all of the main shaft. In this way, the first support plate and the second support plate are arranged more compactly, thereby facilitating miniaturization of the foldable mechanism.

It may be understood that when the foldable mechanism is in the folded state, the first support plate and the second support plate respectively cover the two side parts of the main shaft. In this way, in comparison with a solution in which the first support plate and the second support plate do not cover the two side parts of the main shaft when the foldable mechanism is in the folded state, the first support plate and the second support plate in this implementation are arranged more compactly, thereby facilitating miniaturization of the foldable mechanism.

In a possible implementation, the main shaft is bent to form an inner-side space, the main shaft is further provided with a first arc-shaped groove, and the first arc-shaped groove of the main shaft communicates with the inner-side space.

The first support plate includes a first support plate body and an arc-shaped block.

The arc-shaped block of the first support plate is disposed in the first arc-shaped groove of the main shaft, and is capable of rotating in the first arc-shaped groove of the main shaft. At least a part of the first support plate body is disposed in the inner-side space, and is capable of rotating in the inner-side space.

It may be understood that the arc-shaped block of the first support plate is disposed in the first arc-shaped groove of the main shaft. Through relative motion between the arc-shaped block and the first arc-shaped groove, the first support plate and the main shaft form a rotating connection structure through mating of the arc-shaped block and the arc-shaped groove, that is, the first support plate may be rotatably connected to the main shaft through the virtual axis. A structure of the rotating connection through the virtual axis is simple and occupies little space, which helps reduce a thickness of the foldable mechanism, so that it is easier to make the foldable mechanism and the electronic device thinner and lighter.

It may be understood that at least the part of the first support plate body is disposed in the inner-side space, which helps reduce the thickness of the foldable mechanism, so that it is easier to make the foldable mechanism and the electronic device thinner and lighter.

In a possible implementation, the first support plate includes a sliding block, and the first mounting bracket is provided with a second sliding slot; and the sliding block of the first support plate is disposed in the second sliding slot of the first mounting bracket, and is capable of sliding in the second sliding slot of the first mounting bracket.

It may be understood that the sliding block of the first support plate is disposed in the second sliding slot of the first mounting bracket. Through relative motion between the sliding block and the second sliding slot, the first support plate and the first mounting bracket form a sliding connection structure through mating of the sliding block and the sliding slot. The sliding connection structure in this implementation is simple.

In a possible implementation, the first mounting bracket includes a first side surface facing the main shaft, and the second sliding slot of the first mounting bracket is disposed obliquely relative to the first side surface of the first mounting bracket.

It may be understood that the second sliding slot of the first mounting bracket is disposed obliquely relative to the first side surface of the first mounting bracket, so that when the first mounting bracket and the first support plate are mated with each other, the first mounting bracket and the first support plate may form an oblique sliding slot mating structure; and when the electronic device is dropped or impacted, the first housing exerts pressure on the first mounting bracket. In this case, the first mounting bracket may share energy of the drop impact to the first support plate and the main shaft. In this way, the foldable mechanism has good drop impact performance, thereby helping improve the service life and the reliability of the electronic device.

According to a third aspect, this application provides a foldable mechanism. The foldable mechanism includes a main shaft, a first mounting bracket, a second mounting bracket, a first support plate, a second support plate, a third support plate, a fourth support plate, a first connecting piece, a second connecting piece, a first revolute pair, a second revolute pair, a third revolute pair, and a fourth revolute pair, and the main shaft is located between the first mounting bracket and the second mounting bracket. The first support plate is rotatably connected to the main shaft, and the third support plate is rotatably connected to the first mounting bracket.

The first connecting piece includes a rotating end, a connecting section, and a sliding end that are sequentially connected, the rotating end of the first connecting piece is rotatably connected to the main shaft, the sliding end of the first connecting piece is slidably connected to the first mounting bracket, the connecting section of the first connecting piece is connected to the first support plate through the first revolute pair, and the connecting section of the first connecting piece is further connected to the third support plate through the third revolute pair. The second support plate is rotatably connected to the main shaft, and the fourth support plate is rotatably connected to the second mounting bracket. The second connecting piece includes a rotating end, a connecting section, and a sliding end that are sequentially connected, the rotating end of the second connecting piece is rotatably connected to the main shaft, the sliding end of the second connecting piece is slidably connected to the second mounting bracket, the connecting section of the second connecting piece is connected to the second support plate through the second revolute pair, and the connecting section of the second connecting piece is further connected to the fourth support plate through the fourth revolute pair.

It may be understood that the foldable mechanism may be a crank-slider connecting rod motion mechanism. A main mechanism motion of the foldable mechanism may include a primary motion and a secondary motion. The primary motion may be a motion manner of a first four-connecting rod motion mechanism formed by the main shaft, the first support plate, the first connecting piece, and the first revolute pair. In addition, the secondary motion may be a motion manner of a second four-connecting rod motion mechanism formed by the third support plate, the first mounting bracket, the third revolute pair, and the first connecting piece. The foldable mechanism, through the primary motion and the secondary motion, may enable a degree of freedom for the first mounting bracket to move relative to the main shaft to be 1 in a process of unfolding or folding the foldable mechanism, so that a motion track of the first mounting bracket relative to the main shaft can be determined. Specifically, in the process of unfolding or folding the foldable mechanism, a motion manner of the first support plate, the third support plate, the first connecting piece, the first revolute pair, and the third revolute pair may constrain a motion track of the first mounting bracket, so that the motion track of the first mounting bracket relative to the main shaft can be determined. In this way, in a process of changing an unfolded state of the foldable mechanism to a folded state, the first support plate, the third support plate, the first connecting piece, the first revolute pair, and the third revolute pair can pull the first mounting bracket back to be close to the main shaft. In a process of changing the folded state of the foldable mechanism to the unfolded state, the first support plate, the third support plate, the first connecting piece, the first revolute pair, and the third revolute pair can push the first mounting bracket away from the main shaft.

It may be understood that in the process of unfolding or folding the foldable mechanism, a motion manner of the second support plate, the fourth support plate, the second connecting piece, the second revolute pair, and the fourth revolute pair may constrain a motion track of the second mounting bracket, so that the motion track of the second mounting bracket relative to the main shaft can be determined. In this way, in a process of changing the unfolded state of the foldable mechanism to the folded state, the second support plate, the fourth support plate, the second connecting piece, the second revolute pair, and the fourth revolute pair can pull the second mounting bracket back to be close to the main shaft. In a process of changing the folded state of the foldable mechanism to the unfolded state, the second support plate, the fourth support plate, the second connecting piece, the second revolute pair, and the fourth revolute pair can push the second mounting bracket away from the main shaft.

In a possible implementation, when the foldable mechanism is in the unfolded state, the third support plate, the first support plate, the second support plate, and the fourth support plate are sequentially joined and together form a support surface; or
when the foldable mechanism is in the folded state, the first support plate and the second support plate are disposed opposite to each other, the third support plate and the fourth support plate are disposed opposite to each other, and the main shaft, the first support plate, the second support plate, the third support plate, and the fourth support plate enclose an accommodating space.

It may be understood that when the foldable mechanism is in the unfolded state, the first support plate, the second support plate, the third support plate, and the fourth support plate may together form the support surface, so that when the foldable mechanism is used in an electronic device, the support surface can support a second display area of a flexible screen. In this case, the flexible screen is not easily dented under pressing of a user. This not only helps improve a service life and reliability of the flexible screen, but also achieves good light and shadow performance of the flexible screen. Therefore, the foldable mechanism in this implementation offers strong product competitiveness.

It may be understood that in an implementation, when the foldable mechanism is in the unfolded state, the first support plate, the second support plate, and the main shaft together form the support surface, to support the second display area of the flexible screen. In this solution, because the main shaft needs to be connected to the first support plate and the second support plate through a plurality of connecting pieces, the main shaft needs to be provided with a plurality of clearance spaces, to avoid the connecting pieces or other components. The clearance space may be a groove or a through hole. As a result, a dent easily appears on a surface, of the main shaft, used to form the support surface, that is, flatness of the support surface is poor. In this case, the flexible screen is easily dented under pressing of the user, causing a problem such as a failure of the flexible screen. This is not conducive to improving the service life and the reliability of the flexible screen. In this implementation, when the foldable mechanism is in the unfolded state, the first support plate, the second support plate, the third support plate, and the fourth support plate of the foldable mechanism may be together joined into the support surface, to support the second display area of the flexible screen. In this case, in this implementation, the main shaft may no longer be used to support the second display area of the flexible screen, thereby avoiding a problem such as a failure of the flexible screen caused by poor flatness of the main shaft. In other words, when the electronic device in this implementation is in an unfolded state, the flexible screen has a long service life and high reliability.

It may be understood that because the first support plate, the second support plate, the third support plate, and the fourth support plate have a small quantity of connection positions with other structures, and a mating relationship between parts is simple, the first support plate, the second support plate, the third support plate, and the fourth support plate have a small quantity of holes, and are structurally simple. In this way, the support surface together formed by the first support plate, the second support plate, the third support plate, and the fourth support plate has a small quantity of holes, and a gap between two adjacent support plates is small, thereby facilitating flatness of the support surface, and helping improve the service life and the reliability of the flexible screen.

It may be understood that when the foldable mechanism is in the folded state, the first support plate, the second support plate, the third support plate, and the fourth support plate may together form the accommodating space with the main shaft, to accommodate the second display area of the flexible screen when the foldable mechanism is used in the electronic device. It may be understood that in a process of folding the foldable mechanism, the first support plate, the second support plate, the third support plate, and the fourth support plate may be automatically avoided, to form the accommodating space. Folding actions performed by the first support plate, the second support plate, the third support plate, and the fourth support plate on the flexible screen may be stable, and a compressive force applied to the flexible screen is relatively small. This helps reduce a risk that the flexible screen is damaged due to excessive compression of the foldable mechanism, thereby improving reliability of the flexible screen.

For example, when the foldable mechanism is in the folded state, the first support plate, the second support plate, the third support plate, and the fourth support plate may stably support the second display area of the flexible screen, thereby reducing a risk of damage caused by freedom of the flexible screen, and improving the service life and the reliability of the flexible screen. Therefore, the foldable mechanism in this implementation offers strong product competitiveness.

In a possible implementation, when the foldable mechanism is in the folded state, the first support plate and the second support plate are both disposed obliquely relative to the main shaft, the first support plate and the second support plate are close to each other in a direction close to the main shaft, the third support plate and the fourth support plate are also disposed obliquely relative to the main shaft, and the third support plate and the fourth support plate are close to each other in a direction away from the main shaft. In this way, in a process of folding the electronic device, a volume of the accommodating space is large, and folding actions performed by the first support plate, the second support plate, the third support plate, and the fourth support plate on the flexible screen may be stable, and a compressive force applied to the flexible screen is relatively smaller. This helps reduce a risk that the flexible screen is damaged due to excessive compression of the foldable mechanism, thereby improving reliability of the flexible screen.

In a possible implementation, when the foldable mechanism is in the unfolded state, the first support plate and the second support plate together cover all of the main shaft; or
when the foldable mechanism is in the folded state, the first support plate and the second support plate respectively cover two side parts of the main shaft.

It may be understood that when the foldable mechanism is in the unfolded state, the first support plate and the second support plate together cover all of the main shaft. In this way, the first support plate and the second support plate are arranged more compactly, thereby facilitating miniaturization of the foldable mechanism.

It may be understood that when the foldable mechanism is in the folded state, the first support plate and the second support plate respectively cover the two side parts of the main shaft. In this way, in comparison with a solution in which the first support plate and the second support plate do not cover the two side parts of the main shaft when the foldable mechanism is in the folded state, the first support plate and the second support plate in this implementation are arranged more compactly, thereby facilitating miniaturization of the foldable mechanism.

In a possible implementation, the main shaft is bent to form an inner-side space, the main shaft is further provided with a first arc-shaped groove, and the first arc-shaped groove of the main shaft communicates with the inner-side space.

The first support plate includes a first support plate body and an arc-shaped block.

The arc-shaped block of the first support plate is disposed in the first arc-shaped groove of the main shaft, and is capable of rotating in the first arc-shaped groove of the main shaft. At least a part of the first support plate body is disposed in the inner-side space, and is capable of rotating in the inner-side space.

It may be understood that the arc-shaped block of the first support plate is disposed in the first arc-shaped groove of the main shaft. Through relative motion between the arc-shaped block and the first arc-shaped groove, the first support plate and the main shaft form a rotating connection structure through mating of the arc-shaped block and the arc-shaped groove, that is, the first support plate may be rotatably connected to the main shaft through the virtual axis. A structure of the rotating connection through the virtual axis is simple and occupies little space, which helps reduce a thickness of the foldable mechanism, so that it is easier to make the foldable mechanism and the electronic device thinner and lighter.

It may be understood that at least the part of the first support plate body is disposed in the inner-side space, which helps reduce the thickness of the foldable mechanism, so that it is easier to make the foldable mechanism and the electronic device thinner and lighter.

According to a fourth aspect, this application provides an electronic device. The electronic device includes a first housing, a second housing, a flexible screen, and the foldable mechanism according to any one of the claims, and the first mounting bracket is fastened to the first housing, and the second mounting bracket is fastened to the second housing.

The flexible screen includes a first display area, a second display area, and a third display area that are sequentially connected, the first display area is fastened to the first housing, and the third display area is fastened to the second housing.

It may be understood that because the first mounting bracket may be fastened to the first housing, the first housing may move with the first mounting bracket, and the foldable mechanism may control a motion track of the first housing by controlling a motion track of the first mounting bracket. In addition, because the second mounting bracket may be fastened to the second housing, the second housing may move with the second mounting bracket, and the foldable mechanism may control a motion track of the second housing by controlling a motion track of the second mounting bracket.

It may be understood that because the first mounting bracket is fastened to the first housing, a first support plate, a third support plate, a first connecting piece, and a first revolute pair can pull the first mounting bracket back to be close to a main shaft, and can also push the first mounting bracket away from the main shaft, so that the first mounting bracket can pull the first housing back to be close to the main shaft, and can also push the first housing away from the main shaft, that is, the first mounting bracket can drive the first housing to pull inward and push outward. Similarly, because the second mounting bracket may be fastened to the second housing, a second support plate, a fourth support plate, a second connecting piece, and a second revolute pair can pull the second mounting bracket back to be close to the main shaft, and can also push the second mounting bracket away from the main shaft, so that the second mounting bracket can pull the second housing back to be close to the main shaft, and can also push the second housing away from the main shaft, that is, the second mounting bracket can drive the second housing to pull inward and push outward.

It may be understood that when the electronic device is switched from an unfolded state to a folded state, the first housing and the second housing move toward each other, the first housing may drive the first mounting bracket to rotate relative to the main shaft through the first support plate, the third support plate, the first connecting piece, and the first revolute pair, and the second housing may drive the second mounting bracket to rotate relative to the main shaft through the second support plate, the fourth support plate, the second connecting piece, and the second revolute pair. In a process in which the first housing and the second housing are unfolded relative to each other, the first mounting bracket may drive the first housing to move in a direction away from the main shaft, and the second mounting bracket may drive the second housing to move in a direction away from the main shaft. That is, the foldable mechanism can implement an inward pulling motion of the housing when transitioning from the unfolded state to the folded state, and an outward pushing motion of the housing when transitioning from the folded state to the unfolded state. Therefore, in a process of unfolding or folding the foldable mechanism, a risk of pulling or applying a compressive force to the flexible screen can be reduced, thereby protecting the flexible screen, improving reliability of the flexible screen, and enabling the flexible screen and the electronic device to have a longer service life.

In a possible implementation, when the electronic device is in the unfolded state, the first support plate, the second support plate, the third support plate, and the fourth support plate together form a support surface, and the support surface supports the second display area; or when the foldable mechanism is in the folded state, the main shaft, the first support plate, the second support plate, the third support plate, and the fourth support plate enclose an accommodating space, and the accommodating space accommodates the second display area.

It may be understood that when the electronic device is in the unfolded state, the first support plate, the second support plate, the third support plate, and the fourth support plate of the foldable mechanism may together form the support surface, to support the second display area of the flexible screen. In this case, the flexible screen is not easily dented under pressing of a user. This not only helps improve a service life and reliability of the flexible screen, but also achieves good light and shadow performance of the flexible screen. Therefore, the foldable mechanism in this implementation offers strong product competitiveness.

It may be understood that in an implementation, when the electronic device is in the unfolded state, the first support plate, the second support plate, and the main shaft together form the support surface, to support the second display area of the flexible screen. In this solution, because the main shaft needs to be connected to the first support plate and the second support plate through a plurality of connecting pieces, the main shaft needs to be provided with a plurality of clearance spaces, to avoid the connecting pieces or other components. The clearance space may be a groove or a through hole. As a result, a dent easily appears on a surface, of the main shaft, used to form the support surface, that is, flatness of the support surface is poor. In this case, the flexible screen is easily dented under pressing of the user, causing a problem such as a failure of the flexible screen. This is not conducive to improving the service life and the reliability of the flexible screen. In this implementation, when the electronic device is in the unfolded state, the first support plate, the second support plate, the third support plate, and the fourth support plate of the foldable mechanism may be together joined into the support surface, to support the second display area of the flexible screen. In this case, in this implementation, the main shaft may no longer be used to support the second display area of the flexible screen, thereby avoiding a problem such as a failure of the flexible screen caused by poor flatness of the main shaft. In other words, when the electronic device in this implementation is in the unfolded state, the flexible screen has a long service life and high reliability.

It may be understood that because the first support plate, the second support plate, the third support plate, and the fourth support plate have a small quantity of connection positions with other structures, and a mating relationship between parts is simple, the first support plate, the second support plate, the third support plate, and the fourth support plate have a small quantity of holes, and are structurally simple. In this way, the support surface together formed by the first support plate, the second support plate, the third support plate, and the fourth support plate has a small quantity of holes, and a gap between two adjacent support plates is small, thereby facilitating flatness of the support surface, and helping improve the service life and the reliability of the flexible screen.

It may be understood that when the electronic device is in the folded state, the first support plate, the second support plate, the third support plate, and the fourth support plate may together form the accommodating space with the main shaft, to accommodate the second display area of the flexible screen. It may be understood that in a process of folding the electronic device, the first support plate, the second support plate, the third support plate, and the fourth support plate may be automatically avoided, to form the accommodating space. Folding actions performed by the first support plate, the second support plate, the third support plate, and the fourth support plate on the flexible screen may be stable, and a compressive force applied to the flexible screen is relatively small. This helps reduce a risk that the flexible screen is damaged due to excessive compression of the foldable mechanism, thereby improving reliability of the flexible screen.

For example, when the electronic device is in the folded state, the first support plate, the second support plate, the third support plate, and the fourth support plate may stably support the second display area of the flexible screen, thereby reducing a risk of damage caused by freedom of the flexible screen, and improving the service life and the reliability of the flexible screen. Therefore, the foldable mechanism in this implementation offers strong product competitiveness.

### BRIEF DESCRIPTION OF DRAWINGS

FIG. 1 is a diagram of a structure of an electronic device in an unfolded state according to an implementation of this application;
FIG. 2 is a partial sectional view of the electronic device shown in FIG. 1 at an A-A line according to an implementation;
FIG. 3 is a diagram of a structure of the electronic device shown in FIG. 1 in a folded state according to an implementation;
FIG. 4 is a partial sectional view of the electronic device shown in FIG. 3 at a B-B line according to an implementation;
FIG. 5 is a first partial exploded diagram of the electronic device shown in FIG. 1 according to an implementation;
FIG. 6 is a second partial exploded diagram of the electronic device shown in FIG. 1 according to an implementation;
FIG. 7 is a first partial exploded diagram of a foldable mechanism shown in FIG. 6 according to an implementation;
FIG. 8 is an enlarged diagram of a main shaft shown in FIG. 7 at C according to an implementation;
FIG. 9 is a partial exploded diagram of a first connecting assembly and a second connecting assembly shown in FIG. 7 according to an implementation;
FIG. 10 is a diagram of structures of a first support plate and a second support plate shown in FIG. 9 according to an implementation;
FIG. 11 is a diagram of structures of the first support plate and the second support plate shown in FIG. 9 from another angle;
FIG. 12 is a first diagram of a partial structure of the foldable mechanism shown in FIG. 6 according to an implementation;
FIG. 13 is a partial sectional view of a part of the foldable mechanism shown in FIG. 12 at a D-D line according to an implementation;
FIG. 14 is a partial sectional view of a part of the foldable mechanism shown in FIG. 12 in a folded state;
FIG. 15 is a diagram of structures of a third support plate and a fourth support plate shown in FIG. 9 according to an implementation;
FIG. 16 is a diagram of structures of the third support plate and the fourth support plate shown in FIG. 9 from another angle;
FIG. 17 is a second partial exploded diagram of the foldable mechanism shown in FIG. 6 according to an implementation;
FIG. 18 is a second diagram of a partial structure of the foldable mechanism shown in FIG. 6 according to an implementation;
FIG. 19 is a diagram of a structure of a part of the foldable mechanism shown in FIG. 18 in a folded state;
FIG. 20 is a diagram of structures of a first mounting bracket and a second mounting bracket shown in FIG. 9 according to an implementation;
FIG. 21 is a diagram of structures of the first mounting bracket and the second mounting bracket shown in FIG. 9 from another angle;
FIG. 22 is a third diagram of a partial structure of the foldable mechanism shown in FIG. 6 according to an implementation;
FIG. 23 is a diagram of a structure of a part of the foldable mechanism shown in FIG. 22 in a folded state;
FIG. 24 is a diagram of structures of a first connecting piece and a second connecting piece shown in FIG. 9 according to an implementation;
FIG. 25 is a third partial exploded diagram of the foldable mechanism shown in FIG. 6 according to an implementation;
FIG. 26 is a fourth diagram of a partial structure of the foldable mechanism shown in FIG. 6 according to an implementation;
FIG. 27 is a partial sectional view of a part of the foldable mechanism shown in FIG. 26 in the folded state;
FIG. 28 is a fourth partial exploded diagram of the foldable mechanism shown in FIG. 6 according to an implementation;
FIG. 29 is a fifth diagram of a partial structure of the foldable mechanism shown in FIG. 6 according to an implementation;
FIG. 30 is a sixth diagram of a partial structure of the foldable mechanism shown in FIG. 6 according to an implementation;
FIG. 31 is a partial sectional view of a part of the foldable mechanism shown in FIG. 30 taken along an E-E line according to an implementation;
FIG. 32 is a sectional view of a part of the foldable mechanism shown in FIG. 30 in the folded state;
FIG. 33 is a brief diagram of a connection relationship between a partial structure of the first connecting assembly and the main shaft shown in FIG. 7 according to an implementation;
FIG. 34 is a partial sectional view of the electronic device shown in FIG. 5 at an F-F line according to an implementation;
FIG. 35 is a partial sectional view of the electronic device shown in FIG. 3 at a G-G line according to an implementation;
FIG. 36 is a seventh diagram of a partial structure of the foldable mechanism shown in FIG. 6 according to an implementation;
FIG. 37 is a partial sectional view of a part of the foldable mechanism shown in FIG. 36 at an H-H line according to an implementation;
FIG. 38 is a brief diagram of a connection relationship between a partial structure of the first connecting assembly and the main shaft shown in FIG. 36 according to an implementation;
FIG. 39 is a brief diagram of a connection relationship between a partial structure of the first connecting assembly and the main shaft shown in FIG. 36 according to another implementation;
FIG. 40 is a brief diagram of a connection relationship between a partial structure of the first connecting assembly and the main shaft shown in FIG. 7 according to another implementation;
FIG. 41 is a first brief diagram of a connection relationship between a partial structure of the first connecting assembly and the main shaft shown in FIG. 7 according to still another implementation;
FIG. 42 is a first brief diagram of a connection relationship between a partial structure of the first connecting assembly and the main shaft shown in FIG. 7 according to still another implementation; and
FIG. 43 is a second brief diagram of a connection relationship between a partial structure of the first connecting assembly and the main shaft shown in FIG. 7 according to still another implementation.

### DESCRIPTION OF EMBODIMENTS

The following clearly and completely describes technical solutions in embodiments of this application with reference to the accompanying drawings in embodiments of this application.

In the descriptions of this application, it should be noted that the terms "mount", "connect", "connected", and "connection" should be understood in a broad sense, unless otherwise specified and limited. For example, the "connection" may be a detachable connection or a nondetachable connection, or may be a direct connection or an indirect connection through an intermediate medium, or may be an electrical connection or a mechanical connection. "Fastened" means that parts are connected to each other and a relative position relationship remains unchanged after the parts are connected to each other. "Rotatably connected" means that parts are connected to each other and can rotate relative to each other after the parts are connected to each other. "Slidably connected" means that parts are connected to each other and can slide relative to each other after the parts are connected to each other. "Movably connected" means that parts are connected to each other and can move relative to each other after the parts are connected to each other. In addition, integrating two components into an integrated structure through an integrated molding process means that in a process of forming one of the two components, the component is connected to the other component, and the two components do not need to be connected through secondary processing (for example, bonding, welding, snap-fit, or screwing). That a part A and a part B are disposed opposite to each other may be as follows: The part A is projected in a target direction to obtain a projection C, the part B is projected in a target direction to obtain a projection D, and the projection C and the projection D may at least largely overlap. In some embodiments, largely overlapping may be any one of the following cases: The projection C is completely located in the projection D; or the projection D is completely located in the projection C; or the projection C and the projection D cross each other, and a proportion of a cross area of the projection C and the projection D to the projection C or the projection D is greater than 50%.

Orientation terms mentioned in embodiments of this application, for example, "top", "bottom", "inside", and "outside" are directions with reference to the accompanying drawings. Therefore, the orientation terms are used to better and more clearly describe and understand embodiments of this application, instead of indicating or implying that a specified apparatus or element should have a specific orientation, and be constructed and operated in the specific orientation. Therefore, this cannot be understood as a limitation on embodiments of this application. A person of ordinary skill in the art may understand specific meanings of the foregoing terms based on specific situations.

In this specification and the claims of this application, the terms "first", "second", and the like are intended to distinguish between similar objects but do not indicate a specific order or sequence. It should be understood that data used in this way is interchangeable in proper circumstances, so that embodiments of this application can be implemented in an order other than the order illustrated or described herein. In addition, objects distinguished by "first", "second", and the like are usually of a same type, and a quantity of objects is not limited. For example, there may be one or more first objects. In addition, in this specification and the claims, "and/or" indicates at least one of connected objects, and the character "/" usually indicates an "or" relationship between associated objects. "A plurality of" means at least two.

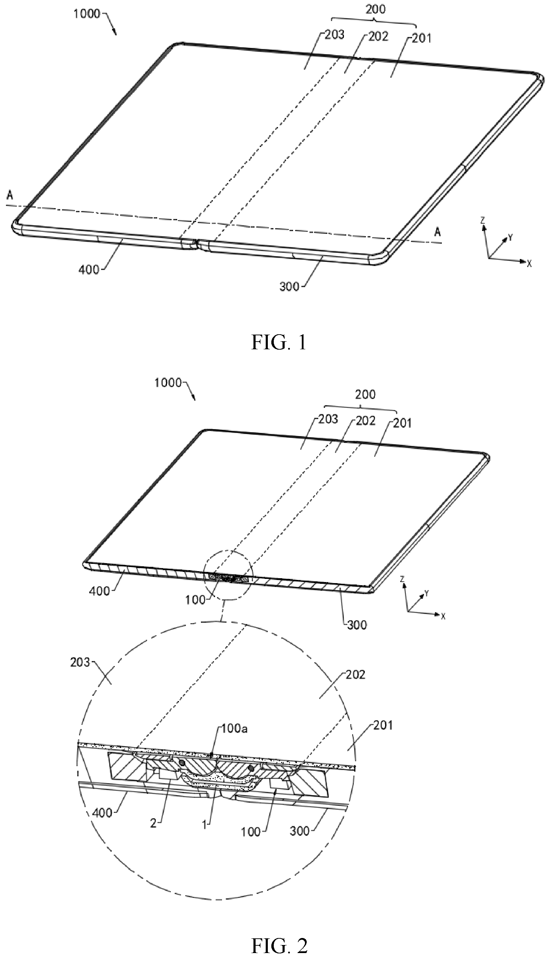

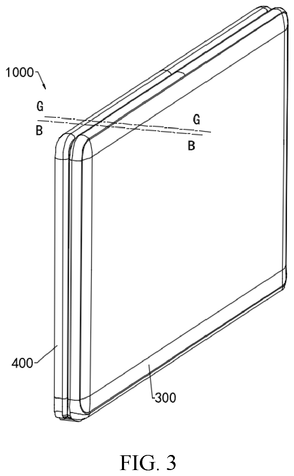

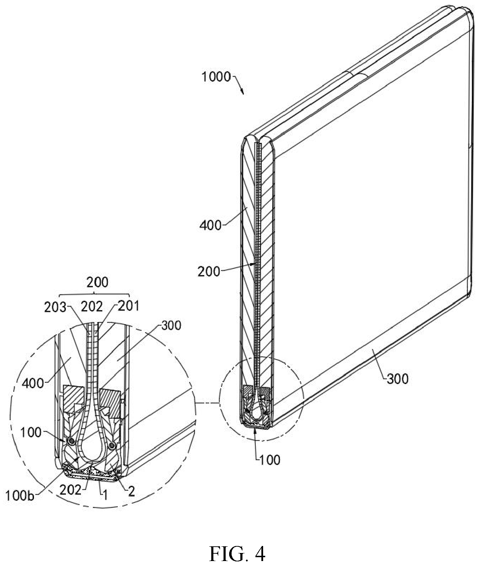

FIG. 1 is a diagram of a structure of an electronic device 1000 in an unfolded state according to an implementation of this application. FIG. 2 is a partial sectional view of the electronic device 1000 shown in FIG. 1 at an A-A line according to an implementation. FIG. 3 is a diagram of a structure of the electronic device 1000 shown in FIG. 1 in a folded state according to an implementation. FIG. 4 is a partial sectional view of the electronic device 1000 shown in FIG. 3 at a B-B line according to an implementation.

As shown in FIG. 1 to FIG. 4, this application provides the foldable electronic device 1000. The foldable electronic device 1000 may be a foldable device such as a mobile phone, a tablet computer, a personal computer, a notebook computer, a vehicle-mounted device, or a wearable device (for example, a smart band). In embodiments of this application, an example in which the electronic device 1000 is a mobile phone is used for detailed description.

For ease of description, for example, a thickness direction of the electronic device 1000 is defined as a Z-axis direction, and an extension direction of a rotating axis of the electronic device 1000 is defined as a Y-axis direction. A direction perpendicular to the Y-axis direction and the Z-axis direction is an X-axis direction. It may be understood that a coordinate system of the electronic device 1000 may alternatively be flexibly set based on a specific requirement.

In this implementation, when the direction of the rotating axis of the electronic device 1000 is the Y-axis direction, the electronic device 1000 may be unfolded or folded in the Y-axis direction. In this way, when the electronic device 1000 is in a folded state, a dimension of the electronic device 1000 in the X-axis direction becomes smaller. This embodiment is described by using an example in which "the direction of the rotation axis of the electronic device 1000 is the Y-axis direction". In this case, the electronic device 1000 can be folded left and right, and folding and unfolding of the electronic device 1000 affect a length dimension of the electronic device 1000. In some other embodiments, the rotating axis of the electronic device 1000 may alternatively be in the X-axis direction, that is, the electronic device 1000 may be unfolded or folded relatively in the X-axis direction. In this case, the electronic device 1000 can be folded up and down, and folding and unfolding of the electronic device 1000 affect a width dimension of the electronic device 1000.

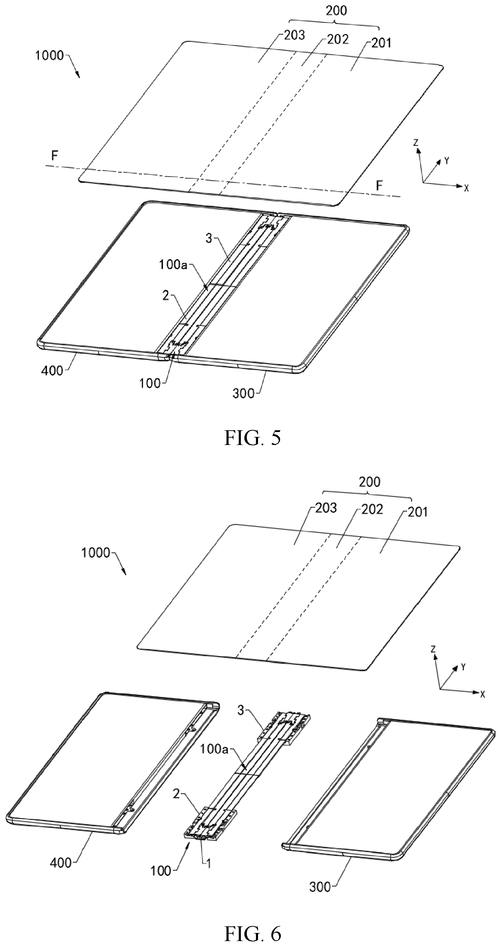

FIG. 5 is a first partial exploded diagram of the electronic device 1000 shown in FIG. 1 according to an implementation. FIG. 6 is a second partial exploded diagram of the electronic device 1000 shown in FIG. 1 according to an implementation.

As shown in FIG. 5 and FIG. 6, the electronic device 1000 includes a foldable mechanism 100, a flexible screen 200, a first housing 300, and a second housing 400. The flexible screen 200 may be an organic light-emitting diode (organic light-emitting diode, OLED) display, an active-matrix organic light-emitting diode (active-matrix organic light-emitting diode, AMOLED) display, a mini light-emitting diode (mini organic light-emitting diode) display, a micro organic light-emitting diode (micro light-emitting diode) display, a quantum dot light-emitting diode (quantum dot light-emitting diode, QLED) display, or the like. For example, a thickness direction of the foldable mechanism 100 may be the Z-axis direction, a length direction of the foldable mechanism 100 may be the Y-axis direction, and a width direction of the foldable mechanism 100 may be the X-axis direction. In another implementation, a coordinate system of the foldable mechanism 100 may alternatively be flexibly set based on a specific requirement.

As shown in FIG. 5 and FIG. 6, for example, the foldable mechanism 100 is connected between the first housing 300 and the second housing 400. The foldable mechanism 100 is configured to unfold or fold the first housing 300 and the second housing 400 relative to each other. The foldable mechanism 100, the first housing 300, and the second housing 400 may form a housing apparatus of the electronic device 1000.

Refer to FIG. 5 and FIG. 6. With reference to FIG. 1 and FIG. 2, when the first housing 300 and the second housing 400 are unfolded relative to each other to an unfolded state, the electronic device 1000 is in an unfolded state, and the first housing 300 and the second housing 400 may be at 180°. In another embodiment, the first housing 300 and the second housing 400 may alternatively slightly deviate from 180°, for example, may be at 165°, 177°, or 185°.

As shown in FIG. 3 and FIG. 4, when the first housing 300 and the second housing 400 are folded relative to each other to a closed state, the electronic device 1000 is in a folded state, the first housing 300 and the second housing 400 may be closed to each other, and there may be no large gap between the first housing 300 and the second housing 400. In this way, the electronic device 1000 has good appearance, and has good waterproof, dustproof, and foreign object prevention performance. That the first housing 300 and the second housing 400 are closed includes a case in which the first housing 300 and the second housing 400 abut against each other, or may include a case in which there is a small gap between the first housing 300 and the second housing 400. When there is a small gap between the first housing 300 and the second housing 400, foreign objects outside the electronic device 1000 may not enter the gap between the first housing 300 and the second housing 400.

The first housing 300 and the second housing 400 may alternatively be unfolded or folded relative to each other to an intermediate state, so that the electronic device 1000 is in an intermediate state. The intermediate state may be any state between the unfolded state and the folded state.

Refer to FIG. 5 and FIG. 6. With reference to FIG. 1 to FIG. 4, the flexible screen 200 includes a first display area 201, a second display area 202, and a third display area 203. The second display area 202 is connected between the first display area 201 and the third display area 203. In FIG. 1, FIG. 2, FIG. 5, and FIG. 6, the first display area 201, the second display area 202, and the third display area 203 are schematically distinguished by using dashed lines. The first display area 201 of the flexible screen 200 may be fastened to the first housing 300. The third display area 203 may be fastened to the second housing 400. In a process in which the first housing 300 and the second housing 400 are unfolded or folded relative to each other, the first housing 300 may drive the first display area 201 to move, the second housing 400 may drive the third display area 203 to move, the first display area 201 and the third display area 203 are unfolded or folded relative to each other, and the second display area 202 can be deformed.

It may be understood that because the first display area 201 is fastened to the first housing 300, and the third display area 203 is fastened to the second housing 400, when the first housing 300 and the second housing 400 are unfolded or folded relative to each other, relative unfolding and folding actions between the first display area 201 and the third display area 203 can be accurately controlled, so that a folding process and a motion form of the flexible screen 200 are controllable, and reliability is high.

Refer to FIG. 5 and FIG. 6. With reference to FIG. 1 and FIG. 2, when the electronic device 1000 is in the unfolded state, the flexible screen 200 may be in the unfolded state. For example, the first display area 201, the second display area 202, and the third display area 203 of the flexible screen 200 may be at 180°. In another embodiment, the first display area 201, the second display area 202, and the third display area 203 may alternatively slightly deviate from 180°, for example, may be at 165°, 177°, or 185°. In this case, the flexible screen 200 has a large continuous display area, that is, the flexible screen 200 can implement large-screen display, and therefore, user experience is good.

For example, when the electronic device 1000 is in the unfolded state, at least a part of the foldable mechanism 100 may be configured to support the second display area 202. In this way, when the second display area 202 is subject to a pressing force, a compressive force, an impact force, or the like, the foldable mechanism 100 may be configured to improve a pressure resistance capability and an impact resistance capability of the second display area 202, that is, ensure that the second display area 202 is not prone to being dented or the like.

As shown in FIG. 3 and FIG. 4, when the electronic device 1000 is in the folded state, the flexible screen 200 is in the folded state. For example, the first display area 201 and the third display area 203 of the flexible screen 200 are close to each other. The second display area 202 is in a bent shape. In this case, the flexible screen 200 may be approximately in a "water droplet" shape.

For example, when the electronic device 1000 is in the folded state, the flexible screen 200 is located in a space enclosed by the first housing 300, the foldable mechanism 100, and the second housing 400. The first display area 201 and the third display area 203 may be located between the first housing 300 and the second housing 400. In this case, the electronic device 1000 has a small planar dimension (a small width dimension), so that a user can easily carry and store the electronic device 1000.

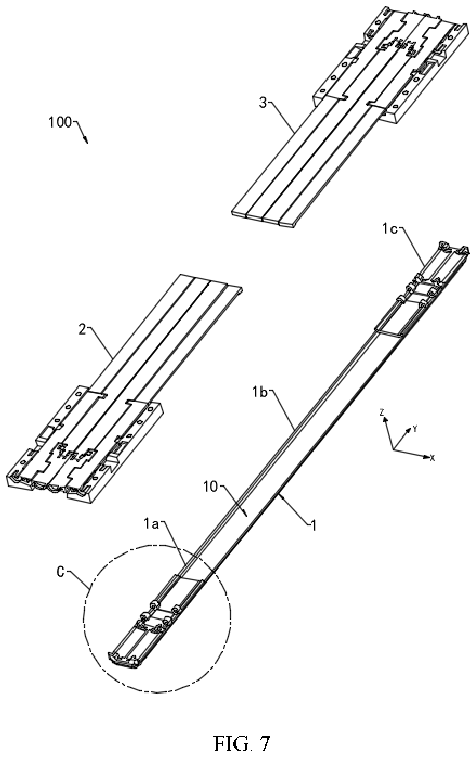

FIG. 7 is a first partial exploded diagram of the foldable mechanism 100 shown in FIG. 6 according to an implementation.

Refer to FIG. 7. With reference to FIG. 5 and FIG. 6, the foldable mechanism 100 includes a main shaft 1, a first connecting assembly 2, and a second connecting assembly 3. A length extension direction of the main shaft 1 may be the Y-axis direction. It may be understood that FIG. 5 to FIG. 7 schematically show only some components included in the foldable mechanism 100, and actual shapes, actual sizes, actual positions, and actual structures of these components are not limited by FIG. 5 to FIG. 7.

For example, the main shaft 1 is located between the first housing 300 and the second housing 400. The first connecting assembly 2 is connected to the first housing 300, the main shaft 1, and the second housing 400. The second connecting assembly 3 is connected to the first housing 300, the main shaft 1, and the second housing 400. For example, the first connecting assembly 2 and the second connecting assembly 3 may be spaced apart in the length extension direction (namely, the Y-axis direction) of the main shaft 1, for example, may be respectively connected to the top and the bottom of the main shaft 1. It may be understood that the first connecting assembly 2 and the second connecting assembly 3 may be mainly configured to enable the first housing 300 and the second housing 400 to be unfolded or folded relative to each other.

Refer to FIG. 5 to FIG. 7. With reference to FIG. 1 and FIG. 2, for example, when the electronic device 1000 is in the unfolded state, both the first connecting assembly 2 and the second connecting assembly 3 are opened, and the first connecting assembly 2 and the second connecting assembly 3 together form at least a part of a support surface 100a. The support surface 100a may be configured to support the second display area 202. In addition, the first connecting assembly 2 covers a part of the main shaft 1, and the second connecting assembly 3 covers a part of the main shaft 1.

Refer to FIG. 5 to FIG. 7. With reference to FIG. 3 and FIG. 4, for example, when the electronic device 1000 is in the folded state, the main shaft 1, the first connecting assembly 2, and the second connecting assembly 3 enclose at least a part of an accommodating space 100b. The accommodating space 100b may be configured to accommodate the second display area 202. In addition, the first connecting assembly 2 and the second connecting assembly 3 may be located on a same side of the main shaft 1.

It may be understood that the second connecting assembly 3 and the first connecting assembly 2 may be of same or similar structures, symmetric or partially symmetric structures, or different structures. In this implementation, the second connecting assembly 3 and the first connecting assembly 2 are of symmetric structures. For a basic design of a component structure of the second connecting assembly 3, a design of a connection relationship between components, and a design of a connection relationship between a component and a structure other than the assembly, refer to a related solution of the first connecting assembly 2. In addition, the second connecting assembly 3 and the first connecting assembly 2 are allowed to be slightly different in a detailed structure or a position arrangement of the components. Details are not described herein again. The following uses a structure of the first connecting assembly 2 as an example for description.

In another implementation, the foldable mechanism 100 may further include a third connecting assembly (not shown in the figure), a fourth connecting assembly (not shown in the figure), ..., and an N^{th} connecting assembly (not shown in the figure). N is an integer greater than 2. The third connecting assembly, the fourth connecting assembly, ..., and the N^{th} connecting assembly may be connected to the first housing 300, the main shaft 1, and the second housing 400. The third connecting assembly, the fourth connecting assembly, ..., and the N^{th} connecting assembly may be mated with the first connecting assembly 2 and the second connecting assembly 3, so that the first housing 300 and the second housing 400 can be unfolded or folded relative to each other.

Refer to FIG. 7. With reference to FIG. 5 and FIG. 6, the main shaft 1 includes a first end part 1a, a middle part 1b, and a second end part 1c that are sequentially connected. The first end part 1a of the main shaft 1 may be connected to the first connecting assembly 2. The second end part 1c of the main shaft 1 may be connected to the second connecting assembly 3. It may be understood that the second end part 1c of the main shaft 1 and the first end part 1a of the main shaft 1 may be of same or similar structures, symmetric or partially symmetric structures, or different structures. In this implementation, the second end part 1c of the main shaft 1 and the first end part 1a of the main shaft 1 are of symmetric structures. For a basic design of a component structure of the second end part 1c of the main shaft 1, a design of a connection relationship between components, and a design of a connection relationship between a component and a structure other than the assembly, refer to a related solution of the first end part 1a of the main shaft 1. In addition, the second end part 1c of the main shaft 1 and the first end part 1a of the main shaft 1 are allowed to be slightly different in a detail structure or a position arrangement of the components. Details are not described herein again. The following uses a structure of the first end part 1a of the main shaft 1 as an example for description.

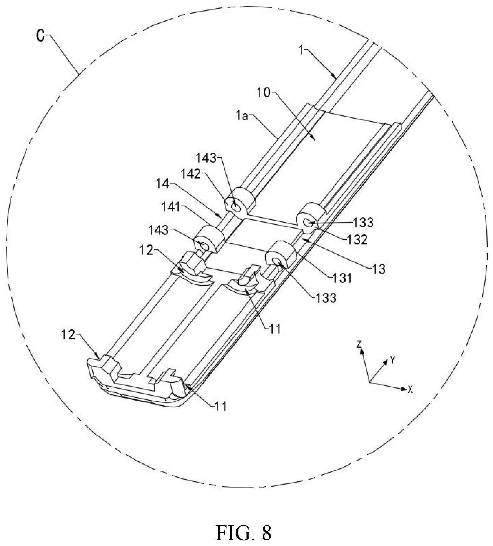

FIG. 8 is an enlarged diagram of the main shaft 1 shown in FIG. 7 at C according to an implementation.

Refer to FIG. 8. With reference to FIG. 7, for example, the main shaft 1 is bent to form an inner-side space 10 of the main shaft 1. The inner-side space 10 is located on an inner side of the main shaft 1.

For example, the first end part 1a of the main shaft 1 is provided with a first arc-shaped groove 11. The first arc-shaped groove 11 of the main shaft 1 may communicate with the inner-side space 10 of the main shaft 1. There may be one arc-shaped groove 11 or a plurality of first arc-shaped grooves 11 of the main shaft 1. When there are the plurality of first arc-shaped grooves 11 of the main shaft 1, the plurality of first arc-shaped grooves 11 of the main shaft 1 may be arranged in the Y-axis direction. This implementation is described by using an example in which there are two first arc-shaped grooves 11 of the main shaft 1.

For example, the first end part 1a of the main shaft 1 is further provided with a second arc-shaped groove 12. For a manner of providing the second arc-shaped groove 12 of the main shaft 1, refer to a manner of providing the first arc-shaped groove 11 of the main shaft 1. Details are not described herein again.

In an implementation, the first arc-shaped groove 11 and the second arc-shaped groove 12 of the main shaft 1 may be spaced apart in the X-axis direction. For example, the first arc-shaped groove 11 and the second arc-shaped groove 12 of the main shaft 1 may be symmetrically provided. In another implementation, a relative position between the first arc-shaped groove 11 and the second arc-shaped groove 12 of the main shaft 1 is not specifically limited.

For example, the first end part 1a of the main shaft 1 is further provided with a first rotating space 13. The first rotating space 13 may be of a groove structure, or may be of a through-hole structure. The first rotating space 13 of the main shaft 1 may be located on one side of the first arc-shaped groove 11 of the main shaft 1. The first rotating space 13 of the main shaft 1 includes a first side wall 131 and a second side wall 132 that are disposed opposite to each other. The first side wall 131 and the second side wall 132 of the first rotating space 13 of the main shaft 1 each are provided with a rotating shaft hole 133. The rotating shaft hole 133 of the second side wall 132 of the first rotating space 13 of the main shaft 1 and the rotating shaft hole 133 of the first side wall 131 of the first rotating space 13 of the main shaft 1 are provided opposite to each other.

For example, the first end part 1a of the main shaft 1 is further provided with a second rotating space 14. The second rotating space 14 may be of a groove structure, or may be of a through-hole structure. The second rotating space 14 of the main shaft 1 may be located on one side of the second arc-shaped groove 12 of the main shaft 1. The second rotating space 14 of the main shaft 1 includes a first side wall 141 and a second side wall 142 that are disposed opposite to each other. The first side wall 141 and the second side wall 142 of the second rotating space 14 of the main shaft 1 each are provided with a rotating shaft hole 143. The rotating shaft hole 143 of the second side wall 142 of the second rotating space 14 of the main shaft 1 and the rotating shaft hole 143 of the first side wall 141 of the second rotating space 14 of the main shaft 1 are provided opposite to each other.

In an implementation, the second rotating space 14 and the first rotating space 13 of the main shaft 1 may be spaced apart in the X-axis direction. For example, the second rotating space 14 and the first rotating space 13 of the main shaft 1 may be symmetrically provided. In another implementation, a relative position between the second rotating space 14 and the first rotating space 13 of the main shaft 1 is not specifically limited.

In an implementation, the main shaft 1 may be further provided with a protrusion (not shown in the figure). The protrusion may be configured to limit the first connecting assembly 2 and/or the second connecting assembly 3, to prevent the first connecting assembly 2 from accidentally detaching from the main shaft 1, to improve connection reliability and motion reliability of the first connecting assembly 2, the second connecting assembly 3, and the main shaft 1, so that reliability of the foldable mechanism 100 is higher.

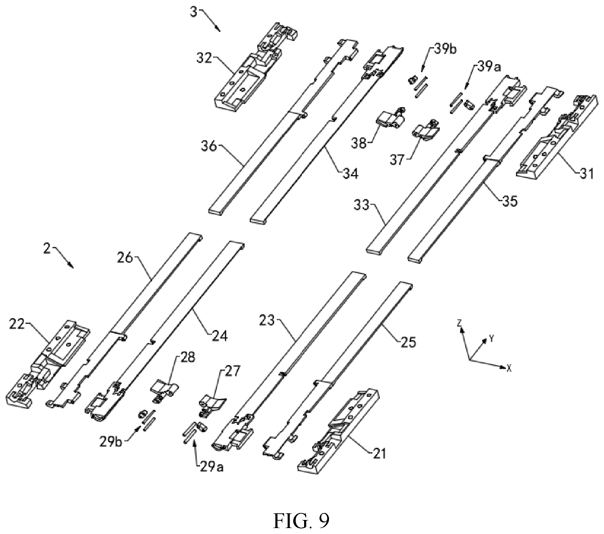

FIG. 9 is a partial exploded diagram of the first connecting assembly 2 and the second connecting assembly 3 shown in FIG. 7 according to an implementation.

As shown in FIG. 9, the first connecting assembly 2 includes a first mounting bracket 21, a second mounting bracket 22, a first support plate 23, a second support plate 24, a third support plate 25, a fourth support plate 26, a first connecting piece 27, a second connecting piece 28, a first revolute pair 29a, and a second revolute pair 29b. It may be understood that FIG. 9 and related accompanying drawings in the following descriptions schematically show only some components included in the first connecting assembly 2, and actual shapes, actual sizes, actual positions, and actual structures of these components are not limited by FIG. 9 and the accompanying drawings in the following descriptions. In another implementation, the first connecting assembly 2 may have more or fewer components. The first connecting assembly 2 may have more components. For example, the first connecting assembly 2 may further include a synchronization component (not shown in the figure) and/or a damping component (not shown in the figure). The first connecting assembly 2 may alternatively have fewer components. For example, the first connecting assembly 2 may not include the first revolute pair 29a and/or the second revolute pair 29b.

It may be understood that for a manner of disposing the second connecting assembly 3 in this implementation, refer to a manner of disposing the first connecting assembly 2. Therefore, the second connecting assembly 3 in this implementation may also include a first mounting bracket 31, a second mounting bracket 32, a first support plate 33, a second support plate 34, a third support plate 35, a fourth support plate 36, a first connecting piece 37, a second connecting piece 38, a first revolute pair 39a, and a second revolute pair 39b. In an implementation, the first mounting bracket 31 of the second connecting assembly 3 and the first mounting bracket 21 of the first connecting assembly 2 may be of an integrated structure. The second mounting bracket 32 of the second connecting assembly 3 and the second mounting bracket 22 of the first connecting assembly 2 may be of an integrated structure. The first support plate 33 of the second connecting assembly 3 and the first support plate 23 of the first connecting assembly 2 may be of an integrated structure. The second support plate 34 of the second connecting assembly 3 and the second support plate 24 of the first connecting assembly 2 may be of an integrated structure. The third support plate 35 of the second connecting assembly 3 and the third support plate 25 of the first connecting assembly 2 may be of an integrated structure. The fourth support plate 36 of the second connecting assembly 3 and the fourth support plate 26 of the first connecting assembly 2 may be of an integrated structure. In another implementation, the components of the second connecting assembly 3 and the components of the first connecting assembly 2 may alternatively be mechanical parts that are separately disposed.

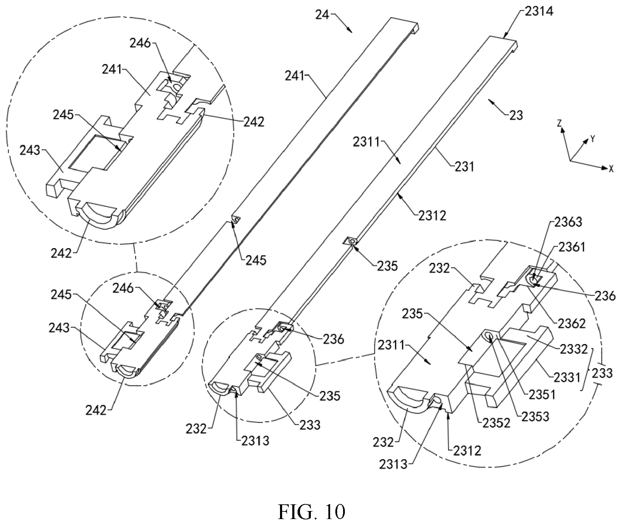

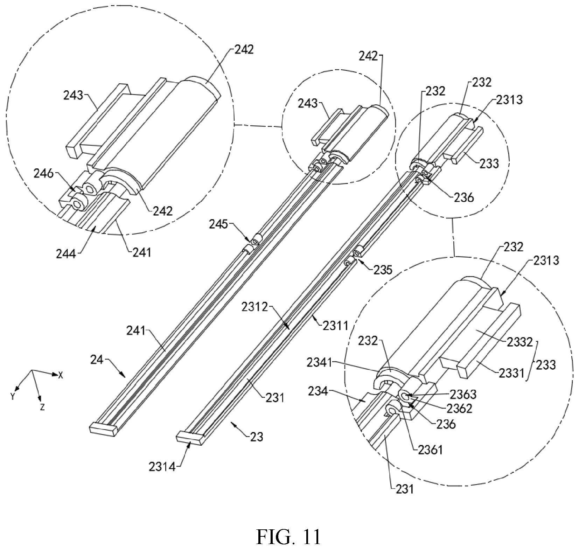

FIG. 10 is a diagram of structures of the first support plate 23 and the second support plate 24 shown in FIG. 9 according to an implementation. FIG. 11 is a diagram of structures of the first support plate 23 and the second support plate 24 shown in FIG. 9 from another angle.

As shown in FIG. 10 and FIG. 11, the first support plate 23 includes a first support plate body 231, an arc-shaped block 232, and a sliding block 233. It may be understood that the first support plate 23 may be an integrally formed mechanical part, to have high structural strength. It may be understood that FIG. 10 and related accompanying drawings in the following descriptions schematically show only some components included in the first support plate 23, and actual shapes, actual sizes, actual positions, and actual structures of these components are not limited by FIG. 10 and the accompanying drawings in the following descriptions. In addition, when the first support plate 23 is in some other forms, the first support plate 23 may alternatively not include the arc-shaped block 232 and/or the sliding block 233.

It may be understood that the first support plate 23 may be detachably connected to form an integrated mechanical part through different mechanical parts. In this way, when the first support plate 23 is assembled with another mechanical part, different mechanical parts may be first separately assembled with the another mechanical part, and then the different mechanical parts are assembled as a whole. This assembly manner can reduce difficulty in assembling the another mechanical part and the first support plate 23.

As shown in FIG. 10 and FIG. 11, the arc-shaped block 232 of the first support plate 23 protrudes from the first support plate body 231. There may be one arc-shaped block 232 or a plurality of arc-shaped blocks 232 (that is, at least two) of the first support plate 23. When there are the plurality of arc-shaped blocks 232 of the first support plate 23, the plurality of arc-shaped blocks 232 of the first support plate 23 protrude, in a one-to-one correspondence, from a plurality of surfaces of the first support plate body 231 in the Y-axis direction. The following is described by using an example in which two arc-shaped blocks 232 of the first support plate 23 protrude, in a one-to-one correspondence, from two surfaces of the first support plate body 231 in the Y-axis direction.

For example, the first support plate body 231 includes a top surface 2311, a bottom surface 2312, a first end surface 2313, and a second end surface 2314. The first end surface 2313 and the second end surface 2314 of the first support plate body 231 are connected between the top surface 2311 and the bottom surface 2312 of the first support plate body 231. For example, the top surface 2311 and the bottom surface 2312 of the first support plate body 231 may be two surfaces of the first support plate body 231 in the Z-axis direction. The first end surface 2313 and the second end surface 2314 of the first support plate body 231 may be two surfaces of the first support plate body 231 in the Y-axis direction. The bottom surface 2312 of the first support plate body 231 faces the main shaft 1 when the foldable mechanism 100 is in the unfolded state.

As shown in FIG. 10 and FIG. 11, the first support plate body 231 is provided with a clearance space 234. The clearance space 234 of the first support plate body 231 may form openings on the bottom surface 2312 and the second end surface 2314 of the first support plate body 231. In this case, the clearance space 234 of the first support plate body 231 includes a first wall surface 2341. The first wall surface 2341 of the first support plate body 231 and the first end surface 2313 of the first support plate body 231 are disposed facing away from each other. In another implementation, the clearance space 234 of the first support plate body 231 may alternatively form an opening only on the bottom surface 2312 of the first support plate body 231. A specific structure of the clearance space 234 of the first support plate body 231 is not specifically limited in this implementation.

As shown in FIG. 10 and FIG. 11, one arc-shaped block 232 of the first support plate 23 protrudes from the first end surface 2313 of the first support plate body 231. One arc-shaped block 232 of the first support plate 23 protrudes from the first wall surface 2341 of the clearance space 234 of the first support plate body 231. It may be understood that an implementation in which the arc-shaped block 232 of the first support plate 23 protrudes from the first support plate body 231 is not limited to the implementation described above. In another implementation, a manner in which the arc-shaped block 232 of the first support plate 23 protrudes from the first support plate body 231 is not specifically limited.

As shown in FIG. 10 and FIG. 11, the first support plate 23 is provided with a first rotating space 235. For example, the first rotating space 235 may form an opening on the top surface 2311 of the first support plate body 231. In this case, the first rotating space 235 may be of a groove structure. In another implementation, the first rotating space 235 may form openings on the top surface 2311 and the bottom surface 2312 of the first support plate body 231. In this case, the first rotating space 235 may be of a through-hole structure.

For example, the first rotating space 235 of the first support plate 23 may include a first side wall 2351 and a second side wall 2352 that are disposed opposite to each other. The first side wall 2351 and the second side wall 2352 of the first rotating space 235 of the first support plate 23 each are provided with a rotating shaft hole 2353. The rotating shaft hole 2353 of the first side wall 2351 of the first rotating space 235 of the first support plate 23 and the rotating shaft hole 2353 of the second side wall 2352 of the first rotating space 235 of the first support plate 23 are provided opposite to each other.

It may be understood that a quantity of first rotating spaces 235 of the first support plate 23 in this implementation is not limited to the two shown in FIG. 10 and FIG. 11. In another implementation, the quantity of first rotating spaces 235 of the first support plate 23 is not specifically limited.

For example, the first rotating space 235 of the first support plate 23 may be located on one side of the arc-shaped block 232 of the first support plate 23 in the X-axis direction.

As shown in FIG. 10 and FIG. 11, for example, the first support plate 23 is further provided with a second rotating space 236. For example, the second rotating space 236 may form openings on the top surface 2311 and the bottom surface 2312 of the first support plate body 231. In this case, the second rotating space 236 may be of a through-hole structure. In another implementation, the second rotating space 236 may form an opening on the bottom surface 2312 of the first support plate body 231. In this case, the second rotating space 236 may be of a groove structure.

For example, the second rotating space 236 of the first support plate 23 may include a first side wall 2361 and a second side wall 2362 that are disposed opposite to each other. The first side wall 2361 and the second side wall 2362 of the second rotating space 236 of the first support plate 23 each are provided with a rotating shaft hole 2363. The rotating shaft hole 2363 of the first side wall 2361 of the second rotating space 236 of the first support plate 23 and the rotating shaft hole 2363 of the second side wall 2362 of the second rotating space 236 of the first support plate 23 are provided opposite to each other.

For example, the rotating shaft hole 2363 of the first side wall 2361 of the second rotating space 236 of the first support plate 23, the rotating shaft hole 2363 of the second side wall 2362 of the second rotating space 236 of the first support plate 23, the rotating shaft hole 2353 of the first side wall 2351 of the first rotating space 235 of the first support plate 23, and the rotating shaft hole 2353 of the second side wall 2352 of the first rotating space 235 of the first support plate 23 may be aligned on a same straight line.

For example, the sliding block 233 of the first support plate 23 includes a first connecting part 2331 and a second connecting part 2332. For example, in the Y-axis direction, a length of the first connecting part 2331 of the sliding block 233 of the first support plate 23 is greater than a length of the second connecting part 2332 of the sliding block 233 of the first support plate 23. In this case, in the Y-axis direction, the first connecting part 2331 of the sliding block 233 of the first support plate 23 extends outward from two sides of the second connecting part 2332 of the sliding block 233 of the first support plate 23.

As shown in FIG. 10 and FIG. 11, the sliding block 233 of the first support plate 23 protrudes from one side of the first support plate body 231. For example, the first connecting part 2331 of the sliding block 233 of the first support plate 23 is connected to the first support plate body 231.

For example, the sliding block 233 of the first support plate 23 may be located, in the X-axis direction, on one side, of the first rotating space 235 of the first support plate 23, away from the arc-shaped block 232 of the first support plate 23.

It may be understood that the second support plate 24 and the first support plate 23 may be of same or similar structures, symmetric or partially symmetric structures, or different structures. In this implementation, the second support plate 24 and the first support plate 23 may be of symmetric structures. For a basic design of a component structure of the second support plate 24, a design of a connection relationship between components, and a design of a connection relationship between a component and a structure other than the assembly, refer to a related solution of the first support plate 23. For example, the second support plate 24 includes a second support plate body 241, an arc-shaped block 242, a sliding block 243, a clearance space 244, a first rotating space 245, and a second rotating space 246. In addition, the second support plate 24 and the first support plate 23 are allowed to be slightly different in a detailed structure or a position arrangement of the components. Details are not described herein again.

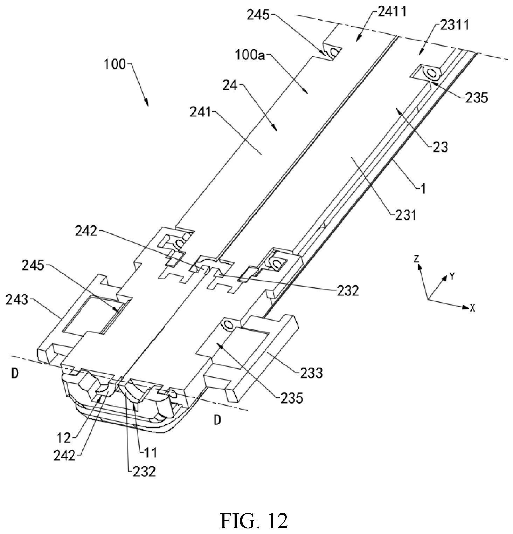

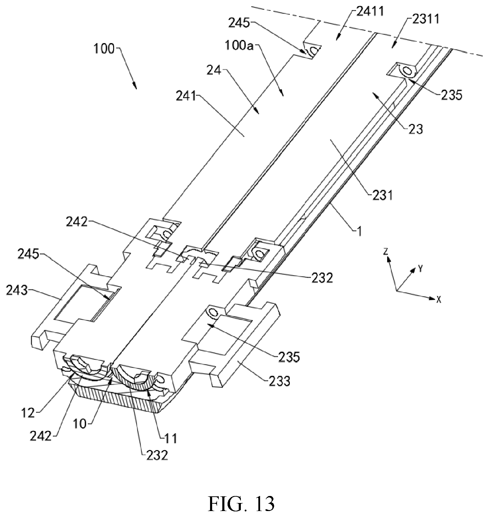

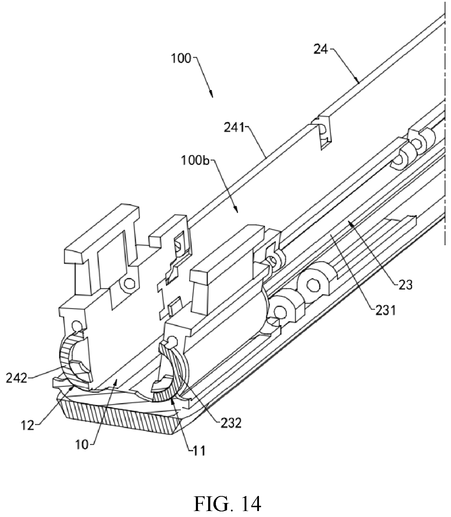

FIG. 12 is a first diagram of a partial structure of the foldable mechanism 100 shown in FIG. 6 according to an implementation. FIG. 13 is a partial sectional view of a part of the foldable mechanism 100 shown in FIG. 12 at a D-D line according to an implementation. FIG. 14 is a partial sectional view of a part of the foldable mechanism 100 shown in FIG. 12 in the folded state.

Refer to FIG. 12 to FIG. 14. With reference to FIG. 8, FIG. 10, and FIG. 11, the first support plate 23 is rotatably connected to the main shaft 1.

For example, the arc-shaped block 232 of the first support plate 23 is disposed in the first arc-shaped groove 11 of the main shaft 1. Through relative motion between the arc-shaped block and the first arc-shaped groove, the first support plate 23 and the main shaft 1 form a rotating connection structure through mating of the arc-shaped block and the arc-shaped groove, that is, the first support plate 23 may be rotatably connected to the main shaft 1 through a virtual axis.

In this implementation, there are two arc-shaped blocks 232 of the first support plate 23 and two first arc-shaped grooves 11 of the main shaft 1. The two arc-shaped blocks 232 of the first support plate 23 are disposed, in a one-to-one correspondence, in the two first arc-shaped grooves 11 of the main shaft 1.

In another implementation, the first support plate 23 may alternatively be rotatably connected to the main shaft 1 through a physical axis. In this case, a connection relationship between the first support plate 23 and the main shaft 1 is reliable, a rotary backlash is small, and a rotation action is accurate and stable.

In another implementation, the rotating connection structure between the first support plate 23 and the main shaft 1 may be entirely connected through a physical axis, or may be entirely connected through a virtual axis, or may be connected through a combination of a physical axis and a virtual axis. This is not strictly limited in this application.

It may be understood that the first rotating space 235 of the first support plate 23 may be located on one side, of the arc-shaped block 232 of the first support plate 23, away from the main shaft 1. The first rotating space 245 of the second support plate 24 may be located on one side, of the arc-shaped block 242 of the second support plate 24, away from the main shaft 1.

Refer to FIG. 12 to FIG. 14. With reference to FIG. 8, FIG. 10, and FIG. 11, the second support plate 24 is rotatably connected to the main shaft 1. It may be understood that for a connection manner of the second support plate 24 and the main shaft 1, refer to a connection manner of the first support plate 23 and the main shaft 1. Details are not described herein again.

Refer to FIG. 12 and FIG. 13. When the foldable mechanism 100 is in the unfolded state, the first support plate 23 and the second support plate 24 are joined with each other to form a part of the support surface 100a. In this case, the first support plate 23 and the second support plate 24 are close to each other, and a distance between the first support plate 23 and the second support plate 24 is small. It may be understood that when the foldable mechanism 100 is in the unfolded state, the top surface 2311 of the first support plate body 231 faces away from the main shaft 1, and the top surface 2411 of the second support plate body 241 faces away from the main shaft 1.

A case in which the first support plate 23 and the second support plate 24 are joined may include but is not limited to the following scenario: One part of the first support plate 23 and one part of the second support plate 24 are in contact with each other, without a gap between the contact parts, and a notch or a gap may be formed between the other part of the first support plate 23 and the other part of the second support plate 24; or the first support plate 23 and the second support plate 24 are in contact with each other, without a gap between the two; or one part of the first support plate 23 and one part of the second support plate 24 are close to each other, with a small gap between the parts that are close to each other, and a notch or a gap may be formed between the other part of the first support plate 23 and the other part of the second support plate 24; or the first support plate 23 and the second support plate 24 are close to each other, with a small gap between the two. It may be understood that when there is a small gap between the first support plate 23 and the second support plate 24, or there is a small gap between one part of the first support plate 23 and one part of the second support plate 24, the user presses an area, of the flexible screen 200, corresponding to the gap, without forming an obvious dent in the corresponding area of the flexible screen 200, so that the first support plate 23 and the second support plate 24 can provide strong support for the flexible screen 200.

When there is a notch or a gap between the first support plate 23 and the second support plate 24, or there is a notch or a gap between one part of the first support plate 23 and one part of the second support plate 24, an area of the notch or the gap may be reduced as much as possible by optimizing a dimension and a shape of a component of the foldable mechanism 100, so that an area, of the flexible screen 200, corresponding to the notch or the gap may be slightly dented under pressing of the user, instead of forming an obvious dent.

Refer to FIG. 12 to FIG. 14. With reference to FIG. 8, FIG. 10, and FIG. 11, for example, at least a part of the first support plate body 231 is disposed in the inner-side space 10, and can rotate in the inner-side space 10. In this way, the first support plate 23 may use an internal space of the main shaft 1, thereby facilitating thinning of the foldable mechanism 100.

For example, at least a part of the second support plate body 241 is disposed in the inner-side space 10, and can rotate in the inner-side space 10. In this way, the second support plate 24 may use an internal space of the main shaft 1, thereby facilitating thinning of the foldable mechanism 100.

As shown in FIG. 13, for example, when the foldable mechanism 100 is in the unfolded state, the first support plate 23 and the second support plate 24 together cover all of the main shaft 1. In this way, the first support plate 23 and the second support plate 24 are arranged more compactly, thereby facilitating miniaturization of the foldable mechanism 100.

As shown in FIG. 13, for example, when the foldable mechanism 100 is in the unfolded state, the arc-shaped block 232 of the first support plate 23 rotates into the first arc-shaped groove 11 of the main shaft 1, the arc-shaped block 242 of the second support plate 24 rotates into the second arc-shaped groove 12 of the main shaft 1, a large part of the first support plate body 231 rotates into the inner-side space 10, and a large part of the second support plate body 241 rotates into the inner-side space 10.

As shown in FIG. 14, when the foldable mechanism 100 is in the folded state, the first support plate body 231 of the first support plate 23 and the second support plate body 241 of the second support plate 24 are disposed opposite to each other, and the first support plate body 231, the second support plate body 241, and the main shaft 1 together enclose one part of the accommodating space 100b.

As shown in FIG. 14, for example, when the foldable mechanism 100 is in the folded state, one part of the first support plate body 231 is located in the inner-side space 10 of the main shaft 1, and one part of the second support plate body 241 is located in the inner-side space 10 of the main shaft 1.

As shown in FIG. 14, for example, when the foldable mechanism 100 is in the folded state, the first support plate 23 and the second support plate 24 are both disposed obliquely relative to the main shaft 1, and the first support plate 23 and the second support plate 24 are close to each other in a direction close to the main shaft 1. It may be understood that when the foldable mechanism 100 is in the folded state, an included angle is formed between the first support plate 23 and the second support plate 24, and the first support plate 23 and the second support plate 24 may be approximately V-shaped.

As shown in FIG. 14, for example, when the foldable mechanism 100 is in the folded state, the first support plate 23 and the second support plate 24 respectively cover two side parts of the main shaft 1. In this way, in comparison with a solution in which the first support plate 23 and the second support plate 24 do not cover the two side parts of the main shaft 1 when the foldable mechanism 100 is in the folded state, the first support plate 23 and the second support plate 24 in this implementation are arranged more compactly, thereby facilitating miniaturization of the foldable mechanism 100.

As shown in FIG. 14, for example, when the foldable mechanism 100 is in the folded state, the arc-shaped block 232 of the first support plate 23 partially rotates out of the first arc-shaped groove 11 of the main shaft 1, and the arc-shaped block of the second support plate 24 partially rotates out of the second arc-shaped groove 12 of the main shaft 1. One part of the first support plate body 231 rotates out of the inner-side space 10, and one part of the second support plate body 241 rotates out of the inner-side space 10.

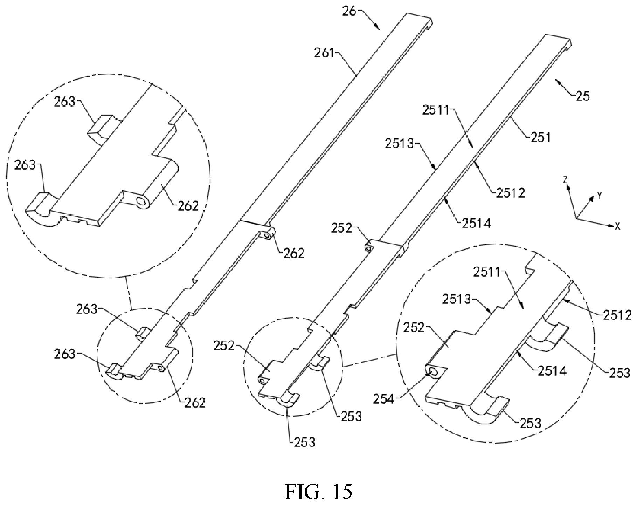

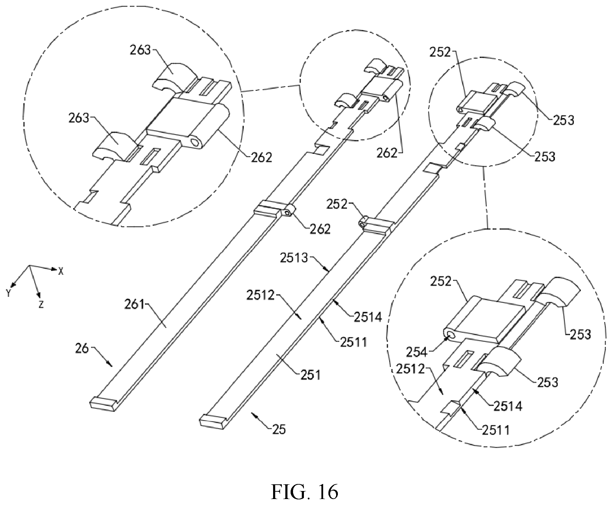

FIG. 15 is a diagram of structures of the third support plate 25 and the fourth support plate 26 shown in FIG. 9 according to an implementation. FIG. 16 is a diagram of structures of the third support plate 25 and the fourth support plate 26 shown in FIG. 9 from another angle.

As shown in FIG. 15 and FIG. 16, for example, the third support plate 25 includes a third support plate body 251, a rotating shaft block 252, and an arc-shaped block 253. It may be understood that the third support plate 25 may be an integrally formed mechanical part, to have high structural strength. It may be understood that FIG. 15, FIG. 16, and related accompanying drawings in the following descriptions schematically show only some components included in the third support plate 25, and actual shapes, actual sizes, actual positions, and actual structures of these components are not limited by FIG. 15, FIG. 16, and the accompanying drawings in the following descriptions. In addition, when the third support plate 25 is in some other forms, the first support plate 23 may alternatively not include the rotating shaft block 252 and/or the arc-shaped block 253.

It may be understood that a quantity of rotating shaft blocks 252 of the third support plate 25 and a quantity of arc-shaped blocks 253 of the third support plate 25 are both not limited to the two shown in FIG. 15 and FIG. 16. In another implementation, the quantity of rotating shaft blocks 252 of the third support plate 25 and the quantity of arc-shaped blocks 253 of the third support plate 25 are not specifically limited.

As shown in FIG. 15 and FIG. 16, for example, the third support plate body 251 includes a top surface 2511 and a bottom surface 2512 that are disposed facing away from each other, and a first side surface 2513 and a second side surface 2514 that are disposed facing away from each other. The top surface 2511 and the bottom surface 2512 of the third support plate body 251 are connected between the first side surface 2513 and the second side surface 2514 of the third support plate body 251. In another implementation, the third support plate body 251 may alternatively use another form. For example, the third support plate body 251 does not include the first side surface 2513 and the second side surface 2514. In this case, the top surface 2511 and the bottom surface 2512 of the third support plate body 251 are connected to each other.

As shown in FIG. 15 and FIG. 16, the rotating shaft block 252 of the third support plate 25 is provided with a rotating shaft hole 254. The rotating shaft block 252 of the third support plate 25 protrudes from the third support plate body 251. The rotating shaft block 252 of the third support plate 25 protrudes from one side of the third support plate body 251. For example, the rotating shaft block 252 of the third support plate 25 protrudes from the first side surface 2513 of the third support plate body 251. In another implementation, the rotating shaft block 252 of the third support plate 25 protrudes from the bottom surface 2512 of the third support plate body 251, and protrudes from the first side surface 2513 of the third support plate body 251. This implementation is not specifically limited herein.

For example, the rotating shaft block 252 of the third support plate 25 may be semicylindrical, that is, one part of an outer surface of the rotating shaft block 252 of the third support plate 25 is an arc surface, and one part is a plane.

As shown in FIG. 15 and FIG. 16, for example, the arc-shaped block 253 of the third support plate 25 protrudes from the third support plate body 251. The arc-shaped block 253 of the third support plate 25 protrudes relative to one side, of the third support plate body 251, away from the rotating shaft block 252 of the third support plate 25. For example, the arc-shaped block 253 of the third support plate 25 protrudes from the bottom surface 2512 of the third support plate body 251, and protrudes relative to the second side surface 2514 of the third support plate body 251. In another implementation, the arc-shaped block 253 of the third support plate 25 protrudes from the second side surface 2514 of the third support plate body 251. This implementation is not specifically limited herein.

It may be understood that the fourth support plate 26 and the third support plate 25 may be of same or similar structures, symmetric or partially symmetric structures, or different structures. In this implementation, the fourth support plate 26 and the third support plate 25 are of symmetric structures. For a basic design of a component structure of the fourth support plate 26, a design of a connection relationship between components, and a design of a connection relationship between a component and a structure other than the assembly, refer to a related solution of the third support plate 25. For example, the fourth support plate 26 includes a fourth support plate body 261, a rotating shaft block 262, and an arc-shaped block 263. In addition, the fourth support plate 26 and the third support plate 25 are allowed to be slightly different in a detailed structure or a position arrangement of the components. Details are not described herein again.

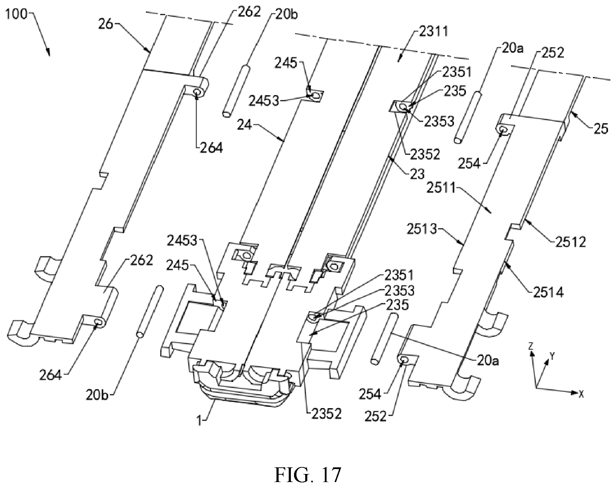

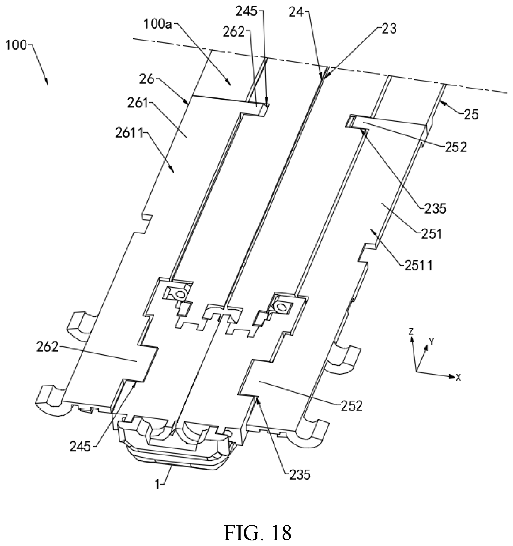

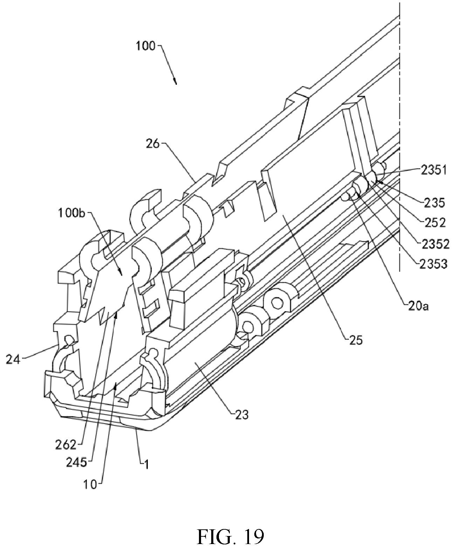

FIG. 17 is a second partial exploded diagram of the foldable mechanism 100 shown in FIG. 6 according to an implementation. FIG. 18 is a second diagram of a partial structure of the foldable mechanism 100 shown in FIG. 6 according to an implementation. FIG. 19 is a diagram of a structure of a part of the foldable mechanism 100 shown in FIG. 18 in the folded state.

Refer to FIG. 17 to FIG. 19. With reference to FIG. 10, FIG. 11, FIG. 15, and FIG. 16, the third support plate 25 is rotatably connected to the first support plate 23.

For example, the rotating shaft block 252 of the third support plate 25 may be located in the first rotating space 235 of the first support plate 23. The rotating shaft hole 254 of the rotating shaft block 252 of the third support plate 25 may be located between the rotating shaft hole 2353 of the first side wall 2351 of the first rotating space 235 of the first support plate 23 and the rotating shaft hole 2353 of the second side wall 2352 of the first rotating space 235 of the first support plate 23. The rotating shaft hole 254 of the rotating shaft block 252 of the third support plate 25 is provided opposite to both the rotating shaft hole 2353 of the first side wall 2351 of the first rotating space 235 of the first support plate 23 and the rotating shaft hole 2353 of the second side wall 2352 of the first rotating space 235 of the first support plate 23.

In this implementation, there are two rotating shaft blocks 252 of the third support plate 25 and two first rotating spaces 235 of the first support plate 23. The two rotating shaft blocks 252 of the third support plate 25 are disposed, in a one-to-one correspondence, in the two first rotating spaces 235 of the first support plate 23.

For example, the first connecting assembly 2 further includes a first rotating shaft 20a, and the first rotating shaft 20a sequentially passes through the rotating shaft hole 2353 of the first side wall 2351 of the first rotating space 235 of the first support plate 23, the rotating shaft hole 254 of the rotating shaft block 252 of the third support plate 25, and the rotating shaft hole 2353 of the second side wall 2352 of the first rotating space 235 of the first support plate 23. In an implementation, two ends of the first rotating shaft 20a may be respectively fastened to the rotating shaft hole 2353 of the first side wall 2351 of the first rotating space 235 of the first support plate 23 and the rotating shaft hole 2353 of the second side wall 2352 of the first rotating space 235 of the first support plate 23. A middle part of the first rotating shaft 20a may rotate relative to a hole wall of the rotating shaft hole 254 of the rotating shaft block 252 of the third support plate 25.

In another implementation, the third support plate 25 may alternatively be rotatably connected to the first support plate 23 in another rotation manner. For example, the third support plate 25 and the first support plate 23 may form a rotating connection structure through mating of the arc-shaped block and the arc-shaped groove, that is, the third support plate 25 may be rotatably connected to the first support plate 23 through a virtual axis. It may be understood that a structure of the rotating connection through the virtual axis is simple and occupies little space, which helps reduce a thickness of the foldable mechanism 100, so that it is easier to make the foldable mechanism 100 and the electronic device 1000 thinner and lighter.

In another implementation, the rotating connection structure between the third support plate 25 and the first support plate 23 may be entirely connected through a physical axis, or may be entirely connected through a virtual axis, or may be connected through a combination of a physical axis and a virtual axis. This is not strictly limited in this application.

Refer to FIG. 17 to FIG. 19. With reference to FIG. 10, FIG. 11, FIG. 15, and FIG. 16, the fourth support plate 26 is rotatably connected to the second support plate 24. It may be understood that for a connection manner of the fourth support plate 26 and the second support plate 24, refer to a connection manner of the third support plate 25 and the first support plate 23. For example, the fourth support plate 26 may be rotatably connected to the second support plate 24 through a second rotating shaft 20b. The rotating shaft block 262 of the fourth support plate 26 may be located in the first rotating space 245 of the second support plate 24. The second rotating shaft 20b may be disposed in a rotating shaft hole 264 of the rotating shaft block 262 of the fourth support plate 26 and a rotating shaft hole 2453 of the first rotating space 245 of the second support plate 24. Details are not described herein again.

Refer to FIG. 17 and FIG. 18, when the foldable mechanism 100 is in the unfolded state, the third support plate 25, the first support plate 23, the second support plate 24, and the fourth support plate 26 are sequentially joined and together form the support surface 100a. In this case, the first support plate 23 and the second support plate 24 are close to each other, and a distance between the first support plate 23 and the second support plate 24 is small. The first support plate 23 and the third support plate 25 are close to each other, and a distance between the first support plate 23 and the third support plate 25 is small. The second support plate 24 and the fourth support plate 26 are close to each other, and a distance between the second support plate 24 and the fourth support plate 26 is small. It may be understood that for explanations of splicing the first support plate 23 and the third support plate 25 and explanations of splicing the second support plate 24 and the fourth support plate 26, refer to explanations of splicing the first support plate 23 and the second support plate 24. Details are not described herein again. It may be understood that the top surface 2511 of the third support plate body 251 faces away from the main shaft 1. The top surface 2611 of the fourth support plate body 261 faces away from the main shaft 1.

In an implementation, as shown in FIG. 17 and FIG. 18, when the foldable mechanism 100 is in the unfolded state, the first support plate 23, the second support plate 24, the third support plate 25, and the fourth support plate 26 are flush. In other words, when the foldable mechanism 100 is in the unfolded state, the first support plate 23, the second support plate 24, the third support plate 25, and the fourth support plate 26 are configured to make the flexible screen 200 present in an unfolded form. In this case, the first support plate 23, the second support plate 24, the third support plate 25, and the fourth support plate 26 can provide smooth and strong support for the flexible screen 200, to improve user experience such as a touch operation and image viewing.

As shown in FIG. 19, for example, when the foldable mechanism 100 is in the folded state, the first support plate 23, the second support plate 24, the third support plate 25, and the fourth support plate 26 are all located on one side of the main shaft 1, the first support plate 23 and the second support plate 24 are disposed opposite to each other, the third support plate 25 and the fourth support plate 26 are also disposed opposite to each other, and the first support plate 23, the second support plate 24, the third support plate 25, the fourth support plate 26, and the main shaft 1 enclose at least a part of the accommodating space 100b.

For example, when the foldable mechanism 100 is in the folded state, a part of the first support plate 23 is located in the inner-side space 10 of the main shaft 1, and a part of the second support plate 24 is located in the inner-side space 10. In this case, a part of space, in the inner-side space 10 of the main shaft 1, located between the first support plate 23 and the second support plate 24 is released, to form a part of the accommodating space 100b, thereby improving space utilization. In this way, components of the electronic device 1000 are arranged more compactly, thereby facilitating miniaturization of the electronic device 1000.

As shown in FIG. 19, for example, when the foldable mechanism 100 is in the folded state, the third support plate 25 and the fourth support plate 26 are also disposed obliquely relative to the main shaft 1, and the third support plate 25 and the fourth support plate 26 are close to each other in a direction away from the main shaft 1. An included angle is formed between the third support plate 25 and the fourth support plate 26, and the third support plate 25 and the fourth support plate 26 may be approximately inverted V-shaped. In this way, under an action of the first support plate 23, the second support plate 24, the third support plate 25, and the fourth support plate 26, the second display area 202 of the flexible screen 200 can be closer to each other to a closed state, to be bent into a water droplet shape.

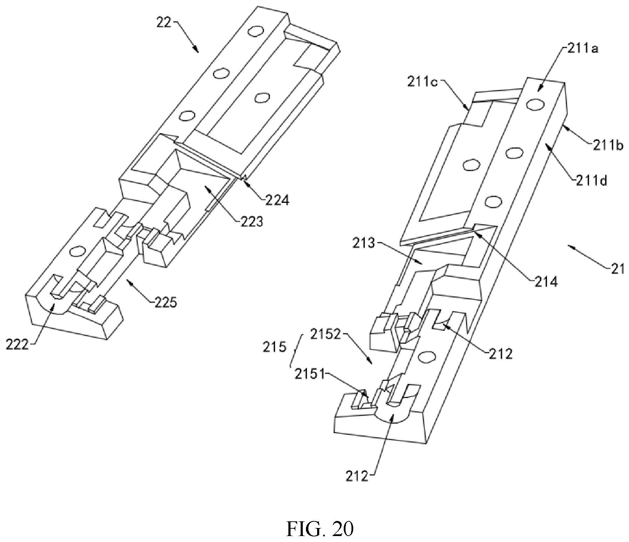

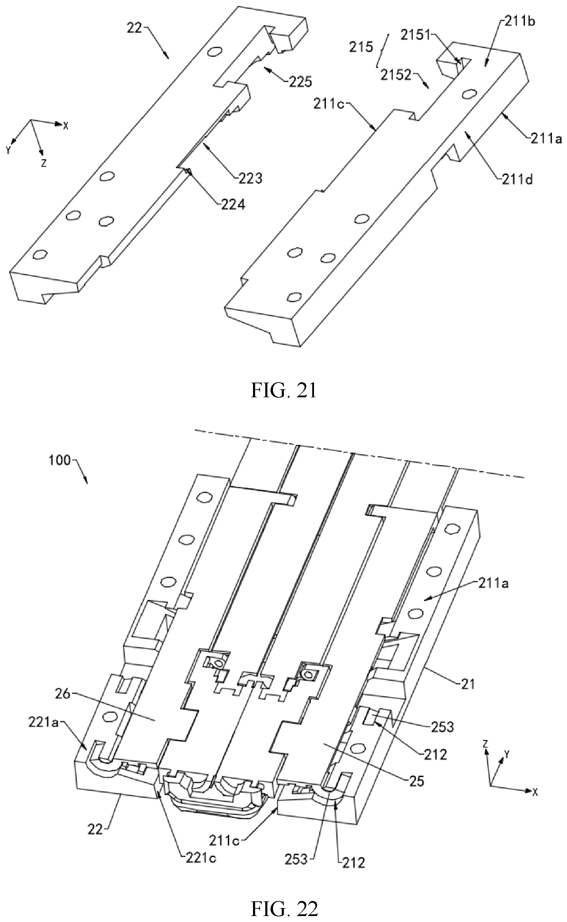

FIG. 20 is a diagram of structures of the first mounting bracket 21 and the second mounting bracket 22 shown in FIG. 9 according to an implementation. FIG. 21 is a diagram of structures of the first mounting bracket 21 and the second mounting bracket 22 shown in FIG. 9 from another angle.

As shown in FIG. 20 and FIG. 21, the first mounting bracket 21 includes a top surface 211a, a bottom surface 211b, a first side surface 211c, and a second side surface 211d. The top surface 211a and the bottom surface 211b of the first mounting bracket 21 are disposed opposite to each other. The first side surface 211c and the second side surface 211d of the first mounting bracket 21 are disposed opposite to each other. The first side surface 211c and the second side surface 211d of the first mounting bracket 21 are located between the top surface 211a and the bottom surface 211b of the first mounting bracket 21. At least a part of the top surface 211a of the first mounting bracket 21 is disposed obliquely relative to the bottom surface 211b of the first mounting bracket 21, that is, an included angle is formed between the top surface 211a of the first mounting bracket 21 and the bottom surface 211b of the first mounting bracket 21. The top surface 211a of the first mounting bracket 21 and the bottom surface 211b of the first mounting bracket 21 are close to each other in a direction close to the first side surface 211c of the first mounting bracket 21.

As shown in FIG. 20 and FIG. 21, for example, the first mounting bracket 21 is provided with an arc-shaped groove 212. There may be one or more arc-shaped grooves 212. When there are a plurality of arc-shaped grooves 212, the plurality of arc-shaped grooves 212 may be spaced apart in the Y-axis direction.

For example, the arc-shaped groove 212 of the first mounting bracket 21 may form an opening on the top surface 211a of the first mounting bracket 21.

As shown in FIG. 20 and FIG. 21, for example, the first mounting bracket 21 is further provided with a first movement space 213. For example, the first movement space 213 of the first mounting bracket 21 and the arc-shaped groove 212 of the first mounting bracket 21 may be spaced apart.

For example, the first movement space 213 of the first mounting bracket 21 may form openings on the top surface 211a and the first side surface 211c of the first mounting bracket 21. The first movement space 213 of the first mounting bracket 21 may be of a groove structure. In another implementation, the first movement space 213 of the first mounting bracket 21 may further form an opening on the bottom surface 211b of the first mounting bracket 21. The first movement space 213 of the first mounting bracket 21 is of a through-hole structure.

As shown in FIG. 20 and FIG. 21, for example, one side wall of the first movement space 213 of the first mounting bracket 21 is provided with a first sliding slot 214.

For example, in a direction in which the second side surface 211d of the first mounting bracket 21 faces the first side surface 211c of the first mounting bracket 21, an extension direction of the first sliding slot 214 of the first movement space 213 and the bottom surface 211b of the first mounting bracket 21 are close to each other. It may be understood that an inclined design of the first sliding slot 214 of the first movement space 213 helps reduce a thickness of the foldable mechanism 100 and optimize the structure of the mechanism. In some other embodiments, a manner of providing the first sliding slot 214 of the first movement space 213 is not strictly limited in this application.

In another implementation, another side wall of the first movement space 213 of the first mounting bracket 21 is also provided with a first sliding slot 214. Specifically, this is not limited in this implementation.

As shown in FIG. 20 and FIG. 21, for example, the first mounting bracket 21 is further provided with a second sliding slot 215. The second sliding slot 215 of the first mounting bracket 21 may form openings on the top surface 211a and the bottom surface 211b of the first mounting bracket 21. The second sliding slot 215 of the first mounting bracket 21 may be located on one side of the first movement space 213 of the first mounting bracket 21.

For example, the second sliding slot 215 of the first mounting bracket 21 may be disposed obliquely relative to the first side surface 211c of the first mounting bracket 21, that is, an included angle is formed between an extension direction of the second sliding slot 215 of the first mounting bracket 21 and the first side surface 211c of the first mounting bracket 21. The second sliding slot 215 of the first mounting bracket 21 may also be disposed obliquely relative to the second side surface 211d of the first mounting bracket 21, that is, an included angle is formed between the extension direction of the second sliding slot 215 of the first mounting bracket 21 and the second side surface 211d of the first mounting bracket 21. In a direction in which the bottom surface 211b of the first mounting bracket 21 faces the top surface 211a of the first mounting bracket 21, the extension direction of the second sliding slot 215 of the first mounting bracket 21 and the first side surface 211c of the first mounting bracket 21 are close to each other. In other words, in comparison with the opening formed by the second sliding slot 215 of the first mounting bracket 21 on the bottom surface 211b of the first mounting bracket 21, the opening formed by the second sliding slot 215 of the first mounting bracket 21 on the top surface 211a of the first mounting bracket 21 is closer to the first side surface 211c of the first mounting bracket 21.

As shown in FIG. 20 and FIG. 21, for example, the second sliding slot 215 of the first mounting bracket 21 includes a first sub-slot 2151 and a second sub-slot 2152. The second sub-slot 2152 communicates with the first sub-slot 2151. In the Y-axis direction, a length of the first sub-slot 2151 is greater than a length of the second sub-slot 2152.

It may be understood that the second mounting bracket 22 and the first mounting bracket 21 may be of same or similar structures, symmetric or partially symmetric structures, or different structures. In this implementation, the second mounting bracket 22 and the first mounting bracket 21 are of symmetric structures. For a basic design of a component structure of the second mounting bracket 22, a design of a connection relationship between components, and a design of a connection relationship between a component and a structure other than the assembly, refer to a related solution of the first mounting bracket 21. For example, the second mounting bracket 22 is also provided with an arc-shaped groove 222, a first movement space 223, a first sliding slot 224, and a second sliding slot 225. In addition, the second mounting bracket 22 and the first mounting bracket 21 are allowed to be slightly different in a detailed structure or a position arrangement of the components. Details are not described herein again.

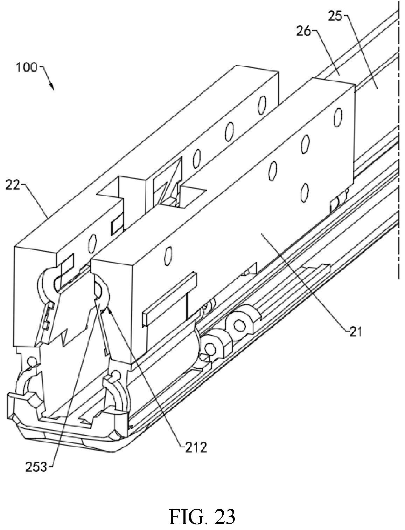

FIG. 22 is a third diagram of a partial structure of the foldable mechanism 100 shown in FIG. 6 according to an implementation. FIG. 23 is a diagram of a structure of a part of the foldable mechanism 100 shown in FIG. 22 in the folded state.

Refer to FIG. 22 and FIG. 23. With reference to FIG. 15, FIG. 16, FIG. 20, and FIG. 21, the third support plate 25 is rotatably connected to the first mounting bracket 21.

For example, the arc-shaped block 253 of the third support plate 25 is disposed in the arc-shaped groove 212 of the first mounting bracket 21. Through relative motion between the arc-shaped block and the arc-shaped groove, the third support plate 25 and the first mounting bracket 21 form a rotating connection structure through mating of the arc-shaped block and the arc-shaped groove, that is, the third support plate 25 may be rotatably connected to the first mounting bracket 21 through a virtual axis.

It may be understood that when there are two arc-shaped blocks 253 of the third support plate 25 and two arc-shaped grooves 212 of the first mounting bracket 21, the two arc-shaped blocks 253 of the third support plate 25 are disposed, in a one-to-one correspondence, in the two arc-shaped grooves 212 of the first mounting bracket 21.

In another implementation, another structure may alternatively be used for disposition, so that the third support plate 25 is rotatably connected to the first mounting bracket 21 through the virtual axis. This is not specifically limited in this application.

In another implementation, the third support plate 25 may alternatively be rotatably connected to the first mounting bracket 21 through a physical axis. A connection relationship between a second rotating part of the third support plate 25 and the first mounting bracket 21 is reliable, a rotary backlash is small, and a rotation action is accurate and stable.

In another implementation, the rotating connection structure between the third support plate 25 and the first mounting bracket 21 may be entirely connected through a physical axis, or may be entirely connected through a virtual axis, or may be connected through a combination of a physical axis and a virtual axis. This is not strictly limited in this application.

Refer to FIG. 22 and FIG. 23. With reference to FIG. 15, FIG. 16, FIG. 20, and FIG. 21, the fourth support plate 26 is rotatably connected to the second mounting bracket 22. It may be understood that for a connection manner of the fourth support plate 26 and the second mounting bracket 22, refer to a connection manner of the third support plate 25 and the first mounting bracket 21. Details are not described herein again.

As shown in FIG. 22, in an implementation, when the foldable mechanism 100 is in the unfolded state, the third support plate 25 covers a part of the first mounting bracket 21, and the fourth support plate 26 covers a part of the second mounting bracket 22. It may be understood that the top surface 211a of the first mounting bracket 21 faces the third support plate 25, the first side surface 211c of the first mounting bracket 21 faces the main shaft 1, the top surface 221a of the second mounting bracket 22 faces the fourth support plate 26, and the first side surface 221c of the second mounting bracket 22 faces the main shaft 1.

As shown in FIG. 23, in an implementation, when the foldable mechanism 100 is in the folded state, the first mounting bracket 21 is located on one side, of the third support plate 25, away from the fourth support plate 26, the second mounting bracket 22 is located on one side, of the fourth support plate 26, away from the third support plate 25, and the first mounting bracket 21 and the second mounting bracket 22 are close to each other.

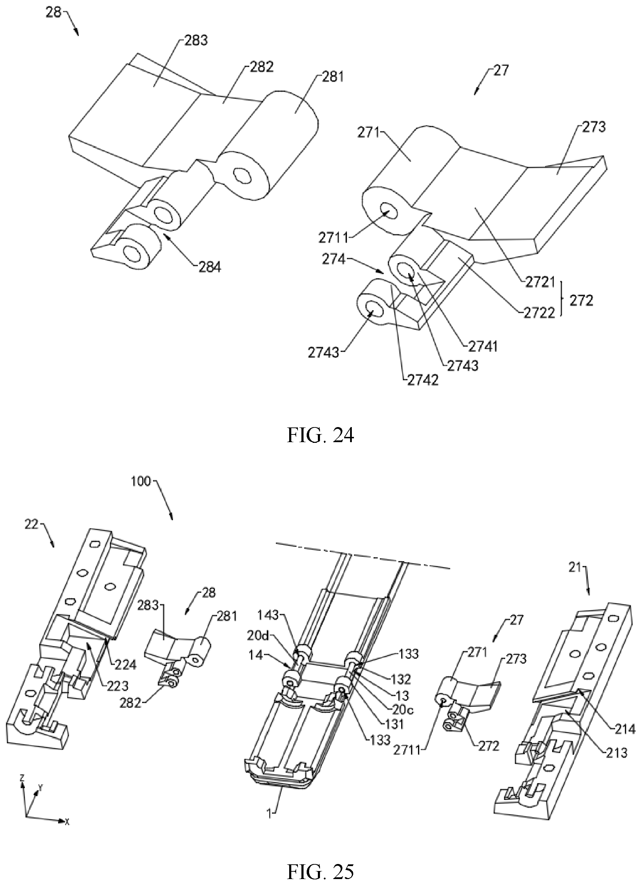

FIG. 24 is a diagram of structures of the first connecting piece 27 and the second connecting piece 28 shown in FIG. 9 according to an implementation.

As shown in FIG. 24, the first connecting piece 27 includes a rotating end 271, a connecting section 272, and a sliding end 273 that are sequentially connected. The connecting section 272 of the first connecting piece 27 is connected between the rotating end 271 and the sliding end 273 of the first connecting piece 27. The first connecting piece 27 may be an integrally formed mechanical part, to have high structural strength. In another implementation, the first connecting piece 27 may not include the connecting section 272.

For example, the rotating end 271 of the first connecting piece 27 is provided with a rotating shaft hole 2711. The rotating end 271 of the first connecting piece 27 may be cylindrical. In another implementation, the rotating end 271 of the first connecting piece 27 may alternatively use another structure.

For example, the sliding end 273 of the first connecting piece 27 may be approximately sliding-block-shaped. In another implementation, the sliding end 273 of the first connecting piece 27 may alternatively use another structure.

For example, the connecting section 272 of the first connecting piece 27 includes a first part 2721 and a second part 2722. The first part 2721 is connected to the rotating end 271 of the first connecting piece 27 and the sliding end 273 of the first connecting piece 27. The second part 2722 protrudes from one side of the rotating end 271 of the first connecting piece 27. It may be understood that FIG. 2 shows only that the second part 2722 protrudes from the rotating end 271 of the first connecting piece 27 in a negative direction of a Y-axis. In another implementation, the second part 2722 may alternatively protrude from the rotating end 271 of the first connecting piece 27 in another direction. For example, the second part 2722 protrudes from the rotating end 271 of the first connecting piece 27 in a negative direction of a Z-axis.

For example, the second part 2722 of the connecting section 272 of the first connecting piece 27 is provided with a rotating space 274. The rotating space 274 of the first connecting piece 27 includes a first side wall 2741 and a second side wall 2742 that are disposed opposite to each other. The first side wall 2741 and the second side wall 2742 of the rotating space 274 of the first connecting piece 27 each are provided with a rotating shaft hole 2743. The rotating shaft hole 2743 of the second side wall 2742 of the rotating space 274 of the first connecting piece 27 and the rotating shaft hole 2743 of the first side wall 2741 of the rotating space 274 of the first connecting piece 27 are provided opposite to each other. In another implementation, when the connecting section 272 of the first connecting piece 27 uses another structure, the rotating space 274 of the first connecting piece 27 may alternatively be provided at another position of the connecting section 272 of the first connecting piece 27.

It may be understood that the second connecting piece 28 and the first connecting piece 27 may be of same or similar structures, symmetric or partially symmetric structures, or different structures. In this implementation, the second connecting piece 28 and the first connecting piece 27 are of symmetric structures. For a basic design of a component structure of the second connecting piece 28, a design of a connection relationship between components, and a design of a connection relationship between a component and a structure other than the assembly, refer to a related solution of the first connecting piece 27. For example, the second connecting piece 28 includes a rotating end 281, a connecting section 282, and a sliding end 283. The connecting section 282 of the second connecting piece 28 is provided with a rotating space 284 and the like. In addition, the second connecting piece 28 and the first connecting piece 27 are allowed to be slightly different in a detailed structure or a position arrangement of the components. Details are not described herein again.

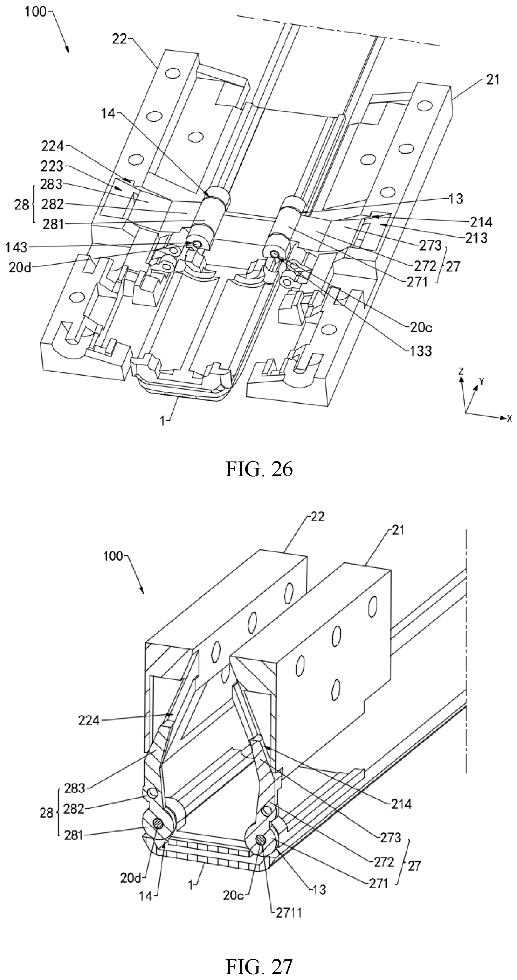

FIG. 25 is a third partial exploded diagram of the foldable mechanism 100 shown in FIG. 6 according to an implementation. FIG. 26 is a fourth diagram of a partial structure of the foldable mechanism 100 shown in FIG. 6 according to an implementation. FIG. 27 is a partial sectional view of a part of the foldable mechanism 100 shown in FIG. 26 in the folded state.

Refer to FIG. 25 to FIG. 27. With reference to FIG. 8 and FIG. 24, the rotating end 271 of the first connecting piece 27 is rotatably connected to the main shaft 1.

For example, the rotating end 271 of the first connecting piece 27 may be located in the first rotating space 13 of the main shaft 1. The rotating shaft hole 2711 of the rotating end 271 of the first connecting piece 27 may be located between the rotating shaft hole 133 of the first side wall 131 of the first rotating space 13 of the main shaft 1 and the rotating shaft hole 133 of the second side wall 132 of the first rotating space 13 of the main shaft 1. The rotating shaft hole 2711 of the rotating end 271 of the first connecting piece 27 is provided opposite to both the rotating shaft hole 133 of the first side wall 131 of the first rotating space 13 of the main shaft 1 and the rotating shaft hole 133 of the second side wall 132 of the first rotating space 13 of the main shaft 1.

For example, the first connecting assembly 2 further includes a third rotating shaft 20c. The third rotating shaft 20c sequentially passes through the rotating shaft hole 133 of the first side wall 131 of the first rotating space 13 of the main shaft 1, the rotating shaft hole 2711 of the rotating end 271 of the first connecting piece 27, and the rotating shaft hole 133 of the second side wall 132 of the first rotating space 13 of the main shaft 1. In an implementation, two ends of the third rotating shaft 20c may be respectively fastened to the rotating shaft hole 133 of the first side wall 131 of the first rotating space 13 of the main shaft 1 and the rotating shaft hole 133 of the second side wall 132 of the first rotating space 13 of the main shaft 1. A middle part of the third rotating shaft 20c may rotate relative to a hole wall of the rotating shaft hole 2711 of the rotating end 271 of the first connecting piece 27.

In another implementation, the rotating end 271 of the first connecting piece 27 may alternatively be rotatably connected to the main shaft 1 in another rotation manner. For example, the rotating end 271 of the first connecting piece 27 and the main shaft 1 may form a rotating connection structure through mating of the arc-shaped block and the arc-shaped groove, that is, the rotating end 271 of the first connecting piece 27 may be rotatably connected to the main shaft 1 through a virtual axis. It may be understood that a structure of the rotating connection through the virtual axis is simple and occupies little space, which helps reduce a thickness of the foldable mechanism 100, so that it is easier to make the foldable mechanism 100 and the electronic device 1000 thinner and lighter.

Refer to FIG. 25 to FIG. 27. With reference to FIG. 8 and FIG. 24, the rotating end 281 of the second connecting piece 28 is rotatably connected to the main shaft 1. It may be understood that for a connection manner of the rotating end 281 of the second connecting piece 28 and the main shaft 1, refer to a connection manner of the rotating end 271 of the first connecting piece 27 and the main shaft 1. For example, the rotating end 281 of the second connecting piece 28 is rotatably connected to the main shaft 1 through a fourth rotating shaft 20d. Details are not described herein again.

Refer to FIG. 25 to FIG. 27. With reference to FIG. 20, FIG. 21, and FIG. 24, the sliding end 273 of the first connecting piece 27 is slidably connected to the first mounting bracket 21.

For example, a part of the sliding end 273 of the first connecting piece 27 is located in the first movement space 213 of the first mounting bracket 21, and a part is located in the first sliding slot 214 of the first movement space 213 of the first mounting bracket 21. It may be understood that the sliding end 273 of the first connecting piece 27 may slide in the first movement space 213 of the first mounting bracket 21 and the first sliding slot 214 of the first movement space 213.

In another implementation, the sliding end 273 of the first connecting piece 27 may alternatively be slidably connected to the first mounting bracket 21 in another sliding manner.

Refer to FIG. 25 to FIG. 27. With reference to FIG. 20, FIG. 21, and FIG. 24, the sliding end 283 of the second connecting piece 28 is slidably connected to the second mounting bracket 22. It may be understood that, for a connection manner of the sliding end 283 of the second connecting piece 28 and the second mounting bracket 22, refer to a connection manner of the sliding end 273 of the first connecting piece 27 and the first mounting bracket 21. For example, a part of the sliding end 283 of the second connecting piece 28 slides in the first movement space 223 of the second mounting bracket 22, and a part slides in the first sliding slot 224 in the first movement space 223 of the second mounting bracket 22. Details are not described herein again.

As shown in FIG. 26, for example, when the foldable mechanism 100 is in the unfolded state, a large part of the sliding end 273 of the first connecting piece 27 slides into the first movement space 213 and the first sliding slot 214 of the first mounting bracket 21, and a large part of the sliding end 283 of the second connecting piece 28 slides into the first movement space 223 and the first sliding slot 224 of the second mounting bracket 22.

In a process in which the foldable mechanism 100 is switched from the unfolded state to the folded state, the sliding end 273 of the first connecting piece 27 slides in a direction away from the first mounting bracket 21 relative to the first mounting bracket 21, and the sliding end 283 of the second connecting piece 28 slides in a direction away from the second mounting bracket 22 relative to the second mounting bracket 22.

As shown in FIG. 26, for example, when the foldable mechanism 100 is in the folded state, a part of the sliding end 273 of the first connecting piece 27 slides out of the first movement space 213 and the first sliding slot 214 of the first mounting bracket 21, and a part of the sliding end 283 of the second connecting piece 28 slides out of the first movement space 223 and the first sliding slot 224 of the second mounting bracket 22.

In an implementation, the foldable mechanism 100 further includes a synchronization component (not shown in the figure). A part of the synchronization component is movablely connected to the first connecting piece 27, and a part is movablely connected to the second connecting piece 28. The synchronization component may enable the first connecting piece 27 and the second connecting piece 28 to synchronously rotate in a motion process of the foldable mechanism 100. For example, the synchronization component may be a gear assembly. Specifically, this is not limited in this implementation.

In an implementation, the foldable mechanism 100 further includes a damping component (not shown in the figure). The damping component may be disposed on the main shaft 1. The damping component may apply a damping force to the first connecting piece 27 and the second connecting piece 28, to provide specific resistance in a process in which the foldable mechanism 100 is unfolded to enter the unfolded state and in a process in which the foldable mechanism 100 is folded to end the unfolded state, so that the user can experience a good sense of operation of the mechanism. The damping component may be a cam structure or the like. Specifically, this is not limited in this implementation.

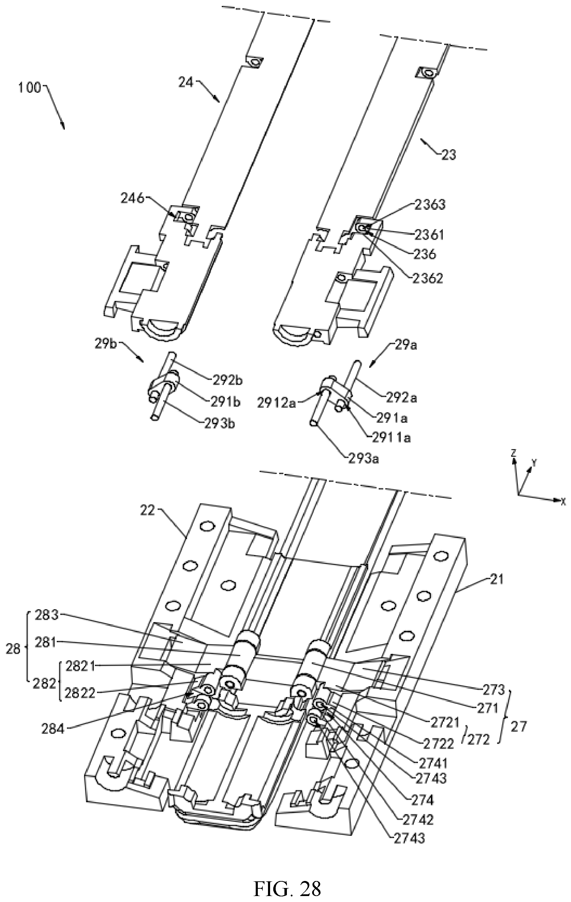

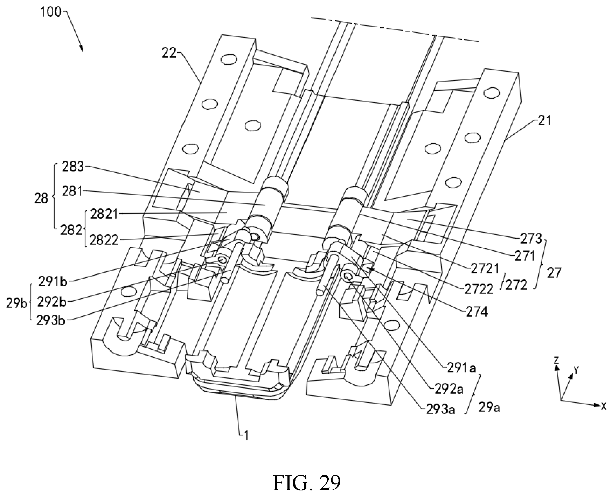

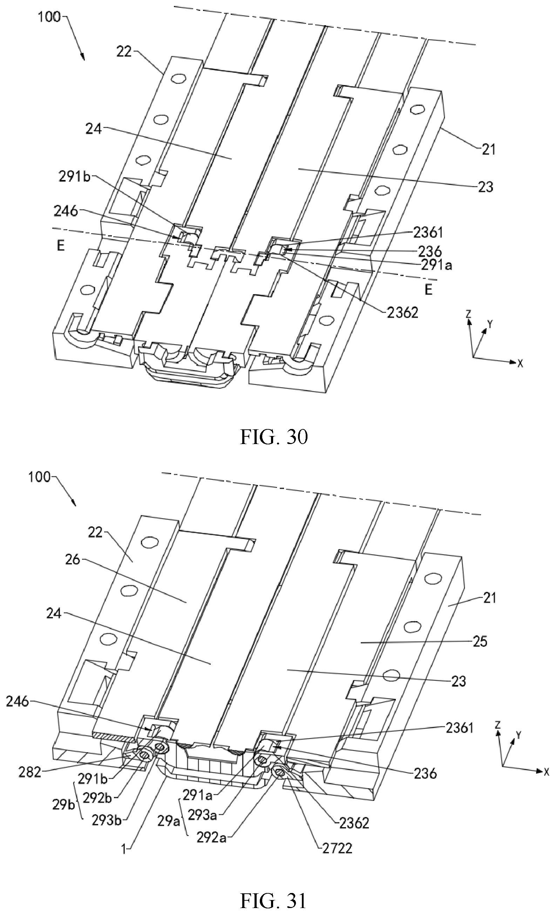

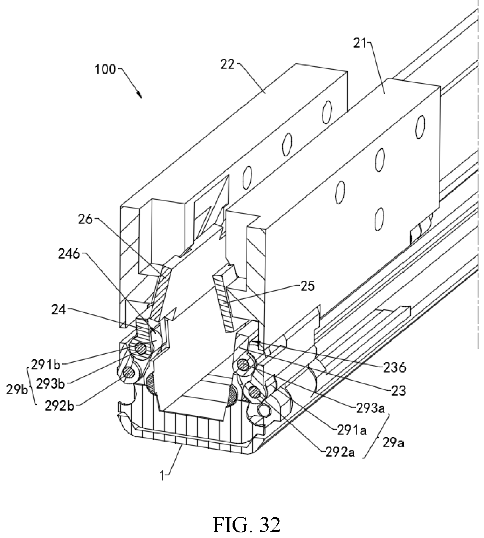

FIG. 28 is a fourth partial exploded diagram of the foldable mechanism 100 shown in FIG. 6 according to an implementation. FIG. 29 is a fifth diagram of a partial structure of the foldable mechanism 100 shown in FIG. 6 according to an implementation. FIG. 30 is a sixth diagram of a partial structure of the foldable mechanism 100 shown in FIG. 6 according to an implementation. FIG. 31 is a partial sectional view of a part of the foldable mechanism 100 shown in FIG. 30 taken along an E-E line according to an implementation. FIG. 32 is a sectional view of a part of the foldable mechanism 100 shown in FIG. 30 in the folded state.

As shown in FIG. 28 to FIG. 32, for example, the first revolute pair 29a includes a bracket 291a, a first pin shaft 292a, and a second pin shaft 293a.

For example, the bracket 291a is provided with a first pin shaft hole 2911a and a second pin shaft hole 2912a that are spaced apart. The first pin shaft 292a may pass through the first pin shaft hole 2911a of the bracket 291a. The second pin shaft 293a may pass through the second pin shaft hole 2912a of the bracket 291a. The bracket 291a is rotatably connected to the first pin shaft 292a and the second pin shaft 293a. In other words, the bracket 291a may rotate relative to the first pin shaft 292a and the second pin shaft 293a.

For example, the holder 291a may be approximately dumbbell-shaped.

As shown in FIG. 28 to FIG. 32, for example, the first support plate 23 is movably connected to the first connecting piece 27 through the first revolute pair 29a. In an implementation, the first support plate 23 is movably connected to the connecting section 272 of the first connecting piece 27 through the first revolute pair 29a.

In another implementation, a connection manner of the first support plate 23 and the first connecting piece 27 is not specifically limited.

As shown in FIG. 28 to FIG. 32, a part of the bracket 291a is located in the rotating space 274 of the connecting section 272 of the first connecting piece 27. The first pin shaft hole 2911a of the bracket 291a is located between the rotating shaft hole 2743 of the first side wall 2741 of the rotating space 274 of the first connecting piece 27 and the rotating shaft hole 2743 of the second side wall 2742 of the rotating space 274 of the first connecting piece 27. The first pin shaft hole 2911a of the bracket 291a is provided opposite to both the rotating shaft hole 2743 of the first side wall 2741 of the rotating space 274 of the first connecting piece 27 and the rotating shaft hole 2743 of the second side wall 2742 of the rotating space 274 of the first connecting piece 27.

For example, the first pin shaft 292a sequentially passes through the rotating shaft hole 2743 of the first side wall 2741 of the rotating space 274 of the first connecting piece 27, the first pin shaft hole 2911a of the bracket 291a, and the rotating shaft hole 2743 of the second side wall 2742 of the rotating space 274 of the first connecting piece 27. In an implementation, both the first connecting piece 27 and the bracket 291a may rotate relative to the first pin shaft 292a.

As shown in FIG. 28 to FIG. 32, a part of the bracket 291a is located in the second rotating space 236 of the first support plate 23. The second pin shaft hole 2912a of the bracket 291a is located between the rotating shaft hole 2363 of the first side wall 2361 of the second rotating space 236 of the first support plate 23 and the rotating shaft hole 2363 of the second side wall 2362 of the second rotating space 236 of the first support plate 23. The second pin shaft hole 2912a of the bracket 291a is provided opposite to both the rotating shaft hole 2363 of the first side wall 2361 of the second rotating space 236 of the first support plate 23 and the rotating shaft hole 2363 of the second side wall 2362 of the second rotating space 236 of the first support plate 23.

For example, the second pin shaft 293a sequentially passes through the rotating shaft hole 2363 of the first side wall 2361 of the second rotating space 236 of the first support plate 23, the second pin shaft hole 2912a of the bracket 291a, and the rotating shaft hole 2363 of the second side wall 2362 of the second rotating space 236 of the first support plate 23. In an implementation, both the first support plate 23 and the bracket 291a may rotate relative to the second pin shaft 293a.

As shown in FIG. 28 to FIG. 32, for example, the second support plate 24 is connected to the second connecting piece 28 through the second revolute pair 29b.

It may be understood that for a connection manner of the second support plate 24 and the second revolute pair 29b and a connection manner of the second revolute pair 29b and the second connecting piece 28, refer to a connection manner of the first support plate 23 and the first revolute pair 29a and a connection manner of the first revolute pair 29a and the first connecting piece 27. Details are not described herein again. In addition, the second revolute pair 29b and the first revolute pair 29a may be of same or similar structures, symmetric or partially symmetric structures, or different structures. In this implementation, the second revolute pair 29b and the first revolute pair 29a are of symmetric structures. For a basic design of a component structure of the second revolute pair 29b, a design of a connection relationship between components, and a design of a connection relationship between a component and a structure other than the assembly, refer to a related solution of the first revolute pair 29a. In addition, the second revolute pair 29b and the first revolute pair 29a are allowed to be slightly different in a detail structure or a position arrangement of the components. Details are not described herein again.

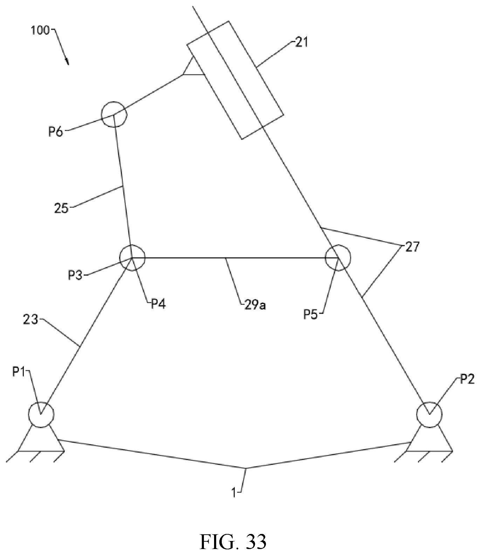

FIG. 33 is a brief diagram of a connection relationship between a partial structure of the first connecting assembly 2 and the main shaft 1 shown in FIG. 7 according to an implementation.

Refer to FIG. 33. With reference to FIG. 8 to FIG. 32, the first support plate 23 is rotatably connected to the main shaft 1, the third support plate 25 is rotatably connected to the first support plate 23, and the third support plate 25 is rotatably connected to the first mounting bracket 21. In addition, the rotating end 271 of the first connecting piece 27 is rotatably connected to the main shaft 1. The sliding end 273 of the first connecting piece 27 is slidably connected to the first mounting bracket 21. In addition, the first support plate 23 is further rotatably connected to the first connecting piece 27 through the first revolute pair 29a. A rotating axis of the first support plate 23 rotatably connected to the main shaft 1 is defined as a first rotating axis P1. A rotating axis of the first connecting piece 27 rotatably connected to the main shaft 1 is a second rotating axis P2. A rotating axis of the first support plate 23 rotatably connected to the first revolute pair 29a is a third rotating axis P3. A rotating axis of the third support plate 25 rotatably connected to the first support plate 23 is a fourth rotating axis P4. A rotating axis of the first connecting piece 27 rotatably connected to the first revolute pair 29a is a fifth rotating axis P5. A rotating axis of the third support plate 25 rotatably connected to the first mounting bracket 21 is a sixth rotating axis P6. It may be understood that in FIG. 33, that two components are connected through a solid line indicates that a connection relationship between the two components is necessary. Connection positions of the two components are schematically indicated by circles, and the connection relationship between the two components is a rotating connection. If a related diagram appears below, refer to related explanations herein.

In this implementation, the third rotating axis P3 and the fourth rotating axis P4 may be aligned on a same straight line, that is, the third rotating axis P3 and the fourth rotating axis P4 are coaxially disposed. In this way, the third support plate 25 may be connected to the first revolute pair 29a through the first support plate 23. It may be understood that in comparison with a solution in which the third support plate 25 is connected to the first revolute pair 29a through the first support plate 23 by disposing another connection structure, in this implementation, the third rotating axis P3 and the fourth rotating axis P4 are coaxially disposed. An assembly manner is simple, and parts can be saved, to simplify the structure. In another implementation, the third rotating axis P3 and the fourth rotating axis P4 may alternatively not be aligned on a same straight line. In this case, the third support plate 25 is connected to the first revolute pair 29a through the first support plate 23 by disposing another connection structure. For example, the third support plate 25 is directly connected to the first revolute pair 29a. Specifically, the following is described with reference to related accompanying drawings.

In this implementation, the foldable mechanism 100 may be a crank-slider connecting rod motion mechanism. A main mechanism motion of the foldable mechanism 100 may include a primary motion and a secondary motion. The primary motion may be a motion manner of a four-connecting rod motion mechanism formed by the main shaft 1, the first support plate 23, the first connecting piece 27, and the first revolute pair 29a. In addition, the secondary motion may be a motion manner of a slider connecting rod motion mechanism formed by the first mounting bracket 21, the third support plate 25, the first support plate 23, and the first revolute pair 29a. The foldable mechanism 100, through the primary motion and the secondary motion, may enable a degree of freedom for the first mounting bracket 21 to move relative to the main shaft 1 to be 1 in a process of unfolding or folding the foldable mechanism 100, so that a motion track of the first mounting bracket 21 relative to the main shaft 1 can be determined. Specifically, in the process of unfolding or folding the foldable mechanism 100, a motion manner of the first support plate 23, the third support plate 25, the first connecting piece 27, and the first revolute pair 29a may constrain a motion track of the first mounting bracket 21, so that the motion track of the first mounting bracket 21 relative to the main shaft 1 can be determined. In this way, in a process of changing the unfolded state of the foldable mechanism 100 to the folded state, the first support plate 23, the third support plate 25, the first connecting piece 27, and the first revolute pair 29a can pull the first mounting bracket back 21 to be close to the main shaft 1. In a process of changing the folded state of the foldable mechanism 100 to the unfolded state, the first support plate 23, the third support plate 25, the first connecting piece 27, and the first revolute pair 29a can push the first mounting bracket 21 away from the main shaft 1.

Similarly, the second support plate 24 is disposed to be rotatably connected to the main shaft 1, the fourth support plate 26 is disposed to be rotatably connected to the second support plate 24, the fourth support plate 26 is disposed to be rotatably connected to the second mounting bracket 22, the rotating end 281 of the second connecting piece 28 is disposed to be rotatably connected to the main shaft 1, and the sliding end 283 of the second connecting piece 28 is disposed to be slidably connected to the second mounting bracket 22, so that the second support plate 24 is further rotatably connected to the second connecting piece 28 through the second revolute pair. In this case, a motion manner of a four-connecting rod motion mechanism formed by the main shaft 1, the second support plate 24, the second connecting piece 28, and the second revolute pair may also form the primary motion of the foldable mechanism 100. A motion manner of a slider connecting rod motion mechanism formed by the second support plate 24, the fourth support plate 26, the second mounting bracket 22, and the second revolute pair 29b may also form the secondary motion of the foldable mechanism 100. In this case, the foldable mechanism 100, through the primary motion and the secondary motion, may enable a degree of freedom for the second mounting bracket 22 to move relative to the main shaft 1 to be 1 in a process of unfolding or folding the foldable mechanism 100, so that a motion track of the second mounting bracket 22 relative to the main shaft 1 can be determined. In this way, in a process of changing the unfolded state of the foldable mechanism 100 to the folded state, the second support plate 24, the fourth support plate 26, the second connecting piece 28, and the second revolute pair can pull the second mounting bracket 22 back to be close to the main shaft 1. In a process of changing the folded state of the foldable mechanism 100 to the unfolded state, the second support plate 24, the fourth support plate 26, the second connecting piece 28, and the second revolute pair can push the second mounting bracket 22 away from the main shaft 1.

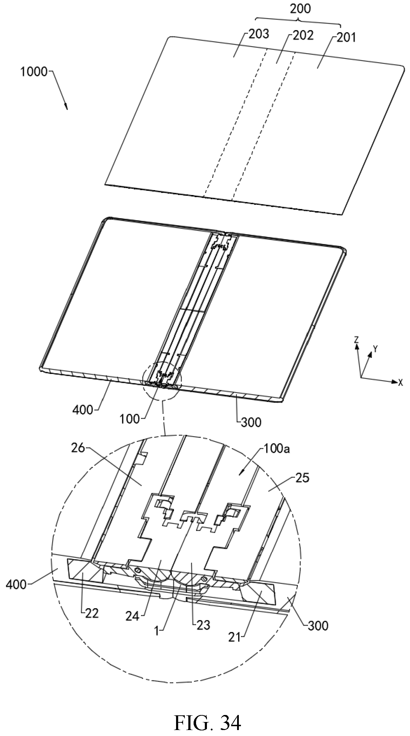

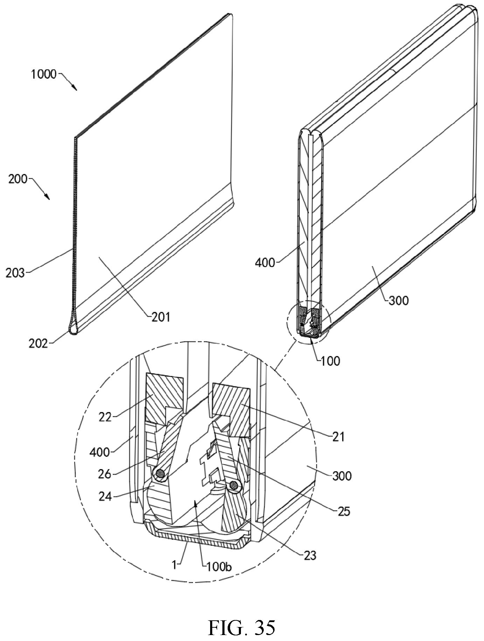

FIG. 34 is a partial sectional view of the electronic device 1000 shown in FIG. 5 at an F-F line according to an implementation. FIG. 35 is a partial sectional view of the electronic device 1000 shown in FIG. 3 at a G-G line according to an implementation.

Refer to FIG. 34 and FIG. 35. With reference to FIG. 8 to FIG. 32, the first mounting bracket 21 may be fastened to the first housing 300. The second mounting bracket 22 may be fastened to the second housing 400. For example, the first mounting bracket 21 may be connected to the first housing 300 by using a fastener. The second mounting bracket 22 may be connected to the second housing 400 by using a fastener. The fastener includes but is not limited to a screw, a bolt, a rivet, a pin, and the like. It may be understood that because the first mounting bracket 21 may be fastened to the first housing 300, the first housing 300 may move with the first mounting bracket 21, and the foldable mechanism 100 may control a motion track of the first housing 300 by controlling a motion track of the first mounting bracket 21. In addition, because the second mounting bracket 22 may be fastened to the second housing 400, the second housing 400 may move with the second mounting bracket 22, and the foldable mechanism 100 may control a motion track of the second housing 400 by controlling a motion track of the second mounting bracket 22.

It may be understood that because the first mounting bracket 21 is fastened to the first housing 300, the first support plate 23, the third support plate 25, the first connecting piece 27, and the first revolute pair 29a can pull the first mounting bracket 21 back to be close to the main shaft 1, and can also push the first mounting bracket 21 away from the main shaft 1, so that the first mounting bracket 21 can pull the first housing 300 back to be close to the main shaft 1, and can also push the first housing 300 away from the main shaft 1, that is, the first mounting bracket 21 can drive the first housing 300 to pull inward and push outward. Similarly, because the second mounting bracket 22 may be fastened to the second housing 400, the second support plate 24, the fourth support plate 26, the second connecting piece 28, and the second revolute pair can pull the second mounting bracket 22 back to be close to the main shaft 1, and can also push the second mounting bracket 22 away from the main shaft 1, so that the second mounting bracket 22 can pull the second housing 400 back to be close to the main shaft 1, and can also push the second housing 400 away from the main shaft 1, that is, the second mounting bracket 22 can drive the second housing 400 to pull inward and push outward.

It may be understood that when the electronic device 1000 is switched from the unfolded state to the folded state, the first housing 300 and the second housing 400 move toward each other, the first housing 300 may drive the first mounting bracket 21 to rotate relative to the main shaft 1 through the first support plate 23, the third support plate 25, the first connecting piece 27, and the first revolute pair 29a, and the second housing 400 may drive the second mounting bracket 22 to rotate relative to the main shaft 1 through the second support plate 24, the fourth support plate 26, the second connecting piece 28, and the second revolute pair. In a process in which the first housing 300 and the second housing 400 are unfolded opposite to each other, the first mounting bracket 21 may drive the first housing 300 to move in a direction away from the main shaft 1, and the second mounting bracket 22 may drive the second housing 400 to move in a direction away from the main shaft 1. That is, the foldable mechanism 100 can implement an inward pulling motion of the housing in a process of changing the unfolded state to the folded state, and an outward pushing motion of the housing in a process of changing the folded state to the unfolded state. Therefore, in a process of unfolding or folding the foldable mechanism 100, a risk of pulling or squeezing the flexible screen 200 can be reduced, thereby protecting the flexible screen 200, improving reliability of the flexible screen 200, and enabling the flexible screen 200 and the electronic device 1000 to have a longer service life.

In this implementation, when the electronic device 1000 is in the unfolded state, the first support plate 23, the second support plate 24, the third support plate 25, and the fourth support plate 26 of the foldable mechanism 100 may together form the support surface 100a, to support the second display area 202 of the flexible screen 200. In this case, the flexible screen 200 is not easily dented under pressing of the user. This not only helps improve a service life and reliability of the flexible screen 200, but also achieves good light and shadow performance of the flexible screen 200. Therefore, the foldable mechanism 100 in this implementation offers strong product competitiveness.

It may be understood that in an implementation, when the electronic device 1000 is in the unfolded state, the first support plate 23, the second support plate 24, and the main shaft 1 together form the support surface, to support the second display area 202 of the flexible screen 200. In this solution, because the main shaft 1 needs to be connected to the first support plate 23 and the second support plate 24 through a plurality of connecting pieces, the main shaft 1 needs to be provided with a plurality of clearance spaces, to avoid the connecting pieces or other components. The clearance space may be a groove or a through hole. As a result, a dent easily appears on a surface, of the main shaft 1, used to form the support surface, that is, flatness of the support surface is poor. In this case, the flexible screen 200 is easily dented under pressing of the user, causing a problem such as a failure of the flexible screen 200. This is not conducive to improving the service life and the reliability of the flexible screen 200. In this implementation, when the electronic device 1000 is in the unfolded state, the first support plate 23, the second support plate 24, the third support plate 25, and the fourth support plate 26 of the foldable mechanism 100 may be together joined into the support surface 100a, to support the second display area 202 of the flexible screen 200. In this case, in this implementation, the main shaft 1 may no longer be used to support the second display area 202 of the flexible screen 200, thereby avoiding a problem such as a failure of the flexible screen 200 caused by poor flatness of the main shaft 1. In other words, when the electronic device 1000 in this implementation is in the unfolded state, the flexible screen 200 has a long service life and high reliability.

In this implementation, because the first support plate 23, the second support plate 24, the third support plate 25, and the fourth support plate 26 have a small quantity of connection positions with other structures, and a mating relationship between parts is simple, the first support plate 23, the second support plate 24, the third support plate 25, and the fourth support plate 26 have a small quantity of holes, and are structurally simple. In this way, the support surface 100a together formed by the first support plate 23, the second support plate 24, the third support plate 25, and the fourth support plate 26 has a small quantity of holes, and a gap between two adjacent support plates is small, thereby facilitating flatness of the support surface 100a, and helping improve the service life and the reliability of the flexible screen 200.

In this implementation, when the electronic device 1000 is in the folded state, the first support plate 23, the second support plate 24, the third support plate 25, and the fourth support plate 26 may together form the accommodating space 100b with the main shaft 1, to accommodate the second display area 202 of the flexible screen 200. It may be understood that in a process of folding the electronic device 1000, the first support plate 23, the second support plate 24, the third support plate 25, and the fourth support plate 26 may be automatically avoided, to form the accommodating space 100b. Folding actions performed by the first support plate 23, the second support plate 24, the third support plate 25, and the fourth support plate 26 on the flexible screen 200 may be stable, and a compressive force applied to the flexible screen is relatively small. This helps reduce a risk that the flexible screen 200 is damaged due to excessive compression of the foldable mechanism 100, thereby improving reliability of the flexible screen. In addition, when the electronic device 1000 is in the folded state, the first support plate 23, the second support plate 24, the third support plate 25, and the fourth support plate 26 may stably support the second display area 202 of the flexible screen 200, thereby reducing a risk of damage caused by freedom of the flexible screen 200, and improving the service life and the reliability of the flexible screen 200. Therefore, the foldable mechanism 100 in this implementation offers strong product competitiveness.

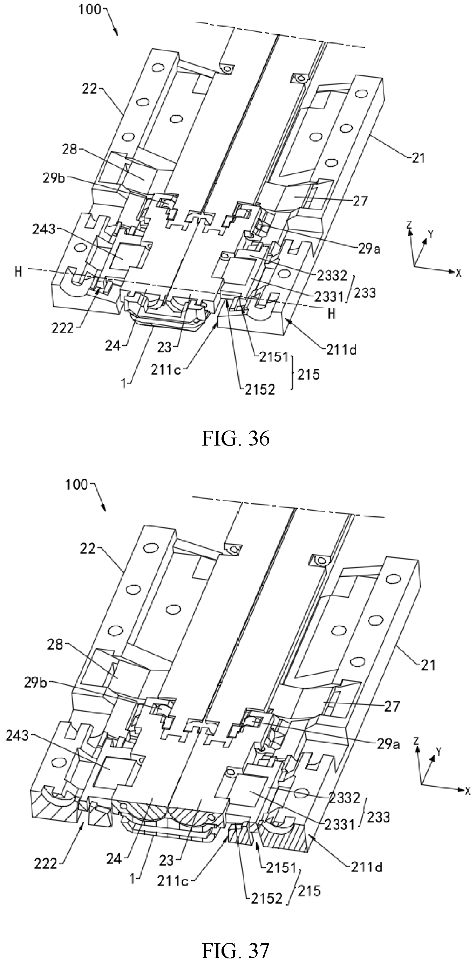

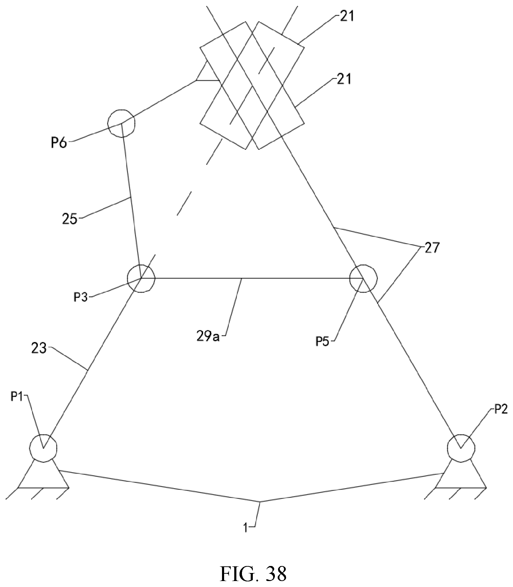

FIG. 36 is a seventh diagram of a partial structure of the foldable mechanism 100 shown in FIG. 6 according to an implementation. FIG. 37 is a partial sectional view of a part of the foldable mechanism 100 shown in FIG. 36 at an H-H line according to an implementation. FIG. 38 is a brief diagram of a connection relationship between a partial structure of the first connecting assembly 2 and the main shaft 1 shown in FIG. 36 according to an implementation.

As shown in FIG. 36 to FIG. 38, the first support plate 23 is further slidably connected to the first mounting bracket 21. It may be understood that in FIG. 38, that two components are connected through a dashed line indicates that a connection relationship between the two components is additionally added, that is, is not necessary. In addition, a sliding connection relationship between the first support plate 23 and the first mounting bracket 21 is illustrated by using two squares in different directions. If a related diagram appears below, refer to related explanations herein.

For example, the sliding block 233 of the first support plate 23 is disposed in the second sliding slot 215 of the first mounting bracket 21. Through relative motion between the sliding block and the second sliding slot, the first support plate 23 and the first mounting bracket 21 form a sliding connection structure through mating of the sliding block and the sliding slot. In another implementation, the first support plate 23 may alternatively be slidably connected to the first mounting bracket 21 in another sliding manner.

In this implementation, the first support plate 23 is further disposed to be slidably connected to the first mounting bracket 21, so that in a process of unfolding or folding the foldable mechanism 100, a motion manner of the first support plate 23, the third support plate 25 (refer to FIG. 34 and FIG. 35), the first connecting piece 27, and the first revolute pair 29a can better constrain a motion track of the first mounting bracket 21, and the motion track of the first mounting bracket 21 relative to the main shaft 1 is more accurate. In this way, folding actions performed by the first support plate 23, the second support plate 24, the third support plate 25, and the fourth support plate 26 on the flexible screen 200 may be stable, and a compressive force applied to the flexible screen is relatively small. This helps reduce a risk that the flexible screen 200 is damaged due to excessive compression of the foldable mechanism 100, thereby improving reliability of the flexible screen 200.

For example, the first connecting part 2331 of the sliding block 233 of the first support plate 23 is disposed in the first sub-slot 2151 of the second sliding slot 215 of the first mounting bracket 21. The second connecting part 2332 of the sliding block 233 of the first support plate 23 is disposed in the second sub-slot 2152 of the second sliding slot 215 of the first mounting bracket 21. It may be understood that because in the Y-axis direction, a length of the first connecting part 2331 is greater than a length of the second connecting part 2332, and a length of the first sub-slot 2151 is greater than a length of the second sub-slot 2152, the first connecting part 2331 and the first sub-slot 2151 are mated with each other, and the second connecting part 2332 and the second sub-slot 2152 are mated with each other, so that a motion direction of the sliding block 233 of the first support plate 23 can be better guided. In this way, folding actions performed by the first support plate 23, the second support plate 24, the third support plate 25, and the fourth support plate 26 on the flexible screen 200 may be stable, and a compressive force applied to the flexible screen is relatively small. This helps reduce a risk that the flexible screen 200 is damaged due to excessive compression of the foldable mechanism 100, thereby improving reliability of the flexible screen 200.

It may be understood that the second sliding slot 215 of the first mounting bracket 21 is disposed obliquely relative to the first side surface 211c (or the second side surface 211d) of the first mounting bracket 21, so that when the first mounting bracket 21 and the first support plate 23 are mated with each other, the first mounting bracket 21 and the first support plate 23 may form an oblique sliding slot mating structure; and when the electronic device 1000 is dropped or impacted, the first housing 300 exerts pressure on the first mounting bracket 21. In this case, the first mounting bracket 21 may share energy of the drop impact to the first support plate 23 and the main shaft 1. In this way, the foldable mechanism 100 has good drop impact performance, thereby helping improve the service life and the reliability of the electronic device 1000.

For example, the second support plate 24 is further slidably connected to the second mounting bracket 22. It may be understood that for a connection manner of the second support plate 24 and the second mounting bracket 22, refer to a connection manner of the first support plate 23 and the first mounting bracket 21. Details are not described herein again.

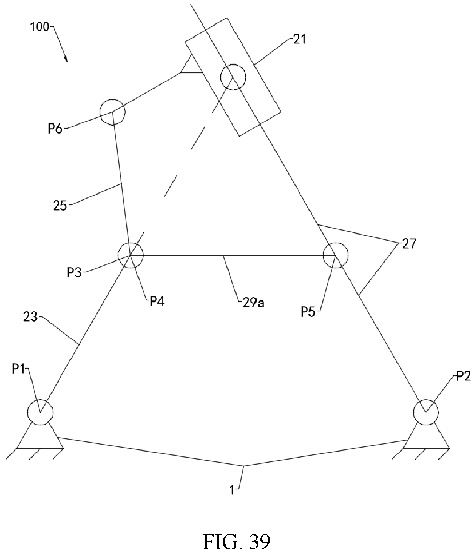

FIG. 39 is a brief diagram of a connection relationship between a partial structure of the first connecting assembly 2 and the main shaft 1 shown in FIG. 36 according to another implementation.

As shown in FIG. 39, the first support plate 23 is further rotatably connected to the first mounting bracket 21. It may be understood that in the brief diagram of FIG. 39, a connection relationship between the first support plate 23 and the first mounting bracket 21 is schematically indicated through a dashed line. In addition, a small circle in one square indicates that the first support plate 23 is rotatably connected to the first mounting bracket 21.

It may be understood that the first support plate 23 is further rotatably connected to the first mounting bracket 21, so that when the electronic device 1000 is dropped or impacted, the first housing 300 exerts pressure on the first mounting bracket 21. In this case, the first mounting bracket 21 may share energy of the drop impact to the first support plate 23 and the main shaft 1. In this way, the foldable mechanism 100 has good drop impact performance, thereby helping improve the service life and the reliability of the electronic device 1000.

For example, the second support plate 24 is further rotatably connected to the second mounting bracket 22. It may be understood that for a connection manner of the second support plate 24 and the second mounting bracket 22, refer to a connection manner of the first support plate 23 and the first mounting bracket 21. Details are not described herein again.

The foregoing describes a specific implementation of the foldable mechanism 100. It may be learned from the foregoing that, as shown in FIG. 33 and with reference to FIG. 8 to FIG. 32, the first support plate 23 is rotatably connected to the main shaft 1, the third support plate 25 is rotatably connected to the first support plate 23, the third support plate 25 is rotatably connected to the first mounting bracket 21, the rotating end 271 of the first connecting piece 27 is rotatably connected to the main shaft 1, the sliding end 273 of the first connecting piece 27 is slidably connected to the first mounting bracket 21, and the first support plate 23 is further rotatably connected to the first connecting piece 27 through the first revolute pair 29a. Therefore, a motion manner of the first support plate 23, the third support plate 25, the first connecting piece 27, and the first revolute pair 29a is used to constrain a motion track of the first mounting bracket 21, so that the motion track of the first mounting bracket 21 relative to the main shaft 1 can be determined. Similarly, the second support plate 24, the fourth support plate 26, and the second connecting piece 28 are used to constrain a motion track of the second mounting bracket 22, so that the motion track of the second mounting bracket 22 relative to the main shaft 1 can be determined. The following further describes several specific implementations of the foldable structure with reference to related accompanying drawings. The foldable mechanism 100 in this implementation may also enable a degree of freedom for the first mounting bracket 21 and the second mounting bracket 22 to move relative to the main shaft 1 to be 1, that is, motion tracks of the first mounting bracket 21 and the second mounting bracket 22 relative to the main shaft 1 can be determined. It may be understood that technical content that is the same as most of the foregoing technical content is not redundantly described in this implementation.

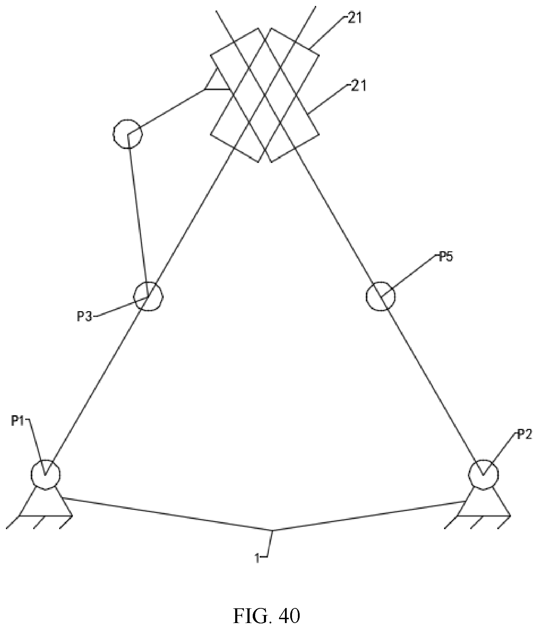

FIG. 40 is a brief diagram of a connection relationship between a partial structure of the first connecting assembly 2 and the main shaft 1 shown in FIG. 7 according to another implementation.

In a first implementation, as shown in FIG. 40, the first support plate 23 is rotatably connected to the main shaft 1, the third support plate 25 is rotatably connected to the first support plate 23, and the third support plate 25 is rotatably connected to the first mounting bracket 21. In addition, the rotating end 271 of the first connecting piece 27 is rotatably connected to the main shaft 1. The sliding end 273 of the first connecting piece 27 is slidably connected to the first mounting bracket 21. In addition, the first support plate 23 is further slidably connected to the first mounting bracket 21. It may be understood that in this implementation, for a manner in which the first support plate 23 is rotatably connected to the main shaft 1, a manner in which the third support plate 25 is rotatably connected to the first support plate 23, a manner in which the third support plate 25 is rotatably connected to the first mounting bracket 21, a manner in which the rotating end 271 of the first connecting piece 27 is rotatably connected to the main shaft 1, a manner in which the sliding end 273 of the first connecting piece 27 is slidably connected to the first mounting bracket 21, and a manner in which the first support plate 23 is further slidably connected to the first mounting bracket 21, refer to the foregoing related content and related accompanying drawings (FIG. 8 to FIG. 37). Details are not described herein again. In addition, a difference from the foregoing descriptions is that the first support plate 23 in this implementation is no longer rotatably connected to the first connecting piece 27 through the first revolute pair 29a, but is directly slidably connected to the first mounting bracket 21. The first connecting piece 27 in this implementation may not include the connecting section 272. Certainly, the first connecting piece 27 in this implementation may further include the connecting section 272.

A rotating axis of the first support plate 23 rotatably connected to the main shaft 1 is defined as a first rotating axis P1. A rotating axis of the first connecting piece 27 rotatably connected to the main shaft 1 is a second rotating axis P2. A rotating axis of the third support plate 25 rotatably connected to the first support plate 23 is a third rotating axis P3. A rotating axis of the third support plate 25 rotatably connected to the first mounting bracket 21 is a fourth rotating axis P4.

In this implementation, the foldable mechanism 100 may be a slider connecting rod motion mechanism. A main mechanism motion of the foldable mechanism 100 may include a primary motion and a secondary motion. The primary motion may be a motion manner of a slider connecting rod motion mechanism formed by the main shaft 1, the first support plate 23, the first connecting piece 27, and the first mounting bracket 21. In addition, the secondary motion may be a motion manner of a connecting rod motion mechanism formed by the first support plate 23, the third support plate 25, and the first mounting bracket 21. The foldable mechanism 100, through the primary motion and the secondary motion, may enable a degree of freedom for the first mounting bracket 21 to move relative to the main shaft 1 to be 1 in a process of unfolding or folding the foldable mechanism 100, so that a motion track of the first mounting bracket 21 relative to the main shaft 1 can be determined. Specifically, in the process of unfolding or folding the foldable mechanism 100, a motion manner of the first support plate 23, the third support plate 25, and the first connecting piece 27 may constrain a motion track of the first mounting bracket 21, so that the motion track of the first mounting bracket 21 relative to the main shaft 1 can be determined. In this way, in a process of changing the unfolded state of the foldable mechanism 100 to the folded state, the first support plate 23, the third support plate 25, and the first connecting piece 27 can pull the first mounting bracket 21 back to be close to the main shaft 1. In a process of changing the folded state of the foldable mechanism 100 to the unfolded state, the first support plate 23, the third support plate 25, and the first connecting piece 27 can push the first mounting bracket 21 away from the main shaft 1.

Similarly, with reference to FIG. 31 and FIG. 32, in the process of unfolding or folding the foldable mechanism 100, a motion manner of the second support plate 24, the fourth support plate 26, and the second connecting piece 28 may constrain a motion track of the second mounting bracket 22, so that the motion track of the second mounting bracket 22 relative to the main shaft 1 can be determined. In this way, in a process of changing the unfolded state of the foldable mechanism 100 to the folded state, the second support plate 24, the fourth support plate 26, and the second connecting piece 28 can pull the second mounting bracket 22 back to be close to the main shaft 1. In a process of changing the folded state of the foldable mechanism 100 to the unfolded state, the second support plate 24, the fourth support plate 26, and the second connecting piece 28 can push the second mounting bracket 22 away from the main shaft 1.

It may be understood that the foldable mechanism 100 in this implementation implements a connection between the first mounting bracket 21 and the main shaft 1 and a connection between the second mounting bracket 22 and the main shaft 1 by using the connecting rod slider structure and the connecting rod structure. The foldable mechanism 100 has a small quantity of components, a simple mating relationship, and a simple mating position, and components are easy to manufacture and assemble, thereby facilitating mass production.

In another implementation, in FIG. 40, that the first support plate 23 is slidably connected to the first mounting bracket 21 may also be replaced with that the first support plate 23 is rotatably connected to the first mounting bracket 21. Similarly, that the second support plate 24 is slidably connected to the second mounting bracket 22 may also be replaced with that the second support plate 24 is rotatably connected to the second mounting bracket 22.

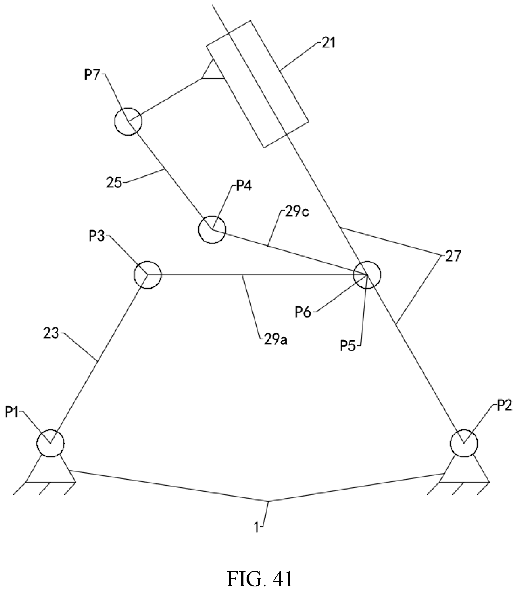

FIG. 41 is a first brief diagram of a connection relationship between a partial structure of the first connecting assembly 2 and the main shaft 1 shown in FIG. 7 according to still another implementation.

In a second implementation, as shown in FIG. 41, the foldable mechanism 100 further includes a third revolute pair 29c. For a structure of the third revolute pair 29c, refer to the structure of the first revolute pair 29a. Details are not described herein again.

As shown in FIG. 41, the first support plate 23 is rotatably connected to the main shaft 1. The third support plate 25 is rotatably connected to the first mounting bracket 21. The rotating end 271 of the first connecting piece 27 is rotatably connected to the main shaft 1, and the sliding end 273 of the first connecting piece 27 is slidably connected to the first mounting bracket 21. The connecting section 272 of the first connecting piece 27 is rotatably connected to the first support plate 23 through the first revolute pair 29a. The connecting section 272 of the first connecting piece 27 is further rotatably connected to the third support plate 25 through the third revolute pair 29c. It may be understood that in this implementation, for a manner in which the first support plate 23 is rotatably connected to the main shaft 1, a manner in which the third support plate 25 is rotatably connected to the first mounting bracket 21, a manner in which the rotating end 271 of the first connecting piece 27 is rotatably connected to the main shaft 1, a manner in which the sliding end 273 of the first connecting piece 27 is slidably connected to the first mounting bracket 21, and a manner in which the first support plate 23 is rotatably connected to the first connecting piece 27 through the first revolute pair 29a, refer to the foregoing related content and related accompanying drawings (FIG. 8 to FIG. 37). Details are not described herein again. In addition, for a manner in which the third support plate 25 is rotatably connected to the first connecting piece 27 through the third revolute pair 29c, refer to the foregoing manner in which the first support plate 23 is further rotatably connected to the first connecting piece 27 through the first revolute pair 29a (refer to FIG. 28 to FIG. 32). Details are not described herein again. In addition, a difference from the foregoing descriptions is that the third support plate 25 in this implementation is no longer rotatably connected to the first support plate 23, but is connected to the first connecting piece 27 through the third revolute pair 29c. In addition, for a manner in which the third support plate 25 in this implementation is connected to the first connecting piece 27 through the third revolute pair 29c, refer to the foregoing manner in which the first support plate 23 is rotatably connected to the first connecting piece 27 through the first revolute pair 29a shown in FIG. 8. Details are not described herein again.

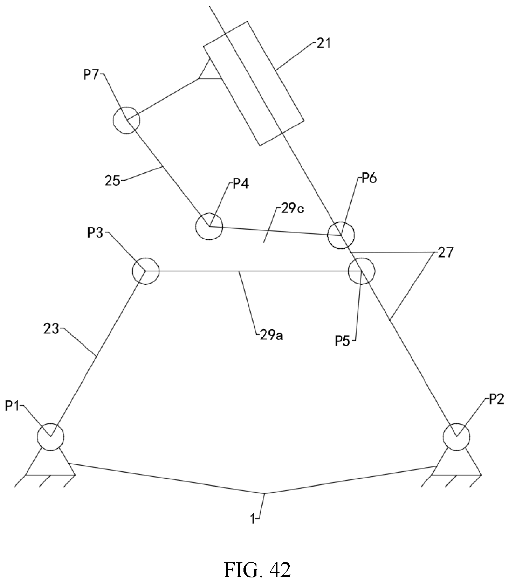

A rotating axis of the first support plate 23 rotatably connected to the main shaft 1 is defined as a first rotating axis P1. A rotating axis of the first connecting piece 27 rotatably connected to the main shaft 1 is a second rotating axis P2. A rotating axis of the first support plate 23 rotatably connected to the first revolute pair 29a is a third rotating axis P3. A rotating axis of the third support plate 25 rotatably connected to the third revolute pair 29c is a fourth rotating axis P4. A rotating axis of the first connecting piece 27 rotatably connected to the first revolute pair 29a is a fifth rotating axis P5. A rotating axis of the first connecting piece 27 rotatably connected to the third revolute pair 29c is a sixth rotating axis P6. A rotating axis of the third support plate 25 rotatably connected to the first mounting bracket 21 is a seventh rotating axis P7. For example, the fifth rotating axis P5 and the sixth rotating axis P6 may be aligned on a same straight line, that is, the fifth rotating axis P5 and the sixth rotating axis P6 are coaxially disposed. It may be understood that in this implementation, parts can be saved, thereby reducing a quantity of parts, and simplifying the structure. In another implementation, FIG. 42 is a first brief diagram of a connection relationship between a partial structure of the first connecting assembly 2 and the main shaft 1 shown in FIG. 7 according to still another implementation. As shown in FIG. 42, the fifth rotating axis P5 and the sixth rotating axis P6 may alternatively not be aligned on a same straight line.

In this implementation, the foldable mechanism 100 may be a crank-slider connecting rod motion mechanism. A main mechanism motion of the foldable mechanism 100 may include a primary motion and a secondary motion. The primary motion may be a motion manner of a first four-connecting rod motion mechanism formed by the main shaft 1, the first support plate 23, the first connecting piece 27, and the first revolute pair 29a. In addition, the secondary motion may be a motion manner of a second four-connecting rod motion mechanism formed by the third support plate 25, the first mounting bracket 21, the third revolute pair 29c, and the first connecting piece 27. The foldable mechanism 100, through the primary motion and the secondary motion, may enable a degree of freedom for the first mounting bracket 21 to move relative to the main shaft 1 to be 1 in a process of unfolding or folding the foldable mechanism 100, so that a motion track of the first mounting bracket 21 relative to the main shaft 1 can be determined. Specifically, in the process of unfolding or folding the foldable mechanism 100, a motion manner of the first support plate 23, the third support plate 25, the first connecting piece 27, the first revolute pair 29a, and the third revolute pair 29c may constrain a motion track of the first mounting bracket 21, so that the motion track of the first mounting bracket 21 relative to the main shaft 1 can be determined. In this way, in a process of changing the unfolded state of the foldable mechanism 100 to the folded state, the first support plate 23, the third support plate 25, the first connecting piece 27, the first revolute pair 29a, and the third revolute pair 29c can pull the first mounting bracket 21 back to be close to the main shaft 1. In a process of changing the folded state of the foldable mechanism 100 to the unfolded state, the first support plate 23, the third support plate 25, the first connecting piece 27, the first revolute pair 29a, and the third revolute pair 29c can push the first mounting bracket 21 away from the main shaft 1.

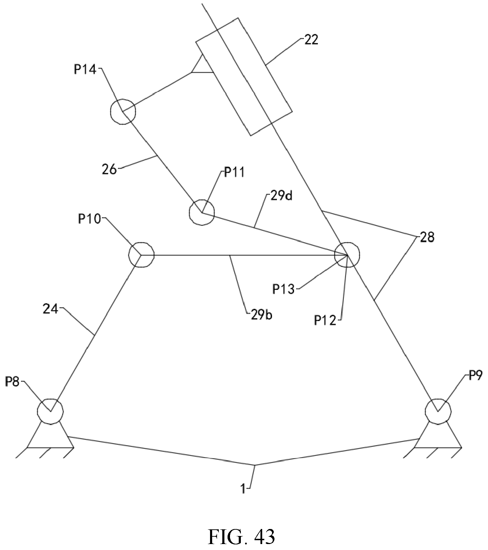

FIG. 43 is a second brief diagram of a connection relationship between a partial structure of the first connecting assembly 2 and the main shaft 1 shown in FIG. 7 according to still another implementation.

As shown in FIG. 43, the foldable mechanism 100 further includes a fourth revolute pair 29d. For a structure of the fourth revolute pair 29d, refer to the structure of the first revolute pair 29a. Details are not described herein again.

As shown in FIG. 43, the second support plate 24 is rotatably connected to the main shaft 1. The fourth support plate 26 is rotatably connected to the second mounting bracket 22. The rotating end 281 of the second connecting piece 28 is rotatably connected to the main shaft 1. The sliding end 283 of the second connecting piece 28 is slidably connected to the second mounting bracket 22. The connecting section 282 of the second connecting piece 28 is connected to the second support plate 24 through the second revolute pair 29b, and the connecting section 282 of the second connecting piece 28 is further connected to the fourth support plate 26 through the fourth revolute pair 29d.

It may be understood that in this implementation, for a manner in which the second support plate 24 is rotatably connected to the main shaft 1, a manner in which the fourth support plate 26 is rotatably connected to the second mounting bracket 22, a manner in which the rotating end 281 of the second connecting piece 28 is rotatably connected to the main shaft 1, a manner in which the sliding end 283 of the second connecting piece 28 is slidably connected to the second mounting bracket 22, and a manner in which the connecting section 282 of the second connecting piece 28 is connected to the second support plate 24 through the second revolute pair 29b, refer to the foregoing related content and related accompanying drawings (FIG. 8 to FIG. 37). Details are not described herein again. In addition, for a manner in which the connecting section 282 of the second connecting piece 28 is further connected to the fourth support plate 26 through the fourth revolute pair 29d, refer to the foregoing manner in which the first support plate 23 is rotatably connected to the first connecting piece 27 through the first revolute pair 29a (refer to FIG. 28 to FIG. 32). Details are not described herein again. In addition, a difference from the foregoing descriptions is that the fourth support plate 26 in this implementation is no longer rotatably connected to the second support plate 24, but is connected to the connecting section 282 of the second connecting piece 28 through the fourth revolute pair 29d.

A rotating axis of the second support plate 24 rotatably connected to the main shaft 1 is defined as an eighth rotating axis P8. A rotating axis of the second connecting piece 28 rotatably connected to the main shaft 1 is a ninth rotating axis P9. A rotating axis of the second support plate 24 rotatably connected to the second revolute pair 29b is a tenth rotating axis P10. A rotating axis of the fourth support plate 26 rotatably connected to the fourth revolute pair 29d is an eleventh rotating axis P11. A rotating axis of the second connecting piece 28 rotatably connected to the second revolute pair 29b is a twelfth rotating axis P12. A rotating axis of the second connecting piece 28 rotatably connected to the fourth revolute pair 29d is a thirteenth rotating axis P13. A rotating axis of the fourth support plate 26 rotatably connected to the second mounting bracket 22 is a fourteenth rotating axis P14. For example, the twelfth rotating axis P12 and the thirteenth rotating axis P13 may be aligned on a same straight line, that is, the twelfth rotating axis P12 and the thirteenth rotating axis P13 are coaxially disposed. In another implementation, the twelfth rotating axis P12 and the thirteenth rotating axis P13 may alternatively not be aligned on a same straight line.

It may be understood that, with reference to FIG. 31 and FIG. 32, in the process of unfolding or folding the foldable mechanism 100, a motion manner of the second support plate 24, the fourth support plate 26, the second connecting piece 28, the second revolute pair 29b, and the fourth revolute pair 29d may constrain a motion track of the second mounting bracket 22, so that the motion track of the second mounting bracket 22 relative to the main shaft 1 can be determined. In this way, in a process of changing the unfolded state of the foldable mechanism 100 to the folded state, the second support plate 24, the fourth support plate 26, the second connecting piece 28, the second revolute pair 29b, and the fourth revolute pair 29d can pull the second mounting bracket 22 back to be close to the main shaft 1. In a process of changing the folded state of the foldable mechanism 100 to the unfolded state, the second support plate 24, the fourth support plate 26, the second connecting piece 28, the second revolute pair, and the fourth revolute pair 29d can push the second mounting bracket 22 away from the main shaft 1.

It should be noted that embodiments of this application and features in embodiments may be combined with each other without a conflict, and any combination of features in different embodiments also falls within the protection scope of this application. In other words, the plurality of embodiments described above may be further combined according to an actual requirement.

It should be noted that all the foregoing accompanying drawings are example figures of this application, and do not represent actual sizes of products. In addition, a dimension proportional relationship between components in the accompanying drawings is not intended to limit an actual product in this application. The foregoing descriptions are merely some embodiments and implementations of this application, but are not intended to limit the protection scope of this application. Any variation or replacement readily figured out by a person skilled in the art within the technical scope disclosed in this application shall fall within the protection scope of this application. Therefore, the protection scope this application shall be subject to the protection scope of the claims.

## Claims

1. A foldable mechanism (100), comprising a main shaft (1), a first mounting bracket (21), a second mounting bracket (22), a first support plate (23), a second support plate (24), a third support plate (25), a fourth support plate (26), a first connecting piece (27), a second connecting piece (28), a first revolute pair (29a), and a second revolute pair (29b), wherein the main shaft (1) is located between the first mounting bracket (21) and the second mounting bracket (22);
the first support plate (23) is rotatably connected to the main shaft (1), and the third support plate (25) is rotatably connected to the first support plate (23) and the first mounting bracket (21);
the first connecting piece (27) comprises a rotating end (271), a connecting section (272), and a sliding end (273) that are sequentially connected, the rotating end (271) of the first connecting piece (27) is rotatably connected to the main shaft (1), the sliding end (273) of the first connecting piece (27) is slidably connected to the first mounting bracket (21), and the connecting section (272) of the first connecting piece (27) is connected to the first support plate (23) through the first revolute pair (29a);
the second support plate (24) is rotatably connected to the main shaft (1), and the fourth support plate (26) is rotatably connected to the second support plate (24) and the second mounting bracket (22); and
the second connecting piece (28) comprises a rotating end (281), a connecting section (282), and a sliding end (283) that are sequentially connected, the rotating end (281) of the second connecting piece (28) is rotatably connected to the main shaft (1), the sliding end (283) of the second connecting piece (28) is slidably connected to the second mounting bracket (22), and the connecting section (282) of the second connecting piece (28) is connected to the second support plate (24) through the second revolute pair (29b).

2. The foldable mechanism (100) according to claim 1, wherein when the foldable mechanism (100) is in an unfolded state, the third support plate (25), the first support plate (23), the second support plate (24), and the fourth support plate (26) are sequentially joined and together form a support surface (100a); or
when the foldable mechanism (100) is in a folded state, the first support plate (23) and the second support plate (24) are disposed opposite to each other, the third support plate (25) and the fourth support plate (26) are disposed opposite to each other, and the main shaft (1), the first support plate (23), the second support plate (24), the third support plate (25), and the fourth support plate (26) enclose an accommodating space (100b).

3. The foldable mechanism (100) according to claim 2, wherein when the foldable mechanism (100) is in the folded state, the first support plate (23) and the second support plate (24) are both disposed obliquely relative to the main shaft (1), the first support plate (23) and the second support plate (24) are close to each other in a direction close to the main shaft (1), the third support plate (25) and the fourth support plate (26) are also disposed obliquely relative to the main shaft (1), and the third support plate (25) and the fourth support plate (26) are close to each other in a direction away from the main shaft (1).

4. The foldable mechanism (100) according to any one of claims 1 to 3, wherein when the foldable mechanism (100) is in the unfolded state, the first support plate (23) and the second support plate (24) together cover all of the main shaft (1); or
when the foldable mechanism (100) is in the folded state, the first support plate (23) and the second support plate (24) respectively cover two side parts of the main shaft (1).

5. The foldable mechanism (100) according to any one of claims 1 to 4, wherein a rotating axis of the first support plate (23) rotatably connected to the first revolute pair (29a) and a rotating axis of the third support plate (25) rotatably connected to the first support plate (23) are aligned on a same straight line.

6. The foldable mechanism (100) according to any one of claims 1 to 5, wherein the main shaft (1) is bent to form an inner-side space (10), the main shaft (1) is further provided with a first arc-shaped groove (11), and the first arc-shaped groove (11) of the main shaft (1) communicates with the inner-side space (10);
the first support plate (23) comprises a first support plate body (231) and an arc-shaped block (232);
the arc-shaped block (232) of the first support plate (23) is disposed in the first arc-shaped groove (11) of the main shaft (1), and is capable of rotating in the first arc-shaped groove (11) of the main shaft (1); and
at least a part of the first support plate body (231) is disposed in the inner-side space (10), and is capable of rotating in the inner-side space (10).

7. The foldable mechanism (100) according to claim 6, wherein the first support plate body (231) comprises a bottom surface (2312) and a first end surface (2313), the first end surface (2313) of the first support plate body (231) is connected to the bottom surface (2312) of the first support plate body (231), and the bottom surface (2312) of the first support plate body (231) faces the main shaft (1) when the foldable mechanism (100) is in the unfolded state;
the first support plate body (231) is provided with a clearance space (234), the clearance space (234) forms an opening on the bottom surface (2312) of the first support plate body (231), the clearance space (234) comprises a first wall surface (2341), and the first wall surface (2341) of the clearance space (234) and the first end surface (2313) of the first support plate body (231) are disposed facing away from each other; and
the first support plate (23) has at least two arc-shaped blocks (232), one arc-shaped block (232) of the first support plate (23) protrudes from the first end surface (2313) of the first support plate body (231), and one arc-shaped block (232) of the first support plate (23) protrudes from the first wall surface (2341) of the clearance space (234).

8. The foldable mechanism (100) according to claim 6 or 7, wherein the first support plate (23) is provided with a first rotating space (235), the first rotating space (235) of the first support plate (23) is located on one side, of the arc-shaped block (232) of the first support plate (23), away from the main shaft (1), the first rotating space (235) of the first support plate (23) comprises a first side wall (2351) and a second side wall (2352) that are disposed opposite to each other, and the first side wall (2351) and the second side wall (2352) of the first rotating space (235) of the first support plate (23) each are provided with a rotating shaft hole (2353);
the third support plate (25) comprises a rotating shaft block (252), and the rotating shaft block (252) of the third support plate (25) is provided with a rotating shaft hole (254); and
the foldable mechanism (100) further comprises a first rotating shaft (20a), and the first rotating shaft (20a) sequentially passes through the rotating shaft hole (2353) of the first side wall (2351) of the first rotating space (235) of the first support plate (23), the rotating shaft hole (254) of the rotating shaft block (252) of the third support plate (25), and the rotating shaft hole (2353) of the second side wall (2352) of the first rotating space (235) of the first support plate (23).

9. The foldable mechanism (100) according to any one of claims 1 to 8, wherein the first revolute pair (29a) comprises a bracket (291a), a first pin shaft (292a), and a second pin shaft (293a), and the bracket (291a) is provided with a first pin shaft hole (2911a) and a second pin shaft hole (2912a) that are spaced apart;
the connecting section (272) of the first connecting piece (27) is provided with a rotating space (274), the rotating space (274) of the first connecting piece (27) comprises a first side wall (2741) and a second side wall (2742) that are disposed opposite to each other, and the first side wall (2741) and the second side wall (2742) of the rotating space (274) of the first connecting piece (27) each are provided with a rotating shaft hole (2743);
a part of the bracket (291a) is located in the rotating space (274) of the connecting section (272) of the first connecting piece (27), and the first pin shaft (292a) sequentially passes through the rotating shaft hole (2743) of the first side wall (2741) of the rotating space (274) of the first connecting piece (27), the first pin shaft hole (2911a) of the bracket (291a), and the rotating shaft hole (2743) of the second side wall (2742) of the rotating space (274) of the first connecting piece (27);
the first support plate (23) is further provided with a second rotating space (236), the second rotating space (236) of the first support plate (23) comprises a first side wall (2361) and a second side wall (2362) that are disposed opposite to each other, and the first side wall (2361) and the second side wall (2362) of the second rotating space (236) of the first support plate (23) each are provided with a rotating shaft hole (2363); and
a part of the bracket (291a) is located in the second rotating space (236) of the first support plate (23), and the second pin shaft (293a) sequentially passes through the rotating shaft hole (2363) of the first side wall (2361) of the second rotating space (236) of the first support plate (23), the second pin shaft hole (2912a) of the bracket (291a), and the rotating shaft hole (2363) of the second side wall (2362) of the second rotating space (236) of the first support plate (23).

10. The foldable mechanism (100) according to claim 9, wherein the connecting section (272) of the first connecting piece (27) comprises a first part (2721) and a second part (2722), the first part (2721) is connected to the rotating end (271) of the first connecting piece (27) and the sliding end (273) of the first connecting piece (27), and the second part (2722) protrudes from one side of the rotating end (271) of the first connecting piece (27); and
the rotating space (274) of the first connecting piece (27) is provided in the second part (2722).

11. The foldable mechanism (100) according to any one of claims 1 to 10, wherein the third support plate (25) comprises an arc-shaped block (253), and the first mounting bracket (21) is provided with an arc-shaped groove (212); and
the arc-shaped block (253) of the third support plate (25) is disposed in the arc-shaped groove (212) of the first mounting bracket (21), and is capable of rotating in the arc-shaped groove (212) of the first mounting bracket (21).

12. The foldable mechanism (100) according to any one of claims 1 to 11, wherein the first support plate (23) is further slidably connected to the first mounting bracket (21), and/or the second support plate (24) is further slidably connected to the second mounting bracket (22).

13. The foldable mechanism (100) according to claim 12, wherein the first support plate (23) comprises a sliding block (233), and the first mounting bracket (21) is provided with a second sliding slot (215); and
the sliding block (233) of the first support plate (23) is disposed in the second sliding slot (215) of the first mounting bracket (21), and is capable of sliding in the second sliding slot (215) of the first mounting bracket (21).

14. The foldable mechanism (100) according to claim 13, wherein the first mounting bracket (21) comprises a first side surface (211c) facing the main shaft (1), and the second sliding slot (215) of the first mounting bracket (21) is disposed obliquely relative to the first side surface (211c) of the first mounting bracket (21).

15. The foldable mechanism (100) according to any one of claims 1 to 11, wherein the first support plate (23) is further rotatably connected to the first mounting bracket (21), and/or the second support plate (24) is further rotatably connected to the second mounting bracket (22).

16. A foldable mechanism (100), comprising a main shaft (1), a first mounting bracket (21), a second mounting bracket (22), a first support plate (23), a second support plate (24), a third support plate (25), a fourth support plate (26), a first connecting piece (27), and a second connecting piece (28), wherein the main shaft (1) is located between the first mounting bracket (21) and the second mounting bracket (22);
the first support plate (23) is rotatably connected to the main shaft (1), and is slidably connected to or rotatably connected to the first mounting bracket (21), and the third support plate (25) is rotatably connected to the first support plate (23) and the first mounting bracket (21);
the first connecting piece (27) comprises a rotating end (271) and a sliding end (273), the rotating end (271) of the first connecting piece (27) is rotatably connected to the main shaft (1), and the sliding end (273) of the first connecting piece (27) is slidably connected to the first mounting bracket (21);
the second support plate (24) is rotatably connected to the main shaft (1), and is slidably connected to or rotatably connected to the second mounting bracket (22), and the fourth support plate (26) is rotatably connected to the second support plate (24) and the second mounting bracket (22); and
the second connecting piece (28) comprises a rotating end (281) and a sliding end (283), the rotating end (281) of the second connecting piece (28) is rotatably connected to the main shaft (1), and the sliding end (283) of the second connecting piece (28) is slidably connected to the second mounting bracket (22).

17. The foldable mechanism (100) according to claim 16, wherein when the foldable mechanism (100) is in an unfolded state, the third support plate (25), the first support plate (23), the second support plate (24), and the fourth support plate (26) are sequentially joined and together form a support surface (100a); or
when the foldable mechanism (100) is in a folded state, the first support plate (23) and the second support plate (24) are disposed opposite to each other, the third support plate (25) and the fourth support plate (26) are disposed opposite to each other, and the main shaft (1), the first support plate (23), the second support plate (24), the third support plate (25), and the fourth support plate (26) enclose an accommodating space (100b).

18. The foldable mechanism (100) according to claim 17, wherein when the foldable mechanism (100) is in the folded state, the first support plate (23) and the second support plate (24) are both disposed obliquely relative to the main shaft (1), the first support plate (23) and the second support plate (24) are close to each other in a direction close to the main shaft (1), the third support plate (25) and the fourth support plate (26) are also disposed obliquely relative to the main shaft (1), and the third support plate (25) and the fourth support plate (26) are close to each other in a direction away from the main shaft (1).

19. The foldable mechanism (100) according to any one of claims 16 to 18, wherein the first support plate (23) comprises a sliding block (233), and the first mounting bracket (21) is provided with a second sliding slot (215); and
the sliding block (233) of the first support plate (23) is disposed in the second sliding slot (215) of the first mounting bracket (21), and is capable of sliding in the second sliding slot (215) of the first mounting bracket (21).

20. The foldable mechanism (100) according to claim 19, wherein the first mounting bracket (21) comprises a first side surface (211c) facing the main shaft (1), and the second sliding slot (215) of the first mounting bracket (21) is disposed obliquely relative to the first side surface (211c) of the first mounting bracket (21).

21. A foldable mechanism (100), comprising a main shaft (1), a first mounting bracket (21), a second mounting bracket (22), a first support plate (23), a second support plate (24), a third support plate (25), a fourth support plate (26), a first connecting piece (27), a second connecting piece (28), a first revolute pair (29a), a second revolute pair (29b), a third revolute pair (29c), and a fourth revolute pair (29d), wherein the main shaft (1) is located between the first mounting bracket (21) and the second mounting bracket (22);
the first support plate (23) is rotatably connected to the main shaft (1), and the third support plate (25) is rotatably connected to the first mounting bracket (21);
the first connecting piece (27) comprises a rotating end (271), a connecting section (272), and a sliding end (273) that are sequentially connected, the rotating end (271) of the first connecting piece (27) is rotatably connected to the main shaft (1), the sliding end (273) of the first connecting piece (27) is slidably connected to the first mounting bracket (21), the connecting section (272) of the first connecting piece (27) is connected to the first support plate (23) through the first revolute pair (29a), and the connecting section (272) of the first connecting piece (27) is further connected to the third support plate (25) through the third revolute pair (29c);
the second support plate (24) is rotatably connected to the main shaft (1), and the fourth support plate (26) is rotatably connected to the second mounting bracket (22); and
the second connecting piece (28) comprises a rotating end (281), a connecting section (282), and a sliding end (283) that are sequentially connected, the rotating end (281) of the second connecting piece (28) is rotatably connected to the main shaft (1), the sliding end (283) of the second connecting piece (28) is slidably connected to the second mounting bracket (22), the connecting section (282) of the second connecting piece (28) is connected to the second support plate (24) through the second revolute pair (29b), and the connecting section (282) of the second connecting piece (28) is further connected to the fourth support plate (26) through the fourth revolute pair (29d).

22. The foldable mechanism (100) according to claim 21, wherein when the foldable mechanism (100) is in an unfolded state, the third support plate (25), the first support plate (23), the second support plate (24), and the fourth support plate (26) are sequentially joined and together form a support surface (100a); or
when the foldable mechanism (100) is in a folded state, the first support plate (23) and the second support plate (24) are disposed opposite to each other, the third support plate (25) and the fourth support plate (26) are disposed opposite to each other, and the main shaft (1), the first support plate (23), the second support plate (24), the third support plate (25), and the fourth support plate (26) enclose an accommodating space (100b).

23. The foldable mechanism (100) according to claim 22, wherein when the foldable mechanism (100) is in the folded state, the first support plate (23) and the second support plate (24) are both disposed obliquely relative to the main shaft (1), the first support plate (23) and the second support plate (24) are close to each other in a direction close to the main shaft (1), the third support plate (25) and the fourth support plate (26) are also disposed obliquely relative to the main shaft (1), and the third support plate (25) and the fourth support plate (26) are close to each other in a direction away from the main shaft (1).

24. An electronic device (1000), comprising a first housing (300), a second housing (400), a flexible screen (200), and the foldable mechanism (100) according to any one of claims 1 to 23, wherein the first mounting bracket (21) is fastened to the first housing (300), and the second mounting bracket (22) is fastened to the second housing (400); and
the flexible screen (200) comprises a first display area (201), a second display area (202), and a third display area (203) that are sequentially connected, the first display area (201) is fastened to the first housing (300), and the third display area (203) is fastened to the second housing (400).

25. The electronic device (1000) according to claim 24, wherein when the electronic device (1000) is in an unfolded state, the first support plate (23), the second support plate (24), the third support plate (25), and the fourth support plate (26) together form a support surface (100a), and the support surface (100a) supports the second display area (202); or
when the foldable mechanism (100) is in a folded state, the main shaft (1), the first support plate (23), the second support plate (24), the third support plate (25), and the fourth support plate (26) enclose an accommodating space (100b), and the accommodating space (100b) accommodates the second display area (202).
